(19) Europäisches Patentamt / European Patent Office / Office européen des brevets

(11) **EP 4 546 114 A1**

(12) **EUROPEAN PATENT APPLICATION**

(43) Date of publication:
**30.04.2025   Bulletin 2025/18**

(21) Application number: **24198215.6**

(22) Date of filing: **03.09.2024**

(51) International Patent Classification (IPC):
**G06F 7/544** $^{(2006.01)}$   **G06F 7/483** $^{(2006.01)}$

(52) Cooperative Patent Classification (CPC):
**G06F 7/5443; G06F 7/483;** G06F 2207/4824

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.10.2023   KR 20230143978**

(71) Applicants:
- **Samsung Electronics Co., Ltd**
  **Suwon-si, Gyeonggi-do 16677 (KR)**
- **Naver Corporation**
  **Seongnam-si, Gyeonggi-do 13561 (KR)**

(72) Inventors:
- **JEON, Younho**
  **Suwon-si (KR)**
- **SON, Hong Rak**
  **Suwon-si (KR)**
- **SONG, Wonsuk**
  Suwon-si (KR)
- **YOO, Younggeon**
  Suwon-si (KR)
- **YOON, JongYoon**
  Suwon-si (KR)
- **LIM, Jihoon**
  Suwon-si (KR)
- **JANG, Jae Hun**
  Suwon-si (KR)
- **KWON, Sejung**
  Seongnam-si (KR)
- **KIM, Byeoungwook**
  Seongnam-si (KR)
- **PARK, Baeseong**
  Seongnam-si (KR)
- **LEE, Dongsoo**
  Seongnam-si (KR)

(74) Representative: **Marks & Clerk LLP**
**15 Fetter Lane**
**London EC4A 1BW (GB)**

(54) **MATRIX MULTIPLIER AND OPERATION METHOD OF MATRIX MULTIPLICATION DEVICE INCLUDING THE SAME**

(57)   A matrix multiplier includes an input vector scaler configured to generate a first scaled input vector based on a first input vector and a plurality of quantization scale coefficients, a first data type converter configured to generate a first fixed-point scaled input vector based on the first scaled input vector, a processing element array including a first processing element configured to generate a first fixed-point output element based on the first fixed-point scaled input vector and first plurality of quantization sign values and a second processing element configured to generate a second fixed-point output element based on the first fixed-point scaled input vector and second plurality of quantization sign values, and a second data type converter configured to generate first and second output elements by converting data type of the first and second fixed-point output elements, and to output a first output vector including the first and second output elements.

FIG. 6

EP 4 546 114 A1

**Description**

**BACKGROUND**

Various example embodiments relate, in general, to a semiconductor device. More specifically, various example embodiments relate to a matrix multiplier that performs matrix multiplication, and/or to a matrix multiplication device including the same.

As artificial intelligence technology has recently developed, a computational amount of an artificial intelligence model is rapidly increasing. Accordingly, various technologies are being researched to shorten an operation time of the artificial intelligence model.

Generally, most of an operation time of an artificial intelligence model is spent on matrix multiplication. For example, the artificial intelligence model may spend most of an operation time to calculate an output matrix by performing multiplication of an input matrix and a weight matrix. Accordingly, various algorithms such as binary-coding-quantization (BCQ) and the like are being researched to perform multiplication of the input matrix and the weight matrix with less calculation amount (i.e. providing greater computational efficiency).

**SUMMARY**

Some example embodiments solve or improve upon the above-described technical problem. More specifically, an object of various example embodiments is to provide a matrix multiplier and/or a matrix multiplication device including the same configured to perform matrix multiplication with a faster speed and/or with a smaller computation amount.

A matrix multiplier according to some example embodiments includes an input vector scaler configured to generate a first scaled input vector based on a first input vector and on a plurality of quantization scale coefficients, a first data type converter configured to generate a first fixed-point scaled input vector based on the first scaled input vector, a processing element array including a first processing element configured to generate a first fixed-point output element based on the first fixed-point scaled input vector and on a first plurality of quantization sign values, and a second processing element configured to generate a second fixed-point output element based on the first fixed-point scaled input vector and on a second plurality of quantization sign values, and a second data type converter configured to generate a first output element and a second output element by converting a data type of the first fixed-point output element and a data type of the second fixed-point output element respectively, and configured to output a first output vector including the first and second output elements.

Alternatively or additionally a matrix multiplier according to some example embodiments includes an input vector scaler configured to generate a first plurality of scaled input elements based on a first input element and a first plurality of quantization scale coefficients, and generates second plurality of scaled input elements based on a second input element and a second plurality of quantization scale coefficients, a first data type converter configured to generate a first plurality of fixed-point scaled input elements based on the first plurality of scaled input elements and to generate a second plurality of fixed-point scaled input elements based on the second plurality of scaled input elements, a first processing element configured to generate a first fixed-point output element by accumulating the first plurality of fixed-point scaled input elements and the second plurality of fixed-point scaled input elements based on a plurality of quantization sign values, and a second data type converter configured to generate a first output element by converting a data type of the first fixed-point output element.

Alternatively or additionally an operation method of a matrix multiplication device according to some example embodiments include receiving first to N-th weights from an external device (wherein N is an integer greater than or equal to 2), generating first to $(N \times R)$-th quantization sign values and first to $(N \times R)$-th quantization scale coefficients by binary coding quantizing the first to N-th weights (wherein R is an integer greater than or equal to 2), receiving first to N-th input elements from the external device, generating first to $(N \times R)$-th scaled input elements by scaling the first to N-th input elements based on the first to $(N \times R)$-th quantization scale coefficients, and outputting a first output element generated by accumulating the first to $(N \times R)$-th scaled input elements based on the first to $(N \times R)$-th quantization sign values.

Alternatively or additionally a matrix multiplication device configured to receive a weight matrix and a first input vector from the outside according to some example embodiments includes a binary coding quantization (BCQ) circuit configured to generate a plurality of quantization sign values and a plurality of quantization scale coefficients by binary coding quantizing the weight matrix, and a matrix multiplier configured to calculate a first output vector corresponding to a product of the first input vector and the weight matrix based on the plurality of quantization sign values and on the plurality of quantization scale coefficients. The matrix multiplier includes an input vector scaler configured to generate a first scaled input vector by scaling the first input vector based on the plurality of quantization scaling coefficients, a first data type converter configured to generate a first fixed-point scaled input vector based on the first scaled input vector, a processing element array configured to calculate a first fixed-point output vector based on the plurality of quantization sign values and the first fixed-point scaled input vector, and a second data type converter configured to generate the first output vector by converting a data type of the first fixed-point output vector.

Alternatively or additionally, a matrix multiplication device configured to receive an n-dimensional input vector and a weight matrix with n by m dimensions and to output an m-dimensional output vector wherein n and m are an integer greater than or equal to 2 according to some example embodiments, includes a binary coding quantization (BCQ) circuit configured to generate first to R-th quantization sign matrices having n by m dimensions, and first to (N×R)-th quantization scale coefficients respectively corresponding to different rows of the first to R-th quantization sign matrices (wherein R is an integer greater than or equal to 2), an input vector scaler configured to scale elements of the n-dimensional input vector based on the first to (N×R)-th quantization scale coefficients, and a processing element array that includes a plurality of processing elements, wherein each of the plurality of processing elements is configured to output different output elements each other included in the m-dimensional output vector, by accumulating elements of the input vector scaled based on the first to R-th quantization sign matrices.

At least some of the above and other features of the invention are set out in the claims.

## BRIEF DESCRIPTION OF THE DRAWINGS

Various example embodiments will be described with reference to one or more figures, wherein:

FIG. 1 is a block diagram showing a matrix multiplication device according to some example embodiments;

FIG. 2 is a drawing showing an operation of a matrix multiplication device implemented to directly multiply an input matrix and a weight matrix of FIG. 1;

FIG. 3 is a drawing showing an operation of a BCQ circuit of FIG. 1;

FIG. 4 is a drawing showing the operation of the BCQ circuit of FIG. 1 that performs a binary coding quantization operation for each column of the weight matrix;

FIG. 5 is a drawing showing an operation of a matrix multiplier according to some example embodiments of FIG. 4;

FIG. 6 is a block diagram showing a configuration of the matrix multiplier of FIG. 1 according to the embodiment of FIG. 4;

FIG. 7 is a drawing showing a configuration of a first data type converter of FIG. 6;

FIG. 8 is a drawing showing an operation of an exponent extract circuit of FIG. 7;

FIG. 9 is a drawing showing an operation of a data type convert circuit of FIG. 7;

FIG. 10 is a block diagram showing a configuration of a processing element array of FIG. 6 in more detail;

FIG. 11 is a block diagram showing some operations of the matrix multiplier of FIG. 6 in more detail;

FIG. 12 is a drawing showing operations of processing elements of FIG. 11;

FIG. 13 is a drawing showing a configuration of one of the processing elements of FIG. 12 implemented according to some example embodiments;

FIG. 14 is a drawing showing an operation of a second data type converter of FIG. 6;

FIG. 15 is a drawing showing the operation of the BCQ circuit of FIG. 1 according to some example embodiments;

FIG. 16 is a drawing showing a weight matrix approximated according to the embodiment of FIG. 15;

FIG. 17 is a drawing showing quantization sign matrices of FIG. 16;

FIG. 18 is a block diagram showing the configuration of the matrix multiplier of FIG. 1 implemented according to some example embodiments;

FIG. 19 is a block diagram showing a configuration of an input vector scaler of FIG. 18;

FIG. 20 is a drawing showing an operation of an input vector scaling circuit of FIG. 19 in more detail;

FIG. 21 is a block diagram showing a configuration of a first data type converter of FIG. 18;

FIG. 22 is a block diagram showing a configuration of a processing element array of FIG. 18 in more detail;

FIG. 23 is a block diagram showing outputs of processing elements of FIG. 22 in more detail;

FIG. 24 is a block diagram showing an operation of a first processing element row of FIG. 22 in more detail;

FIG. 25 is a drawing showing a configuration of a processing element of FIG. 24 according to some example embodiments;

FIG. 26 is a drawing showing an operation of a second data type converter of FIG. 18;

FIG. 27 is a flowchart showing an operation of the matrix multiplication device of FIG. 1;

FIG. 28 is a flowchart showing a step S150 of FIG. 27 in more detail;

FIG. 29 is a flowchart showing an operation of the matrix multiplication device of FIG. 1;

FIG. 30 is a flowchart showing a step S250 of FIG. 29 in more detail;

FIG. 31 is a block diagram showing the processing element array of FIG. 22 implemented in a systolic array method;

FIG. 32 is a drawing showing a configuration of a processing element of FIG. 31 in more detail;

FIG. 33 is a drawing showing an operation of the input vector scaling circuit of FIG. 19 according to some example embodiments;

FIG. 34 is a drawing showing an operation of the matrix multiplication device of FIG. 1 according to some example embodiments;

FIG. 35 is a drawing showing a full input matrix of FIG. 34;

FIG. 36 is a drawing showing a full weight matrix of FIG. 34;

FIG. 37 is a drawing showing a full output matrix of FIG. 34;

FIG. 38 is a block diagram showing a matrix multiplication device according to some example embodiments;

FIG. 39 is a block diagram showing a neural processing system implemented according to some example embodiments; and

FIG. 40 is a block diagram showing an artificial intelligence model driven by the neural processing system of FIG. 39.

## DETAILED DESCRIPTION

Below, various example embodiments will be described clearly and in detail to such an extent that a person of an ordinary skill in the technical fields may easily perform example embodiments. Details such as detailed configurations and structures are provided simply to facilitate an overall understanding of example embodiments. Therefore, modifications of example embodiments described may be performed by a person of an ordinary skill in the art without departing from the technical scope thereof. Moreover, descriptions of some functions and/or structures, such as some well-known functions and/or structures may be omitted for clarity and/or brevity. Configurations in the drawings and/or a detailed description of may be connected to an element other than that shown in the drawings or described in the detailed description. Terms used below are defined considering functions of variously described example embodiments, and are not limited to specific functions. The definition of the terms may be determined based on details described in the detailed description.

Elements described with reference to a term such as a driver, a block, or the like used in the detailed description may be implemented in the form of software, hardware, or a combination thereof. For example, the software may be a machine code, firmware, an embedded code, and application software. For example, the hardware may include an electrical circuit, an electronic circuit, a processor, a computer, integrated circuit cores, a pressure sensor, an inertial sensor, a microelectromechanical System (MEMS), a passive element, or a combination thereof.

Hereinafter, for a more concise description, a matrix is referred to through square brackets "[" and "]", and a set is referred to through braces "{" and "}". However, a scope of example embodiments is not limited to the notation method.

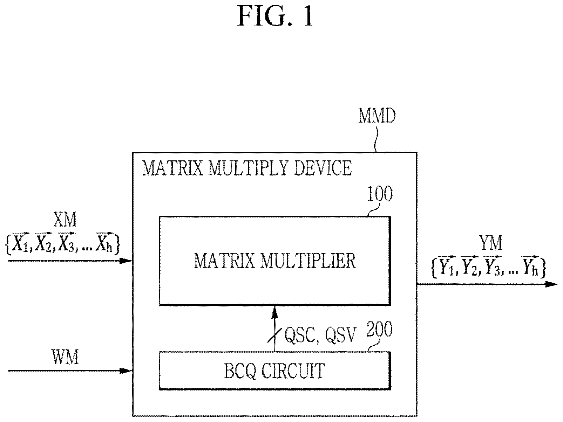

FIG. 1 is a block diagram showing a matrix multiplication device according to some example embodiments. Referring to FIG. 1, the matrix multiplication device MMD may include a matrix multiplier 100 and a binary coding quantization (BCQ) circuit 200. The matrix multiplication device MMD may also be referred as matrix multiply device MMD.

The matrix multiplication device MMD may receive and/or obtain an input matrix XM. The input matrix XM may include a plurality of input vectors. Each of the plurality of input vectors may include a plurality of input elements. For example, the input matrix XM may be expressed as Equation 1 below.

$$
\text{(Equation 1)}
$$

$$
XM = \begin{bmatrix} \overrightarrow{X_1} \\ \overrightarrow{X_2} \\ \vdots \\ \overrightarrow{X_h} \end{bmatrix} = \begin{bmatrix} x_{11} & x_{12} & \cdots & x_{1n} \\ x_{21} & x_{22} & \cdots & x_{2n} \\ \vdots & \vdots & \ddots & \vdots \\ x_{h1} & x_{h2} & \cdots & x_{hn} \end{bmatrix}
$$

Referring to Equation 1, the XM may represent the input matrix XM of dimension n x h, $\overrightarrow{X_1}$ to $\overrightarrow{X_h}$ may represent first to h-th input vectors, respectively, and $X_{11}$ to $X_{hn}$ may represent different input elements. For example, $x_{11}$ to $x_{1n}$ may represent input elements included in the first input vector (e.g., $\overrightarrow{X_1}$), and $x_{h1}$ to $x_{hn}$ may represent input elements included in the h-th input vector (e.g., $\overrightarrow{X_h}$ ). In Equation 1, h may be the same as n, less than n, or greater than n.

Below, for a more concise description, example embodiments in which a dimension of each of the input vectors included in the input matrix XM is "n" are representatively described. For example, various example embodiments in which each of the input vectors includes n-input elements is representatively described. Example embodiments in which the input matrix XM includes n-columns will be representatively described.

In various example embodiments, each of the input elements included in the input matrix XM may have a 16-bits floating-point (FP16) data type and/or a 32-bits floating-point (FP32) data type. However, example embodiments are not limited thereto.

The matrix multiplication device MMD may receive a weight matrix WM. The weight matrix WM may include a plurality of weights. For example, the weight matrix WM may be expressed as Equation 2 below.

(Equation 2)

$$WM = \begin{bmatrix} w_{11} & w_{12} & \cdots & w_{1m} \\ w_{21} & w_{22} & \cdots & w_{2m} \\ \vdots & \vdots & \ddots & \vdots \\ w_{n1} & w_{n2} & \cdots & w_{nm} \end{bmatrix}$$

Referring to Equation 2, the WM may represent a weight matrix WM, and $w_{11}$ to $w_{nm}$ may represent weights, at least two of which may be different from each other, respectively. For example, $w_{ij}$ may be a weight disposed in an i-th row and a j-th column of the weight matrix WM. Here, m may be the same as n, less than n, or greater than n.

In various example embodiments, each of the weights included in the weight matrix WM may have a 16-bit floating-point (FP16) data type and/or a 32-bit floating-point (FP32) data type. However, the scope example embodiments are not limited thereto.

The BCQ circuit 200 may perform binary coding quantization (BCQ) on the weight matrix WM. For example, the BCQ circuit 200 may determine a plurality of quantization sign values QSV and a plurality of quantization scale coefficients QSC based on the weight matrix WM.

For example, the BCQ circuit 200 may convert each of the plurality of weights to a plurality of 'quantization scale coefficient (QSC)-quantization sign value (QSV)' pairs. In some example embodiments, the BCQ circuit 200 may approximate each of the weights of the weight matrix WM with the plurality of quantization scale coefficient (QSC) and quantization sign value (QSV) pairs.

In various example embodiments, each of the plurality of quantization sign values QSV may be or correspond to or represent -1 or +1 (or, one of -1 or +1).

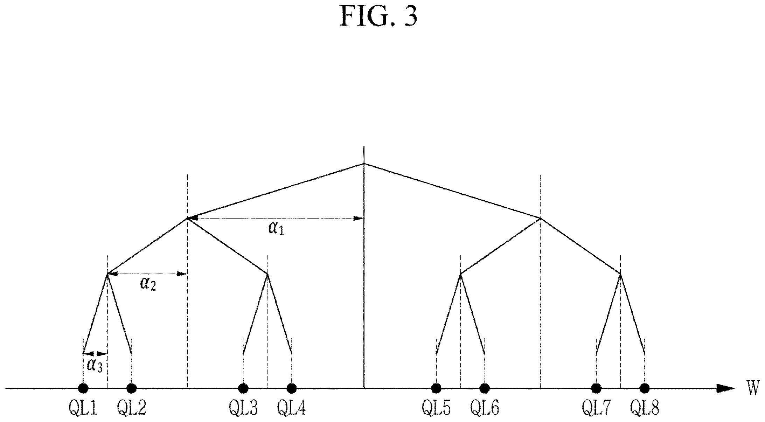

In some example embodiments, each of the plurality of quantization scale coefficients QSC may have the same data type as that of the respective weight of the weight matrix WM. For example, each of the plurality of quantization scale coefficients QSC may have an FP16 and/or an FP32 data type. However, example embodiments are not limited thereto. A specific operation of the BCQ circuit 200 is described in more detail with reference to FIG. 3.

The matrix multiplier 100 may receive the plurality of quantization sign values QSV and the plurality of quantization scale coefficients QSC. The matrix multiplier 100 may perform matrix multiplication for the input matrix XM and the weight matrix WM based on the plurality of quantization sign values QSV and the plurality of quantization scale coefficients QSC. For example, the matrix multiplier 100 may generate an output matrix YM by multiplying the input matrix XM by the weight matrix WM approximated based on the plurality of quantization sign values QSV and the plurality of quantization scale coefficients QSC. A quantization sign bit with a 1-bit code length may be provided to the matrix multiplier 100. However, example embodiments are not limited thereto.

The output matrix YM may include a plurality of output vectors. Each of the plurality of output vectors may include a plurality of output elements. For example, the output matrix YM may be expressed as Equation 3 below.

(Equation 3)

$$YM = \begin{bmatrix} \vec{Y_1} \\ \vec{Y_2} \\ \vdots \\ \vec{Y_h} \end{bmatrix} = \begin{bmatrix} y_{11} & y_{12} & \cdots & y_{1m} \\ y_{21} & y_{22} & \cdots & y_{2m} \\ \vdots & \vdots & \ddots & \vdots \\ y_{h1} & y_{h2} & \cdots & y_{hm} \end{bmatrix}$$

In this case, the YM may represent the output matrix YM, and $y_{11}$ to $y_{hm}$ may represent different output elements, respectively. For example, $y_{11}$ to $y_{1m}$ may represent output elements included in the first output vector (i.e., $\vec{Y_1}$), and $y_{h1}$ to $y_{hm}$ may represent output elements included in the h-th output vector (i.e., $\vec{Y_h}$). Here, h may be the same as m, greater than m, or less than m.

For example in various example embodiments, 'n' and 'm' may be the same integer. For example, the weight matrix WM may be implemented as a square matrix. In this case, dimensions of the output vectors included in the output matrix YM may be the same as the dimension of the input vector. However, example embodiments are not limited thereto.

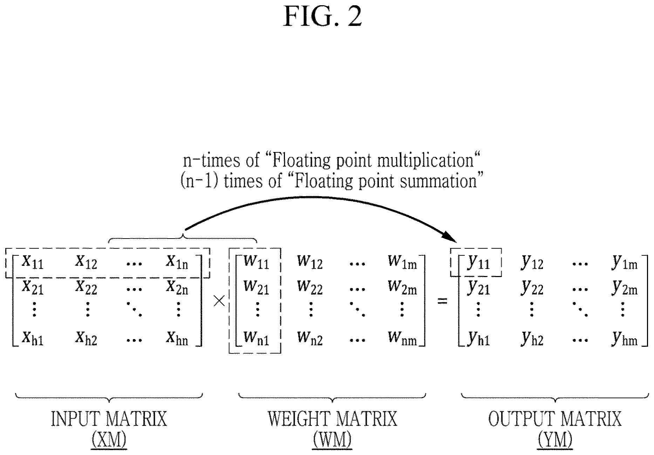

In various example embodiments, if the matrix multiplication device MMD directly multiplies the input matrix XM and the weight matrix WM to calculate the output matrix YM, the matrix multiplication device MMD may have to process a very large amount of computation. In this case, an operating speed of the matrix multiplication device MMD may be deteriorated. The operation of the matrix multiplication device MMD that calculates the output matrix YM by directly multiplying the input matrix XM and the weight matrix WM will be described in more detail with reference to FIG. 2 below.

On the other hand, if the matrix multiplication device MMD calculates the output matrix YM by multiplying the input matrix XM by the weight matrix WM approximated based on the plurality of quantization sign values QSV and on the plurality of quantization scale coefficients QSC, an amount of computation of the matrix multiplication device MMD may be reduced, e.g., may be greatly reduced. An operation of the matrix multiplication device MMD for calculating the output matrix YM based on the plurality of quantization sign values QSV and the plurality of quantization scale coefficients QSC will be described in more detail with reference to the following drawings.

FIG. 2 is a drawing showing the operation of a matrix multiplication device implemented to directly multiply input matrix and weight matrix of FIG. 1. Referring to FIG. 1 and FIG. 2, the matrix multiplication device MMD may calculate the output matrix YM by directly multiplying the input matrix XM and the weight matrix WM, for example with a matrix multiplication algorithm such as but not limited to one or more of the naive n^3 algorithm, Strassen's algorithm, a divide-and-conquer algorithm, Winograd's algorithm, etc.

In order to calculate one output element included in the output matrix YM, the matrix multiplication device MMD may have to perform of n-times of floating-point multiplication, and then may have to perform n-1 times of floating-point summation. For example, the matrix multiplication device MMD may calculate one of the output elements (e.g., $y_{11}$) included in the output matrix YM in a manner similar to Equation 4 below.

$$\text{(Equation 4)}$$

$$y_{11} = x_{11} \times w_{11} + x_{12} \times w_{21} + \cdots + x_{1n} \times w_{n1}$$

In this way, the matrix multiplication device MMD may have to perform $m \times n$ times floating-point multiplication and $m \times (n-1)$ times of floating-point summation to calculate the output vector (e.g., $\overrightarrow{Y_1}$) corresponding to one input vector (e.g., $\overrightarrow{X_1}$). In this case, an operating speed of an artificial intelligence model driven based on the matrix multiplication device MMD may be deteriorated due to an excessive amount of calculation performed by the matrix multiplication device MMD.

FIG. 3 is a drawing showing an operation of the BCQ circuit of FIG. 1. Referring to FIG. 1 and FIG. 3, a horizontal axis represents a size of the weight included in the weight matrix WM.

The BCQ circuit 200 may approximate one or more weights included in the weight matrix WM to a plurality of quantum levels QL. The BCQ circuit 200 may determine the number of the plurality of quantum levels QL based on a resolution, such as a predetermined BCQ resolution. For example, the BCQ circuit 200 may approximate each of the plurality of weights to $2^R$ quantum levels QL, wherein the R is the BCQ resolution. In this case, each of the $2^R$ quantum levels QL may be determined based on a combination of R-quantization scale coefficients QSC and the R-quantization sign values QSV.

However, hereinafter, for a more concise description, example embodiments where R is 3 will be representatively described. For example, the BCQ circuit 200 may approximate each of the weights included in the weight matrix WM to the first to eighth quantum level QL1-QL8. In this case, each of the first to eighth quantum levels QL1-QL8 may be determined based on Equation 5 below.

$$\text{(Equation 5)}$$

$$QL = \alpha_1 \times b_1 + \alpha_2 \times b_2 + \alpha_3 \times b_3$$

Referring to Equation 5, QL may represent an arbitrary quantum level, $\alpha_1$ to $\alpha_3$ may represent the quantization scale coefficients QSC, and $b_1$ to $b_3$ may represent the quantization sign values QSV. In this case, the first to eighth quantum levels QL1-QL8 may correspond to different combinations of b1 to b3.

For example, the first quantum level QL1 may correspond to a case where all of $b_1$ to $b_3$ are "-1". In this case, the first quantum level QL1 may correspond to "$-\alpha_1 - \alpha_2 - \alpha_3$". Similarly, the eighth quantum level QL8 may correspond to the case where all of $b_1$ to $b_3$ are "+1". In this case, the eighth quantum level QL8 may correspond to "$+\alpha_1 + \alpha_2 + \alpha_3$". In this way, the seventh quantum level QL7 may correspond to the case where $b_1$ to $b_3$ are "+1", "+1", and "-1", respectively. In this case, the seventh quantum level QL7 may correspond to "$+\alpha_1 + \alpha_2 - \alpha_3$". In some example embodiments, the sign of the sum may be based on the binary encoding of the quantum level QL. However, example embodiments are not limited thereto.

The BCQ circuit 200 may approximate each of the weights included in the weight matrix WM to the quantum level with the closest value among the first to eighth quantum levels QL1-QL8. For example, if a size of the weight $w_{11}$ is closest to the seventh quantum level QL7 among the first to eighth quantum levels QL1-QL8, the BCQ circuit 200 may approximate

the weight $w_{11}$ to the seventh quantum level QL7. In this case, the BCQ circuit 200 may represent the weight $w_{11}$ as a combination of the plurality of quantization scale coefficients QSC (e.g., $\alpha_1$ to $\alpha_3$) corresponding to the seventh quantum level QL7 and the plurality of quantization sign values QSV (e.g., "+1", "+1", and "-1"). Similarly, the BCQ circuit 200 may approximate each of the weights included in the weight matrix WM based on the plurality of quantization sign values QSV and the plurality of quantization scale coefficients QSC.

In various example embodiments, the plurality of quantization scale coefficients QSC may have different sizes, e.g. may have sizes decreasing, such as decreasing arithmetically or decreasing geometrically. For example, a size of $\alpha_1$ may be larger than a size of $\alpha_2$. The size of $\alpha_2$ may be larger than a size of $\alpha_3$.

For a more concise description, various example embodiments in which the BCQ resolution is 3 are representatively described in FIG. 3, but example embodiments are not limited thereto. For example, the BCQ resolution may be determined as an integer of 2 or more depending on the type of the artificial intelligence model driven and based on the matrix multiplication device MMD.

In some example embodiments, if the artificial intelligence model driven based on the matrix multiplication device MMD is or includes or is included in a large language model (LLM), the BCQ resolution may be 3. This may provide a favorable trade-off between performance and accuracy in this use case. However, example embodiments are not limited thereto.

Alternatively or additionally, in some example embodiments, if the artificial intelligence model driven based on the matrix multiplication device MMD is or includes or is included in an image object identification model, the BCQ resolution may be 2. This may provide a favorable trade-off between performance and accuracy in this use case. However, example embodiments are not limited thereto.

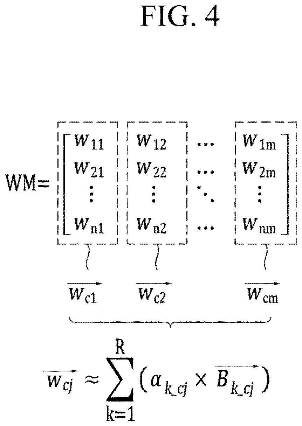

In some example embodiments, the BCQ circuit 200 may perform a binary coding quantization operation for each column of the weight matrix WM. For example, the BCQ circuit 200 may determine different plurality of quantization scale coefficients QSC for each column of the weight matrix WM. In this case, the quantization scale coefficients for the weights included in a first column of the weight matrix WM may be different from the quantization scale coefficients for the weights included in a second column of the weight matrix WM. Example embodiments in which the BCQ circuit 200 performs the binary coding quantization operation for each column of the weight matrix WM will be described in more detail with reference to FIGS. 4 to 14. However, example embodiments are not limited thereto.

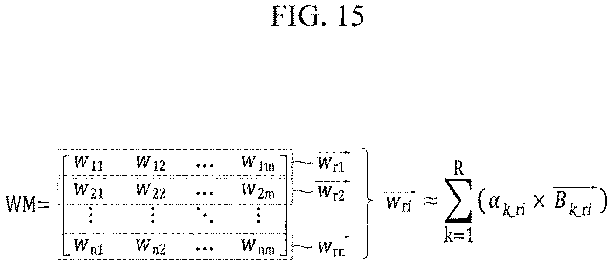

In some example embodiments, the BCQ circuit 200 may perform a binary coding quantization operation for each row of the weight matrix WM. For example, the BCQ circuit 200 may determine different plurality of quantization scale coefficients QSC for each row of the weight matrix WM. In this case, the quantization scale coefficients for the weights included in a first row of the weight matrix WM may be different from the quantization scale coefficients for the weights included in a second row of the weight matrix WM. Embodiments in which the BCQ circuit 200 performs the binary coding quantization operation for each row of the weight matrix WM will be described in more detail with reference to FIGS. 15 to 40. However, example embodiments are not limited thereto.

In some example embodiments, the BCQ circuit 200 may approximate each of the plurality of weights to the first to eighth quantum levels QL1-QL8 based on a uniform BCQ algorithm. For example, the BCQ circuit 200 may approximate the plurality of weights based on the first to eighth quantum levels QL1-QL8 with uniform intervals. In this case, sizes of the plurality of quantization scale coefficients QSC may be implemented as a geometric sequence with a common ratio of 2. For example, a size of $\alpha_1$ may be twice the size of $\alpha_2$, and the size of $\alpha_2$ may be twice the size of $\alpha_3$. However, example embodiments are not limited thereto.

FIG. 4 is a drawing showing the operation of the BCQ circuit of FIG. 1 that performs the binary coding quantization operation for each column of the weight matrix. Referring to FIG. 1, FIG. 3, and FIG. 4, the BCQ circuit 200 may perform the binary coding quantization operation for each column of the weight matrix WM.

First, the weight matrix WM may be expressed as Equation 6 below.

$$\text{(Equation 6)}$$

$$WM = \begin{bmatrix} w_{11} & w_{12} & \cdots & w_{1m} \\ w_{21} & w_{22} & \cdots & w_{2m} \\ \vdots & \vdots & \ddots & \vdots \\ w_{n1} & w_{n2} & \cdots & w_{nm} \end{bmatrix} = \begin{bmatrix} \overrightarrow{w_{c1}} & \overrightarrow{w_{c2}} & \cdots & \overrightarrow{w_{cm}} \end{bmatrix}$$

In this case, $\overrightarrow{w_{cj}}$ may represent a j-th column vector of the weight matrix WM. For example, $\overrightarrow{w_{cj}}$ may include $w_{1j}$ to $w_{nj}$.

The BCQ circuit 200 may perform a binary coding quantization operation for each column of the weight matrix WM based on Equation 7 below.

(Equation 7)

$$\overrightarrow{w_{cj}} \approx \sum_{k=1}^{R}\left(\alpha_{k\_cj} \times \overrightarrow{B_{k\_cj}}\right)$$

Referring to Equation 7, R may represent the BCQ resolution. The $\alpha_{k\_cj}$ may represent a k-th quantization scale coefficient for the j-th column vector of the weight matrix WM. The $\overrightarrow{B_{k\_cj}}$ may represent a quantization sign vector corresponding to $\alpha_{k\_cj}$. For example, $\overrightarrow{B_{k\_cj}}$ may represent a quantization sign vector corresponding to the k-th quantization scale coefficient of the j-th column vector of the weight matrix WM. The $\overrightarrow{B_{k\_cj}}$ may include a plurality of quantization sign values corresponding to the k-th quantization scale coefficient of the j-th column vector.

More specifically, $\overrightarrow{B_{k\_cj}}$ may be expressed as Equation 8 below.

(Equation 8)

$$\overrightarrow{B_{k\_cj}} = \begin{bmatrix} b_{1\_k\_cj} \\ b_{2\_k\_cj} \\ \vdots \\ b_{n\_k\_cj} \end{bmatrix}$$

Each of the $b_{1\_k\_cj}$ to $b_{n\_k\_cj}$ may represent different quantization sign values QSV respectively. More specifically, $b_{1\_k\_cj}$ to $b_{n\_k\_cj}$ may be quantization sign values for weights disposed in different rows of the weight matrix WM. Each of $b_{1\_k\_cj}$ to $b_{n\_k\_cj}$ may be "+1" or "-1".

For example, the BCQ circuit 200 may approximate each weight of the weight matrix WM based on the plurality of quantization sign values QSV (e.g., "b" values) and the plurality of quantization scale coefficients QSC (e.g., "α" values).

The BCQ circuit 200 may provide the plurality of quantization sign values QSV (e.g., "b" values) and the plurality of quantization scale coefficients QSC (e.g., "α" values) to the matrix multiplier 100. Hereinafter, an operation of the matrix multiplier 100 that performs a matrix multiplication calculation based on the plurality of quantization sign values QSV and the plurality of quantization scale coefficients QSC, will be described.

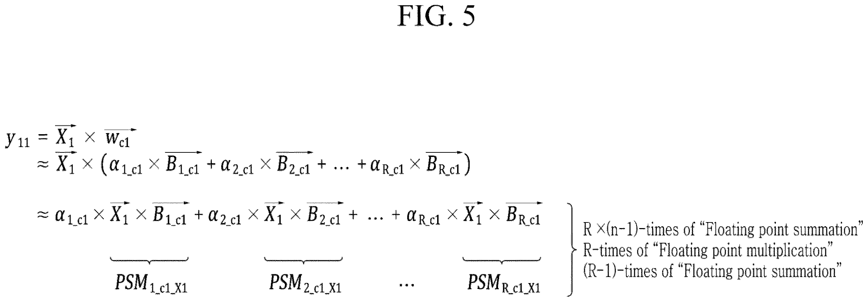

FIG. 5 is a drawing showing an operation of the matrix multiplier according to example embodiments described with reference to FIG. 4. Referring to FIGS. 1 and 3 to 5, the matrix multiplier 100 may calculate the output matrix YM based on the plurality of quantization sign values QSV and the plurality of quantization scale coefficients QSC.

Hereinafter, for a more concise description, an operation of the matrix multiplier 100 that multiplies the first input vector (e.g., $\overrightarrow{X_1}$) by the first column vector (e.g., $\overrightarrow{w_{c1}}$) of the weight matrix WM that is approximated based on the plurality of quantization sign values QSV and the plurality of quantization scale coefficients QSC to calculate the output element (e.g., $y_{11}$) of a first row and a first column of the output matrix YM, is representatively described. However, example embodiments are not limited thereto.

The matrix multiplier 100 may calculate $y_{11}$ according to Equation 9 below.

(Equation 9)

$$y_{11} \approx \overrightarrow{X_1} \times \left(\alpha_{1\_c1} \times \overrightarrow{B_{1\_c1}} + \alpha_{2\_c1} \times \overrightarrow{B_{2\_c1}} + ... + \alpha_{R\_c1} \times \overrightarrow{B_{R\_c1}}\right)$$

In this case, a product of the first input vector (e.g., $\overrightarrow{X_1}$) and the quantization sign vector (e.g., $\overrightarrow{B}$) may be referred to as a partial sum (hereinafter referred to as "PSM"). For example, a product of $\overrightarrow{X_1}$ and $\overrightarrow{B_{1\_c1}}$ may be referred to as a partial sum "$PSM_{1\_c1\_X1}$", and a product of $\overrightarrow{X_1}$ and $\overrightarrow{B_{2\_c1}}$ may be referred to as "$PSM_{2\_c1\_X1}$". In such way, partial sums for the first input vector (e.g., $\overrightarrow{X_1}$) may be expressed as Equation 10 below.

(Equation 10)

$$PSM_{1\_c1\_X1} = \begin{bmatrix} x_{11} & x_{12} & \cdots & x_{1n} \end{bmatrix} \times \begin{bmatrix} b_{1\_1\_c1} \\ b_{2\_1\_c1} \\ \vdots \\ b_{n\_1\_c1} \end{bmatrix}$$

$$PSM_{2\_c1\_X1} = \begin{bmatrix} x_{11} & x_{12} & \cdots & x_{1n} \end{bmatrix} \times \begin{bmatrix} b_{1\_2\_c1} \\ b_{2\_2\_c1} \\ \vdots \\ b_{n\_2\_c1} \end{bmatrix}$$

$$\vdots$$

$$PSM_{R\_c1\_X1} = \begin{bmatrix} x_{11} & x_{12} & \cdots & x_{1n} \end{bmatrix} \times \begin{bmatrix} b_{1\_R\_c1} \\ b_{2\_R\_c1} \\ \vdots \\ b_{n\_R\_c1} \end{bmatrix}$$

In this case, each of the partial sums for the first input vector (e.g., $\overrightarrow{X_1}$) may be calculated through an accumulation calculation of $X_{11}$ to $x_{1n}$ based on the quantization sign values QSV. For example, the matrix multiplier 100 may determine whether to invert sign bit of each input element, based on the quantization sign values QSV. Thereafter, the matrix multiplier 100 may sequentially accumulate input elements for which the sign bit is determined to calculate each of the partial sums of Equation 10 described above. Therefore, the matrix multiplier 100 may have to perform (n-1) times of floating-point summation to calculate one partial sum. As a result, the matrix multiplier 100 may have to perform $R \times (n - 1)$ times of floating-point summation to calculate all partial sums of Equation 10.

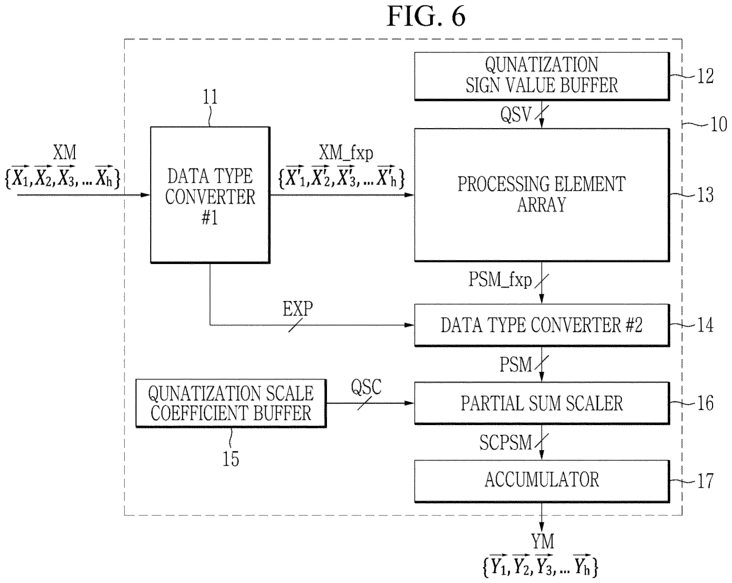

In some example embodiments, if a data type of each of the plurality of input elements is converted to a fixed-point, the matrix multiplier 100 may calculate the partial sum of Equation 10 with a small amount of calculation. For example, if the data type of each of the plurality of input elements is a fixed-point corresponding to same exponent value, the matrix multiplier 100 may have to perform $R \times (n - 1)$ times of fixed-point summation to calculate all partial sums of Equation 10. A more detailed operation of the matrix multiplier 100 for converting the data type of each of the plurality of input elements to the fixed-point will be described in more detail with reference to FIGS. 6 to 15.

The matrix multiplier 100 may calculate one output element by multiplying each of the plurality of partial sums of Equation 10 above by the quantization scale coefficient QSC, and then accumulating them. For example, the matrix multiplier 100 may calculate one output element (e.g., $y_{11}$) by performing R times of floating-point multiplication, and then performing R - 1 times of floating-point summation. In this case, unlike the above description with reference to FIG. 2, the number of floating-point multiplication performed by the matrix multiplier 100 may be reduced or minimized. For example, instead of performing $m \times n$ times of floating-point multiplication calculation and $m \times (n-1)$ times of floating-point summation, the matrix multiplier 100 may calculate the output element by performing R times of floating-point multiplication and R - 1 times of floating-point summation. Therefore, according to example embodiments described with reference to FIGS. 4 and 5, an operating speed of the matrix multiplication device MMD may be improved.

FIG. 6 is a block diagram showing a configuration of the matrix multiplier of FIG. 1 according to the embodiment of FIG. 4. Referring to FIGS. 1 and 3 to 6, the matrix multiplier 100 of FIG. 1 may be implemented as a matrix multiplier 10.

The matrix multiplier 10 may include a first data type converter 11, a quantization sign value buffer 12, a processing element array 13, a second data type converter 14, a quantization scale coefficient buffer 15, a partial sum scaler 16, and an accumulator 17.

The first data type converter 11 may receive the input matrix XM. For example, the first data type converter 11 may receive the plurality of input vector (e.g., $\overrightarrow{X_1}$ to $\overrightarrow{X_h}$) including the plurality of input elements.

The first data type converter 11 may extract an exponent EXP from each of the plurality of input vectors. For example, the first data type converter 11 may extract a first exponent from the input elements included in the first input vector ($\overrightarrow{X_1}$), and may extract a second exponent from input elements included in a second input vector ($\overrightarrow{X_2}$). The first data type converter 11 may provide extracted exponents EXP to the second data type converter 14.

The first data type converter 11 may convert a data type of each of the plurality of input vectors to fixed-point data type based on the extracted exponent. For example, the first data type converter 11 may convert a data type of each of the plurality of input elements to fixed-point. For example, the first data type converter 11 may receive the input matrix XM, and may output a fixed-point input matrix XM_fxp.

The fixed-point input matrix XM_fxp may include a plurality of fixed-point input vectors. Each of the plurality of fixed-point input vectors may include a plurality of fixed-point input elements. For example, the fixed-point input matrix XM_fxp may be expressed as Equation 11 below.

(Equation 11)

$$XM\_fxp = \begin{bmatrix} \overrightarrow{X'_1} \\ \overrightarrow{X'_2} \\ \vdots \\ \overrightarrow{X'_h} \end{bmatrix} = \begin{bmatrix} x'_{11} & x'_{12} & \cdots & x'_{1n} \\ x'_{21} & x'_{22} & \cdots & x'_{2n} \\ \vdots & \vdots & \ddots & \vdots \\ x'_{h1} & x'_{h2} & \cdots & x'_{hn} \end{bmatrix}$$

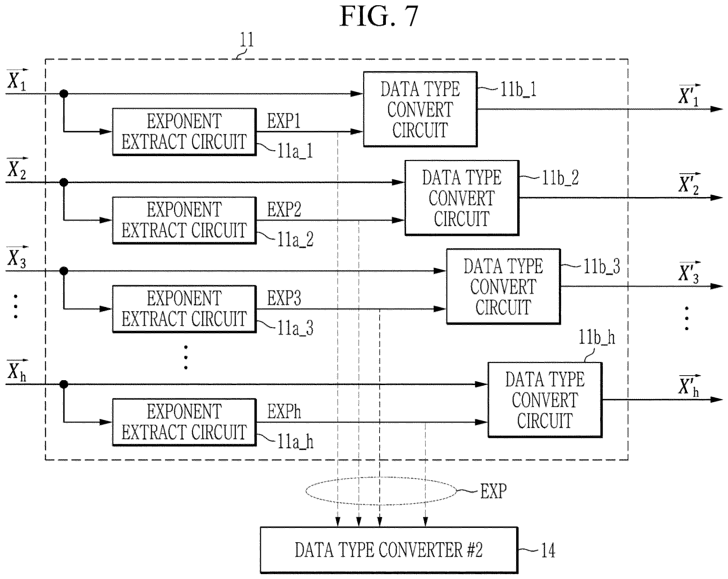

Here, h may be the same as, greater than, or less than n. In this case, XM_fxp may represent the fixed-point input matrix XM_fxp, $\overrightarrow{X'_1}$ to $\overrightarrow{X'_h}$ may represent first to h-th fixed-point input vectors, respectively, and $x'_{11}$ to $x'_{hn}$ may represent different fixed-point input elements. The $x'_{11}$ to $x'_{hn}$ may represent $x_{11}$ to $x_{hn}$ converted to a fixed-point data type, respectively. A configuration and an operation of the first data type converter 11 will be described in more detail with reference to FIGS. 7 to 9.

The quantization sign value buffer 12 may store the plurality of quantization sign values QSV provided from the BCQ circuit 200. The quantization sign value buffer 12 may provide the plurality of quantization sign values QSV to the processing element array 13.

The processing element array 13 may receive the plurality of quantization sign values QSV and the fixed-point input matrix XM_fxp. The processing element array 13 may calculate a plurality of fixed-point partial sums PSM_fxp based on the plurality of fixed-point input elements included in the fixed-point input matrix XM_fxp and the plurality of quantization sign values QSV. For example, the processing element array 13 may calculate the fixed-point partial sums PSM_fxp corresponding to the first input vector (e.g., $\overrightarrow{X_1}$) according to Equation 12 below.

(Equation 12)

$$PSM'_{1\_c1\_X1} = \begin{bmatrix} x'_{11} & x'_{12} & \cdots & x'_{1n} \end{bmatrix} \times \begin{bmatrix} b_{1\_1\_c1} \\ b_{2\_1\_c1} \\ \vdots \\ b_{n\_1\_c1} \end{bmatrix}$$

$$PSM'_{2\_c1\_X1} = \begin{bmatrix} x'_{11} & x'_{12} & \cdots & x'_{1n} \end{bmatrix} \times \begin{bmatrix} b_{1\_2\_c1} \\ b_{2\_2\_c1} \\ \vdots \\ b_{n\_2\_c1} \end{bmatrix}$$

$$\vdots$$

$$PSM'_{R\_c1\_X1} = \begin{bmatrix} x'_{11} & x'_{12} & \cdots & x'_{1n} \end{bmatrix} \times \begin{bmatrix} b_{1\_R\_c1} \\ b_{2\_R\_c1} \\ \vdots \\ b_{n\_R\_c1} \end{bmatrix}$$

In this case, $PSM'_{1\_c1\_X1}$ to $PSM'_{R\_c1\_X1}$ may have fixed-point forms of the above-described $PSM_{1\_c1\_X1}$ to $PSM_{2\_c1\_X1}$, respectively.

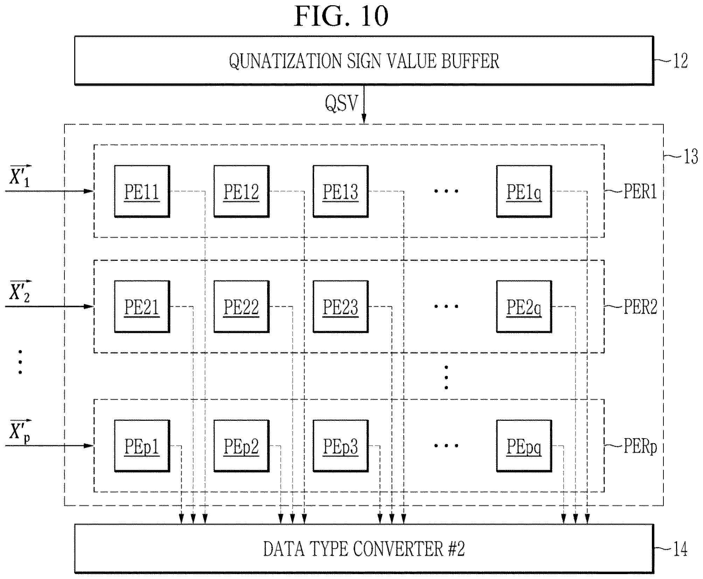

The processing element array 13 may include a plurality of processing elements disposed or arranged in a row direction and a column direction. Each processing element may calculate different fixed-point partial sums PSM_fxp described with Equation 12 above. A more detailed configuration and operation of each processing element will be described in more detail with reference to FIGS. 10 to 13.

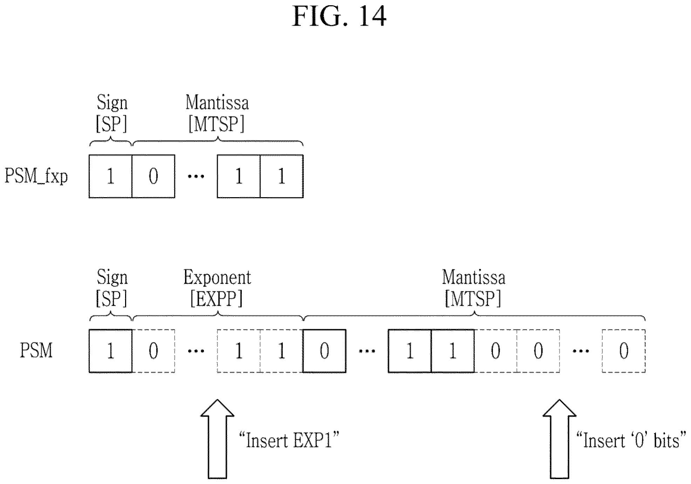

The second data type converter 14 may receive a plurality of exponents EXP from the first data type converter 11. The second data type converter 14 may receive the plurality of fixed-point partial sums PSM_fxp from the processing element array 13. The second data type converter 14 may convert data types of the plurality of fixed-point partial sums PSM_fxp to a floating-point based on the plurality of exponents EXP. For example, the second data type converter 14 may output a plurality of partial sums PSM having a floating-point format. For example, the second data type converter 14 may convert $PSM'_{1\_c1\_X1} \sim PSM'_{R\_c1\_X1}$ to $PSM_{1\_c1\_X1} \sim PSM_{2\_c1\_X1}$, respectively. A more detailed configuration and operation of the second data type converter 14 will be described in more detail with reference to FIG. 14.

The quantization scale coefficient buffer 15 may store the plurality of quantization scale coefficients QSC provided from the BCQ circuit 200. The quantization scale coefficient buffer 15 may provide the plurality of quantization scale coefficients QSC to the partial sum scaler 16.

The partial sum scaler 16 may receive a plurality of quantization scale coefficients QSC and the plurality of partial sums PSM.

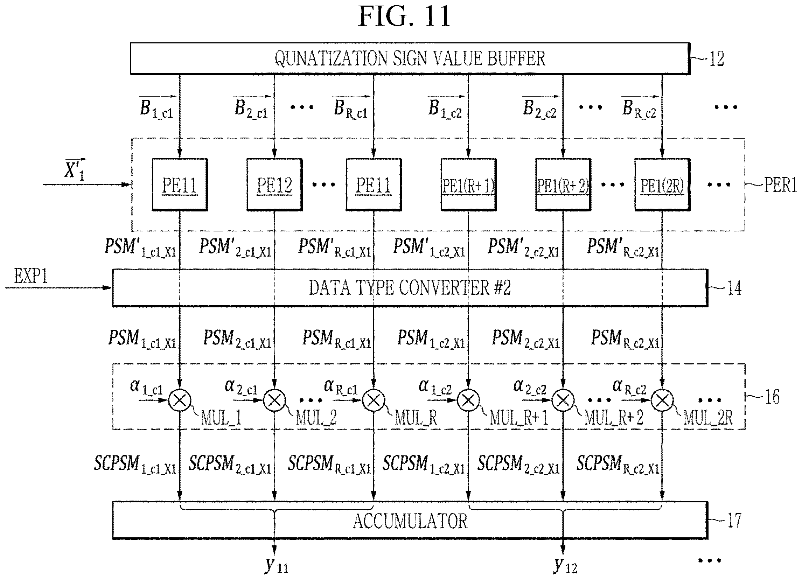

The partial sum scaler 16 may scale the plurality of partial sums PSM based on the plurality of quantization scale coefficients QSC. For example, the partial sum scaler 16 may generate a plurality of scaled partial sums SCPSM by multiplying each of the plurality of partial sums PSM by the quantization scale coefficient QSC corresponding to each of the plurality of partial sums PSM. A more detailed configuration and operation of the partial sum scaler 16 will be described in more detail with reference to FIG. 11.

In some example embodiments, the partial sum scaler 16 may temporarily store the plurality of scaled partial sums SCPSM in a volatile memory device (e.g., a static random access memory (SRAM) device and/or a dynamic random access memory (DRAM) device) outside the matrix multiplication device MMD.

The accumulator 17 may receive the plurality of scaled partial sums SCPSM. The accumulator 17 may calculate the plurality of output elements based on the plurality of scaled partial sums SCPSM. For example, the accumulator 17 may calculate one output element by adding the scaled partial sums SCPSM. For example, the accumulator 17 may calculate one output element by accumulating R-scaled partial sums SCPSM. In this way, the accumulator 17 may calculate the plurality of output elements to output the output matrix YM. A more detailed operation of the accumulator 17 will be described with reference to FIG. 11.

In some example embodiments, the accumulator 17 may read the plurality of scaled partial sums SCPSM from the volatile memory device outside the matrix multiplication device MMD.

In some example embodiments, an operating speed of the processing element array 13 may be faster than a speed of which the matrix multiplication device MMD accesses the volatile memory device of outside. In this case, a bottleneck phenomenon may occur in an operating speed of the matrix multiplication device MMD due to a speed of reading the plurality of scaled partial sums SCPSM from the volatile memory device of outside. A configuration and an operation of the matrix multiplication device MMD with reduced or minimized accessing times to the volatile memory device of outside will be described with reference to FIGS. 15 to 40.

FIG. 7 is a drawing showing a configuration of the first data type converter of FIG. 6. Referring to FIGS. 1 and 3 to 7, the first data type converter 11 may include first to h-th exponent extract circuits 11a_1 to 11a_h and first to h-th data type convert circuits 11b_1 to 11b_h.

The first to h-th exponent extract circuits 11a_1 to 11a_h may receive different input vectors, respectively. For example, the first to h-th exponent extract circuits 11a_1 to 11a_h may receive first to h-th input vectors (e.g., $\overrightarrow{X_1}$ to $\overrightarrow{X_h}$), respectively.

Each of the first to h-th exponent extract circuits 11a_1 to 11a_h may extract an exponent from the plurality of input elements included in the received input vector. For example, the first exponent extract circuit 11a_1 may extract a first exponent EXP1 from input elements (e.g., $x_{11}$ to $x_{1n}$) included in a first input vector; and the second exponent extract circuit 11a_2 may extract a second exponent EXP2 from input elements (e.g., $x_{21}$ to $x_{2N}$) included in a second input vector. In this way, the first to h-th exponent extract circuits 11a_1 to 11a_h may extract first to h-th exponents EXP1-EXPh, respectively.

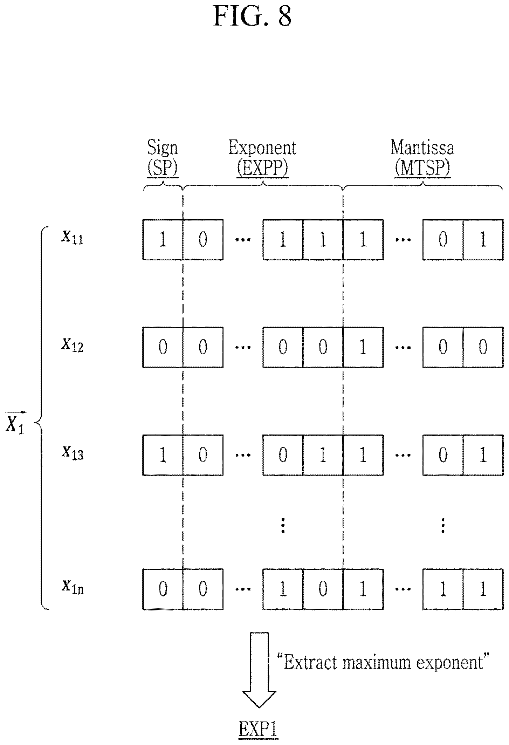

The first to h-th exponent extract circuits 11a_1 to 11a_h may provide the extracted exponents to the first to h-th data type convert circuits 11b_1 to 11b_h, respectively. Additionally, each of the first to h-th exponent extract circuits 11a_1 to 11a_h may provide the extracted exponent to the second data type converter 14. A more detailed operation of each of the first to h-th exponent extract circuits 11a_1 to 11a_h will be described in more detail with reference to FIG. 8.

The first to h-th data type convert circuits 11b_1 to 11b_h may receive the first to h-th exponents EXP1-EXPh, respectively. The first to h-th data type convert circuits 11b_1 to 11b_h may receive the first to h-th input vectors (e.g., $\overrightarrow{X_1}$ to $\overrightarrow{X_h}$), respectively.

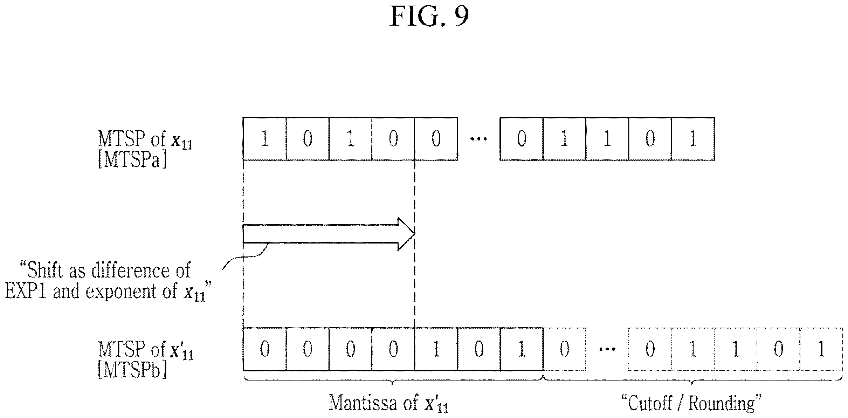

Each of the first to h-th data type convert circuits 11b_1 to 11b_h may convert a data type of the received input vector to a fixed-point based on the received exponent. The first to h-th data type convert circuits 11b_1 to 11b_h may output the first to h-th fixed-point input vectors (e.g., $\overrightarrow{X'_1}$ to $\overrightarrow{X'_h}$), respectively. For example, the first data type convert circuit (or a first data type convert circuit) 11b_1 may convert each of the input elements included in the first input vector to a fixed-point format based on the first exponent EXP1. A more detailed operation of each of the first to h-th data type convert circuits 11b_1 to 11b_h will be described in more detail with reference to FIG. 9.

FIG. 8 is a drawing showing an operation of the exponent extract circuit of FIG. 7. Below, for a more concise description, an operation of the first exponent extract circuit 11a_1 will be representatively described. However, example embodiments are not limited thereto.

Referring to FIGS. 1 and 3 to 8, the first exponent extract circuit 11a_1 may receive the plurality of input elements. For example, the first exponent extract circuit 11a_1 may receive $x_{11}$ to $x_{1n}$.

A data type of each of the plurality of input elements may be a floating-point. For example, each of $x_{11}$ to $x_{1n}$ may include a sign part SP, an exponent part EXPP, and a mantissa part MTSP.

The first exponent extract circuit 11 a_1 may identify the largest value among values of exponent parts EXPP of the received plurality of input elements. In this case, the first exponent extract circuit 11a_1 may determine the exponent of the identified input element as the first exponent EXP1. For example, the first exponent extract circuit 11 a_1 may extract the largest exponent among the exponents $x_{11}$ to $x_{1n}$.

For a more concise description, example embodiments in which the first exponent extract circuit 11 a_1 extracts the largest value among the values of the exponent parts of the plurality of input elements are representatively described in FIG. 8, but example embodiments are not limited thereto. For example, the first exponent extract circuit 11 a_1 may be implemented to extract the smallest value among the values of the exponent parts of the plurality of input elements.

FIG. 9 is a drawing showing an operation of the data type convert circuit of FIG. 7. Below, for a more concise description, an operation of the first data type convert circuit 11b_1 will be representatively described. However, example embodiments are not limited thereto.

Referring to FIGS. 1 and 3 to 9, the first data type convert circuit 11b_1 may receive the plurality of input elements. For example, the first data type convert circuit 11b_1 may receive $x_{11}$ to $x_{1n}$.

The first data type convert circuit 11b_1 may receive the first exponent EXP1. The first data type convert circuit 11b_1 may convert each of the received plurality of input elements into a fixed-point data type based on the first exponent EXP1. For example, the first data type convert circuit 11b_1 may convert $x_{11}$~$x_{1n}$ to $x'_{11}$~$x'_{1n}$, respectively. However, hereinafter, for a more concise description, an operation of the first data type convert circuit 11b_1 that converts the input element ($x_{11}$) to the fixed-point input element ($x'_{11}$), will be representatively described.

The first data type convert circuit 11b_1 may shift the mantissa part (hereinafter referred to as a first mantissa part MTSPa) of the input element ($x_{11}$) to a last significant bit (LSB) direction by a difference between the first exponent EXP1 and the exponent of $x_{11}$. For example, if the difference between the values of the first exponent EXP1 and the exponent part EXPP of $x_{11}$ is '4', the first data type convert circuit 11b_1 may insert four '0' bits into a most significant bit (MSB) place of the first mantissa part MTSPa.

The first data type convert circuit 11b_1 may determine the mantissa part (hereinafter referred to as the second mantissa part MTSPb) of the fixed-point input element ($x'_{11}$) based on the shifted first mantissa part MTSPa. For example, the first data type convert circuit 11b_1 may cut-off low-order bits of the shifted first mantissa part MTSPa according to a code length of the second mantissa part MTSPb. Alternatively or additionally, the first data type convert circuit 11b_1 may determine the low bits of the shifted first mantissa part MTSPa according to the code length of the second mantissa part MTSPb based on various types of rounding algorithms such as 'nearest even rounding' and/or the like. However, example embodiments are not limited thereto.

In some example embodiments, a code length of the first mantissa part MTSPa may be 10 bits or 23 bits. However, example embodiments are not limited thereto.

In some example embodiments, the code length of the second mantissa part MTSPb may be 7 bits. However, example embodiments are not limited thereto.

In some example embodiments, a data type of each of the plurality of fixed-point input elements may be an 8-bit integer (INT8). However, example embodiments are not limited thereto.

FIG. 10 is a block diagram showing a configuration of the processing element array of FIG. 6 in more detail. Referring to FIGS. 1 and 3 to 10, the processing element array 13 may include a plurality of processing elements PE disposed in a row direction and a column direction. Hereinafter, for a more concise description, it is assumed that the plurality of processing elements PE are disposed in p-rows and q-columns. Additionally, the processing element disposed in an i-th row and a j-th column of the processing element array 13 will be referred to as "PEij". For example, the processing element disposed in a first row and a second column of the processing element array 13 will be referred to as "PE12".

The processing element array 13 may include first to p-th processing element rows PER1-PERp. Each of the first to p-th processing element rows PER1-PERp may include different plurality of processing elements PE. For example, the first processing element row PER1 may include processing elements PE11-PE1q.

In some example embodiments, "p" may be an integer having a size equal to or smaller than "h". However, example embodiments are not limited thereto.

The first to p-th processing element rows PER1-PERp may receive different fixed-point input vectors, respectively. For example, the first to p-th processing element rows PER1-PERp may receive first to p-th fixed-point input vectors (e.g., $\overrightarrow{X'_1}$ to $\overrightarrow{X'_p}$), respectively. For example, each of the first to p-th processing element rows PER1-PERp may perform a multiplication operation on the weight matrix WM of different input vectors.

Each of the plurality of processing elements PE may receive the plurality of quantization sign values QSV from the quantization sign value buffer 12.

The processing elements disposed in the same column of the processing element array 13 may receive the same quantization sign value. For a more detailed example, the quantization sign values received by the processing element PE11 may be the same as the quantization sign values received by the processing element PE21.

The processing elements disposed in different columns of the processing element array 13 may receive different quantization sign values. For example, the quantization sign values received by the processing element PE11 may be different from the quantization sign values received by the processing element PE12.

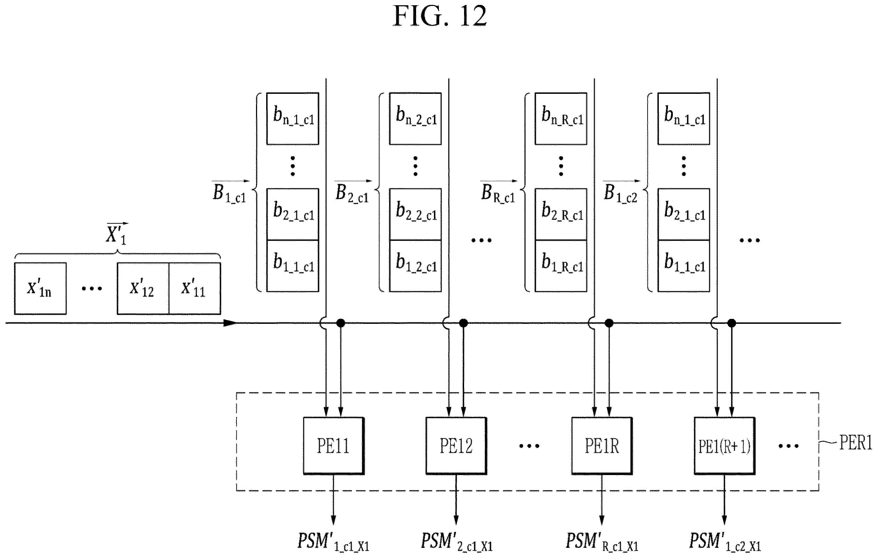

The quantization sign values provided to the different columns of the processing element array 13 are described in more detail with reference to FIG. 12.

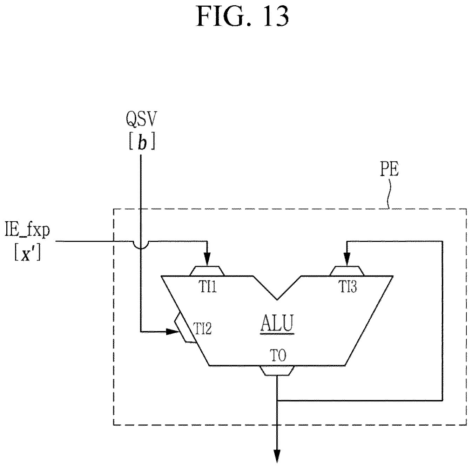

Each of the plurality of processing elements PE may calculate the different fixed-point partial sums PSM_fxp based on the received fixed-point input vector and quantization sign values QSV. The plurality of processing elements PE may provide the calculated fixed-point partial sums (PSM_fxp) to the second data type converter 14. A specific method in which the plurality of processing elements PE calculate the different fixed-point partial sums PSM_fxp will be described in more detail with reference to FIGS. 11 and 13.

FIG. 11 is a block diagram showing some operations of the matrix multiplier of FIG. 6 in more detail. Below, an operation of the matrix multiplier 10 related to the first fixed-point input vector $\overrightarrow{X'_1}$ will be representatively described, but example embodiments are not limited thereto. For example, the matrix multiplier 10 may operate in the same or a similar way for other fixed-point input vectors.

Referring to FIGS. 1 and 3 to 11, the first processing element row PER1 may receive the first fixed-point input vector (e.g., $\overrightarrow{X'_1}$). For example, each of the processing elements PE11-PE1q may receive $x'_{11}$ to $x'_{1n}$.

The processing elements PE11-PE1q may receive different quantization sign vectors, respectively. For example, processing elements PE11-PE1R may receive quantization sign vectors (e.g., $\overrightarrow{B_{1\_c1}}$ to $\overrightarrow{B_{R\_c1}}$) corresponding to first to R-th quantization scale coefficients of the first column vector of the weight matrix $\overrightarrow{WM}$, respectively. Similarly, processing elements PE1(R+1)-PE1(2R) may receive quantization sign vectors (e.g., $\overrightarrow{B_{1\_c2}}$ to $\overrightarrow{B_{R\_c2}}$) corresponding to first to R-th quantization scale coefficients of a second column vector of the weight matrix $\overrightarrow{WM}$, respectively. In this way, the processing elements included in the first processing element row PER1 may receive different quantization sign vectors from the quantization sign value buffer 12.

Each of the processing elements included in the first processing element row PER1 may calculate the different fixed-point partial sums PSM_fxp. For example, the processing elements PE11-PE1R may calculate $PSM'_{1\_c1\_X1}$ to $PSM'_{R\_c1\_X1}$, respectively. Similarly, the processing elements PE1(R+1)-PE1(2R) may calculate $PSM'_{1\_c2\_X1}$ to $PSM'_{R\_c2\_X1}$, respectively.

The second data type converter 14 may receive the first exponent EXP1. The second data type converter 14 may receive the plurality of fixed-point partial sums PSM_fxp from the first processing element row PER1. The second data type converter 14 may convert the received fixed-point partial sum PSM_fxp to a floating-point data type based on the first exponent EXP1. For example, the second data type converter 14 may convert $PSM'_{1\_c1\_X1} \sim PSM'_{R\_c1\_X1}$ to $PSM_{1\_c1\_X1} \sim PSM_{R\_c1\_X1}$, respectively. Similarly, the second data type converter 14 may convert $PSM'_{1\_c2\_X1} \sim PSM'_{R\_c2\_X1}$ to $PSM_{1\_c2\_X1} \sim PSM_{R\_c2\_X1}$, respectively.

The partial sum scaler 16 may include a plurality of multiplication circuits MUL. A plurality of multiplication circuits MUL may receive different partial sums. Hereinafter, for a more concise description, the multiplication circuit MUL that receives the partial sum PSM generated based on the processing element disposed in a j-th column of the processing element array 13 will be referred to as "MUL_j". For example, the multiplication circuits MUL_1-MUL_R may receive $PSM_{1\_c1\_X1}$ to $PSM_{R\_c1\_X1}$, respectively, and the multiplication circuits MUL_R+1-MUL_2R may $PSM_{1\_c2\_X1}$ to $PSM_{R\_c2\_X1}$, respectively.

Each of the plurality of multiplication circuits MUL may receive one quantization scale coefficient QSC corresponding to the received partial sum PSM. For example, the multiplication circuits MUL_1-MUL_R may receive $\alpha_{1\_c1}$ to $\alpha_{R\_c1}$, respectively, and the multiplication circuits MUL_R+1-MUL_2R may receive $\alpha_{1\_c2}$ to $\alpha_{R\_c2}$, respectively.

Each of the plurality of multiplication circuits MUL may multiply the received partial sum PSM and the quantization scale coefficient QSC to output a scaled partial sum SCPSM. For example, the multiplication circuits MUL_1-MUL_R may output $SCPSM_{1\_c1\_X1}$ to $SCPSM_{R\_c1\_X1}$, respectively, and the multiplication circuits MUL_R+1-MUL_2R may output $SCPSM_{1\_c2\_X1}$ to $SCPSM_{R\_c2\_X1}$, respectively.

The accumulator 17 may receive a plurality of scaled partial sums SCPSM from the partial sum scaler 16. The accumulator 17 may calculate the output element by accumulating scaled partial sums corresponding to the same input vector and the same column vector among the plurality of scaled partial sums SCPSM. For example, the accumulator 17 may calculate $y_{11}$ by summing $SCPSM_{1\_c1\_X1}$ to $SCPSM_{R\_c1\_X1}$ corresponding to the first input vector (e.g., $\overrightarrow{X_1}$) and corresponding to the first column vector (e.g., $\overrightarrow{w_{c1}}$) of the weight matrix WM. Similarly, the accumulator 17 may calculate $y_{12}$ by summing $SCPSM_{1\_c2\_X1}$ to $SCPSM_{R\_c2\_X1}$ corresponding to the first input vector (e.g., $\overrightarrow{X_1}$) and the second column vector (e.g., $\overrightarrow{w_{c2}}$) of the weight matrix WM.

For example, the matrix multiplier 10 may calculate the output elements (e.g., $y_{11}$ to $y_{1m}$) corresponding to the first input vector (e.g., $\overrightarrow{X_1}$) using the processing elements included in the first processing element row PER1. Similarly, the matrix multiplier 10 may use the processing elements included in a second processing element row PER2 to calculate the output elements (e.g., $y_{21}$ to $y_{2m}$) corresponding to the second input vector (e.g., $\overrightarrow{X_2}$).

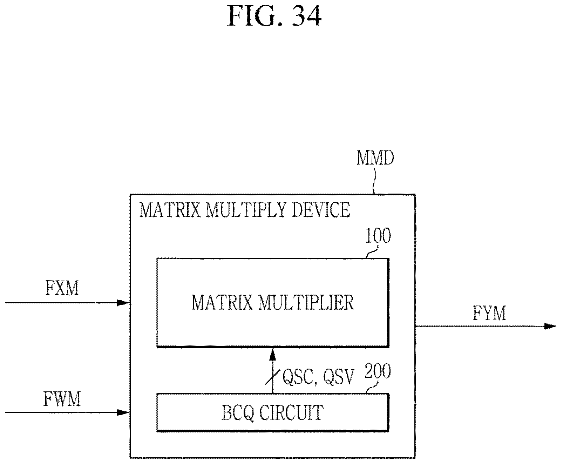

In some example embodiments, if a product of the number of columns of the weight matrix WM (e.g., m) and the BCQ resolution (e.g., R) is greater than the number of columns of the processing element array 13 (e.g., q), the matrix multiplier 10 may calculate the output elements based on various tiling techniques. The tiling technique will be described in more detail with reference to FIGS. 34 to 37.

In some example embodiments, the product of the number of columns of the weight matrix WM (e.g., m) and the BCQ resolution (e.g., R) may not be an integer multiple of the number of columns of the processing element array 13 (e.g., q). In this case, some columns of the processing element array 13 may not perform the partial sum calculation operation described above. For example, according to example embodiments described with reference to FIGS. 4 to 11, an operating efficiency of the processing element array 13 may be deteriorated, and an operating speed of the matrix multiplication device MMD may be deteriorated.

FIG. 12 is a drawing showing operations of the processing elements of FIG. 11. Referring to FIGS. 1 and 3 to 12, the first processing element row PER1 may include processing elements PE11, PE12, PE1R, and PE1(R+1). Below, for a more concise description, operations of the processing elements PE11, PE12, PE1R, and PE1(R+1) are representatively described, but example embodiments are not limited thereto.

Each of the processing elements included in the first processing element row PER1 may receive the first fixed-point input vector (e.g., $\overrightarrow{X'_1}$). For example, each of the processing elements PE11, PE12, PE1R, and PE1(R+1) may sequentially receive $x'_{11}$ to $x'_{1n}$.

Each of the processing elements PE11, PE12, PE1R, and PE1(R+1) may receive different quantization sign vectors. For example, the processing element PE11 may sequentially receive the quantization sign values (e.g., $b_{1\_1\_c1}$ to $b_{n\_1\_c1}$) included in $\overrightarrow{B_{1\_c1}}$. Similarly, the processing element PE12 may sequentially receive the quantization sign values (e.g., $b_{1\_2\_c1}$ to $b_{n\_2\_c1}$) included in $\overrightarrow{B_{2\_c1}}$, the processing element PE1R may sequentially receive the quantization sign values (e.g., $b_{1\_R\_c1}$ to $b_{n\_R\_c1}$) included in $\overrightarrow{B_{R\_c1}}$, and the processing element PE1(R+1) may sequentially receive the quantization sign values (e.g., $b_{1\_1\_c2}$ to $b_{n\_1\_c2}$) included in $\overrightarrow{B_{1\_c2}}$.

Each of the processing elements PE11, PE12, PE1R, and PE1(R+1) may calculate the different fixed-point partial sums PSM_fxp based on an order in which the fixed-point input elements and the quantization sign values are received. For example, the processing element PE11 may calculate $PSM'_{1\_c1\_X1}$ according to Equation 13 below.

(Equation 13)

$$PSM'_{1\_c1\_X1} = x'_{11} \times b_{1\_1\_c1} + x'_{12} \times b_{2\_1\_c1} + \cdots + x'_{1n} \times b_{n\_1\_c1}$$

A method in which another processing element PE calculates the fixed-point partial sum PSM_fxp is similar to that in which the processing element PE11 calculates the fixed-point partial sum PSM_fxp, so that a detailed description thereof is omitted.

For a more concise description, FIG. 12 illustrates various example embodiments in which the same fixed-point input element is individually provided to each of the processing elements included in the first processing element row PER1, but example embodiments are not limited thereto. For example, each of the processing elements included in the first processing element row PER1 may be implemented to sequentially transfer the received fixed-point input elements to the processing elements adjacent to a row direction. However, example embodiments are not limited thereto.

In some example embodiments, the processing elements disposed in the same column of the processing element array 13 may receive the same quantization sign vector. In this case, each processing element disposed in the same column may be implemented to sequentially transfer the received quantization sign vector to the processing elements adjacent to a column direction. However, example embodiments are not limited thereto.

FIG. 13 is a drawing showing a configuration of one of the processing elements of FIG. 12 implemented according to various example embodiments. Referring to FIGS. 1 and 3 to 13, the processing element PE may include an arithmetic logic unit ALU.

The arithmetic logic unit ALU may include first to third input terminals TI1-TI3 and an output terminal TO. The first input terminal TI1 may receive the fixed-point input element IE_fxp (e.g., $x'_{11}$). The second input terminal TI2 may receive the quantization sign value QSV. The third input terminal TI3 may be connected to the output terminal TO.

The arithmetic logic unit ALU may output a value obtained by adding a product of values received by the first input terminal TI1 and the second input terminal TI2 to a value received through the third input terminal TI3 to the output terminal TO. However, example embodiments are not limited thereto.

FIG. 14 is a drawing showing an operation of the second data type converter of FIG. 6. Below, for a more concise description, an operation of the second data type converter 14 corresponding to the first input vector (e.g., $\overrightarrow{X_1}$) will be representatively described. However, example embodiments are not limited thereto.

Referring to FIGS. 1 and 3 to 14, the second data type converter 14 may receive the first exponent EXP1 from first data type converter 11. The second data type converter 14 may receive the fixed-point partial sum PSM_fxp from one processing element PE.

The second data type converter 14 may generate the partial sum PSM by converting a data type of the fixed-point partial sum PSM_fxp to a floating-point.

The second data type converter 14 may add the exponent part EXPP to the fixed-point partial sum PSM_fxp. The second data type converter 14 may determine the exponent part EXPP of the partial sum PSM as the first exponent EXP1.

The second data type converter 14 may add a plurality of 0 bits to an LSB place of the mantissa part of the partial sum PSM, according to a difference in code lengths of the mantissa part of the partial sum PSM and the mantissa part of the fixed-point partial sum PSM_fxp. However, example embodiments are not limited thereto.

FIG. 15 is a drawing showing the operation of the BCQ circuit of FIG. 1 according to some example embodiments. Referring to FIG. 1, FIG. 3, and FIG. 15, the BCQ circuit 200 may perform a binary coding quantization operation for each row of the weight matrix WM.

First, the weight matrix WM may be expressed as Equation 14 below.

$$\text{(Equation 14)}$$

$$\text{WM} = \begin{bmatrix} w_{11} & w_{12} & \cdots & w_{1m} \\ w_{21} & w_{22} & \cdots & w_{2m} \\ \vdots & \vdots & \ddots & \vdots \\ w_{n1} & w_{n2} & \cdots & w_{nm} \end{bmatrix} = \begin{bmatrix} \overrightarrow{w_{r1}} \\ \overrightarrow{w_{r2}} \\ \vdots \\ \overrightarrow{w_{rn}} \end{bmatrix}$$

Referring to Equation 14, $\overrightarrow{w_{r1}}$ may represent an i-th row vector of the weight matrix WM. For example, $\overrightarrow{w_{ri}}$ may include $w_{i1}$ to $w_{im}$.

The BCQ circuit 200 may perform a binary coding quantization operation for each row of the weight matrix WM based on Equation 15 below.

$$\text{(Equation 15)}$$

$$\overrightarrow{w_{ri}} \approx \sum_{k=1}^{R} \left( \alpha_{k\_ri} \times \overrightarrow{B_{k\_ri}} \right)$$

Referring to Equation 15, R may represent the BCQ resolution. The $\alpha_{k\_ri}$ may represent a k-th quantization scale coefficient for an i-th row vector of the weight matrix WM. The $\overrightarrow{B_{k\_ri}}$ may represent the quantization sign vector corresponding to $\alpha_{k\_ri}$. For example, $\overrightarrow{B_{k\_r1}}$ may represent the quantization sign vector corresponding to the k-th quantization scale coefficient for the i-th row vector of the weight matrix WM.

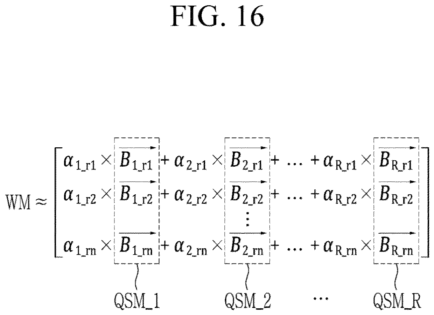

FIG. 16 is a drawing showing a weight matrix approximated according to the embodiment of FIG. 15. Referring to FIG. 1, FIG. 3, FIG. 15, and FIG. 16, the quantization sign vector $(\overrightarrow{B_{k\_r1}})$ may be implemented as a row vector with the same dimension as that of the number of columns of the weight matrix WM. For example, the quantization sign vector $(\overrightarrow{B_{k\_ri}})$ may be expressed as Equation 16 below.

$$\text{(Equation 16)}$$

$$\overrightarrow{B_{k\_r1}} = \begin{bmatrix} b_{1\_k\_ri} & b_{2\_k\_ri} & \cdots & b_{m\_k\_ri} \end{bmatrix}$$

The $b_{1\_k\_ri}$ to $b_{m\_k\_ri}$ may represent different quantization sign values QSV, respectively. For example, $b_{1\_k\_ri}$ to $b_{m\_k\_ri}$ may be quantization sign values for weights disposed in different columns of the weight matrix WM. Each of $b_{1\_k\_ri}$ to $b_{m\_k\_ri}$ may be "+1" or "-1".

In this way, the BCQ circuit 200 may approximate each row vector included in the weight matrix WM with a combination of the plurality of quantization sign values QSV and the plurality of quantization scale coefficients QSC.

Below, for a more concise description, an operation of the matrix multiplier 100 that calculates the output element (e.g., $y_{11}$) of the first row and first column of the output matrix YM, is representatively described. However, example embodiments are not limited thereto.

The BCQ circuit 200 may provide the plurality of quantization sign values QSV (e.g., "b" values) and the plurality of quantization scale coefficients QSC (e.g., "α" values) to the matrix multiplier 100.

The matrix multiplier 100 may calculate the output matrix YM based on the plurality of quantization sign values QSV and the plurality of quantization scale coefficients QSC. For example, the matrix multiplier 100 may calculate the output matrix YM by multiplying the input matrix XM by the weight matrix WM approximated in the manner described above with reference to Equations 14 to 16 and FIG. 16.

For a more detailed example, the matrix multiplier 100 may calculate $y_{11}$ according to Equation 17 below.

(Equation 17)

$$y_{11} \approx x_{11} \times \left( \alpha_{1\_r1} \times b_{1\_2\_r1} + \alpha_{2\_r1} \times b_{1\_2\_r1} + \ldots + \alpha_{R\_r1} \times b_{1\_R\_r1} \right)$$

$$+ x_{12} \times \left( \alpha_{1\_r2} \times b_{1\_2\_r2} + \alpha_{2\_r2} \times b_{1\_2\_r2} + \ldots + \alpha_{R\_r2} \times b_{1\_R\_r2} \right)$$

$$+ \ldots$$

$$+ x_{1n} \times \left( \alpha_{1\_rn} \times b_{1\_2\_rn} + \alpha_{2\_rn} \times b_{1\_2\_rn} + \ldots + \alpha_{R\_rn} \times b_{1\_R\_rn} \right)$$

In some example embodiments, the matrix multiplier 100 may be implemented to calculate the output element by first calculating a product of the quantization scale coefficient QSC and the input element (hereinafter referred to as a scaled input element (SCIE)), and then accumulating the calculated product based on the quantization sign value. In this case, the matrix multiplier 100 may use the same scaled input element to calculate different output elements included in one output vector (e.g., $\overrightarrow{Y_1}$). For example, the matrix multiplier 100 may use ($\alpha_{1\_r1} \times x_{11}$) for calculations of $y_{11}$ to $y_{1n}$. Therefore, according to the embodiment of the present disclosure, an amount of computation of the matrix multiplier 100 may be reduced or minimized. A more detailed configuration and operation of the matrix multiplier 100 will be described in more detail with reference to FIGS. 16 to 33.

On the other hand, continuing to refer to FIG. 16 and Equations 14 to 16, the quantization sign vectors (e.g., $\overrightarrow{B_{1\_r1}}$ to $\overrightarrow{B_{1\_rn}}$) multiplied by first quantization scale coefficients for first to n-th rows of the weight matrix WM (e.g., $\alpha_{1\_r1}$ to $\alpha_{1\_rn}$) may be expressed as a first quantization sign matrix QSM_1. For example, the first quantization sign matrix QSM_1 may be expressed as Equation 18 below.

(Equation 18)

$$QSM\_1 = \begin{bmatrix} \overrightarrow{B_{1\_r1}} \\ \overrightarrow{B_{1\_r2}} \\ \vdots \\ \overrightarrow{B_{1\_rn}} \end{bmatrix}$$

In a similar manner, the quantization sign vectors (e.g., $\overrightarrow{B_{R\_r1}}$ to $\overrightarrow{B_{R\_rn}}$) that are multiplied by R-th quantization scale coefficients (e.g., $\alpha_{R\_r1}$ to $\alpha_{R\_rn}$) for the first to n-th rows of the weight matrix WM may be expressed as a quantization sign matrix QSM_R.

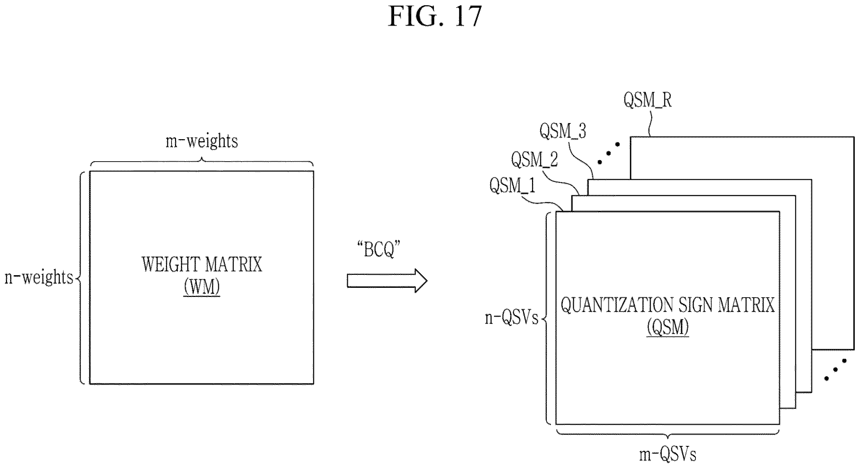

In some example embodiments, the first to R-th quantization sign matrices QSM_1-QSM_R may be implemented with the same number of rows and columns as that of the weight matrix WM. For example, the number of rows of the first quantization sign matrix QSM_1 may be "n", and the number of columns of the first quantization sign matrix QSM_1 may be "m". The first to R-th quantization sign matrices QSM_1-QSM_R will be described in more detail with reference to FIG. 17.

FIG. 17 is a drawing showing the quantization sign matrices of FIG. 16. Referring to FIGS. 1, 3, and 15 to 17, the BCQ circuit 200 may perform binary coding quantization (BCQ) on the weight matrix WM into the plurality of quantization sign matrices QSM and the plurality of quantization scale coefficients QSC.

The number of quantization sign matrices QSM may be determined according to the BCQ resolution (e.g., R). For example, the BCQ circuit 200 may perform binary coding quantization on the weight matrix WM to generate the first to R-th quantization sign matrices QSM_1-QSM_R.

Each of the first to R-th quantization sign matrices QSM_1-QSM_R may be implemented with the same number of rows and columns as that of the weight matrix WM. For example, the number of rows of each of the first to R-th quantization sign matrices QSM_1-QSM_R may be "n", and the number of columns of each of the first to R-th quantization sign matrices QSM_1-QSM_R may be "m". In this case, the quantization sign value QSV disposed in an i-th row and a j-th column of the k-th quantization sign matrix QSM_k may be $b_{j\_k\_ri}$.

Each weight of the weight matrix WM may be approximated based on the quantization sign values QSV disposed at the corresponding positions of the first to R-th quantization sign matrices QSM_1-QSM_R. For example, the weight (e.g., $w_{ij}$) disposed in an i-th row and a j-th column of the weight matrix WM may be approximated based on the quantization sign values disposed in an i-th row and a j-th column of the first to R-th quantization sign matrices QSM_1-QSM_R (e.g.,

$b_{j\_1\_ri}$ to $b_{j\_R\_ri}$).

Each of the first to R-th quantization sign matrices QSM_1-QSM_R may correspond to the plurality of quantization scale coefficients. For example, as described above with reference to FIG. 15 to FIG. 16, if the BCQ circuit 200 performs a binary coding quantization operation for each row of the weight matrix WM, different rows of the weight matrix WM may be approximated based on different quantization scale coefficients, and the weights included in the same row of the weight matrix WM may be approximated based on the same quantization scale coefficient.

For example, all quantization sign values (e.g., $b_{1\_k\_ri}$ to $b_{m\_k\_ri}$) included in an i-th row of the k-th quantization sign matrix QSM_k may correspond to the quantization scale coefficient ($\alpha_{k\_ri}$). For example, first to n-th rows of the k-th quantization sign matrix QSM_k may respectively correspond to the quantization scale coefficients $\alpha_{k\_r1}$ to $\alpha_{k\_rn}$.

For a more detailed example, first to n-th rows of the first quantization sign matrix QSM_1 may correspond to $\alpha_{1\_r1}$ to $\alpha_{1\_rn}$, respectively. In this case, all quantization sign values disposed in the first row of the first quantization sign matrix QSM_1 may correspond to $\alpha_{1\_r1}$.

In this way, the weights (e.g., $w_{ij}$) disposed in the i-th row and the j-th column of the weight matrix WM may be approximated based on the quantization scale coefficients QSC (e.g., $\alpha_{1\_ri}$ to $\alpha_{R\_ri}$) corresponding to the quantization sign values disposed in an i-th row of the first to R-th quantization sign matrices QSM_1-QSM_R. According to various example embodiments, the quantization scale coefficient may be defined independently of a column number of the weight matrix.

Therefore, each of the plurality of weights may be approximated by the plurality of quantization scale coefficients QSC and the plurality of quantization sign values QSV according to Equation 19 below.

$$\text{(Equation 19)}$$

$$w_{ij} \approx \alpha_{1\_ri} \times b_{j\_1\_ri} + \alpha_{2\_ri} \times b_{j\_2\_ri} + \cdots + \alpha_{R\_ri} \times b_{j\_R\_ri}$$

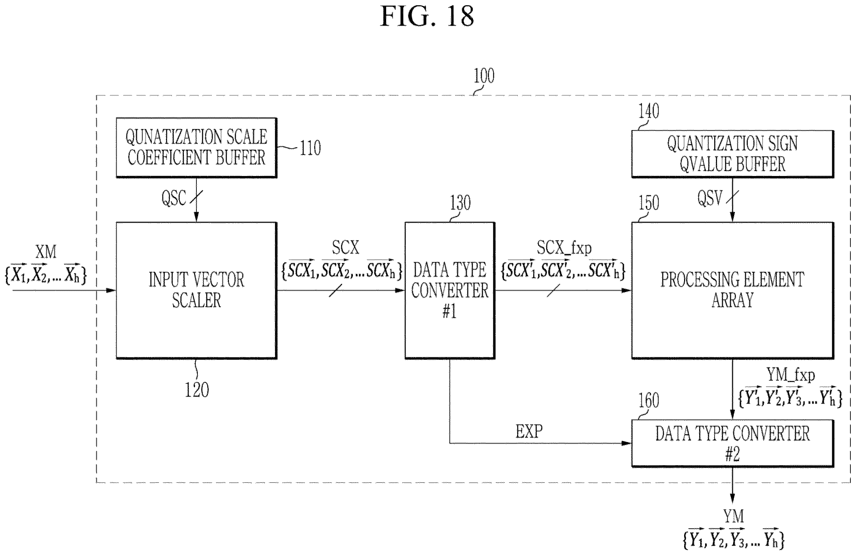

According to various example embodiments, one weight may be approximated with R-'quantization scale coefficient (QSC)-quantization sign value (QSV)' pairs. An operation of the matrix multiplier 100 based on the weight approximated by the plurality of quantization scale coefficients QSC and the plurality of quantization sign values QSV will be described in more detail with reference to FIGS. 18 to 33.

FIG. 18 is a block diagram showing the configuration of the matrix multiplier of FIG. 1 implemented according to some example embodiments. Referring to FIGS. 1, 3, and 15 to 18, the matrix multiplier 100 may include a quantization scale coefficient buffer 110, an input vector scaler 120, a first data type converter 130, a quantization sign value buffer 140, a processing element array 150, and a second data type converter 160.

The quantization scale coefficient buffer 110 may store the plurality of quantization scale coefficients QSC provided from the BCQ circuit 200. The quantization scale coefficient buffer 15 may provide the plurality of quantization scale coefficients QSC to the input vector scaler 120.

The input vector scaler 120 may receive the input matrix XM. For example, the input vector scaler 120 may receive the plurality of input vector (e.g., $\overrightarrow{X_1}$ to $\overrightarrow{X_h}$) including the plurality of input elements.

The input vector scaler 120 may scale the input matrix XM based on the plurality of quantization scale coefficients QSC. For example, the input vector scaler 120 may generate a plurality of scaled input vectors SCX based on the plurality of input vectors. In this case, the plurality of scaled input vectors SCX may correspond to the plurality of input vector (e.g., $\overrightarrow{X_1}$ to $\overrightarrow{X_h}$), respectively. Hereinafter, the scaled input vectors corresponding to $\overrightarrow{X_1}$ to $\overrightarrow{X_h}$, will be referred to as $\overrightarrow{SCX_1}$ to $\overrightarrow{SCX_h}$, respectively.

In some example embodiments, the plurality of scaled input vectors SCX may be included in the scaled input matrix. In this case, a row size of the scaled input matrix may be an integer multiple of a row size of the input matrix XM, and a column size of the scaled input matrix may be the same as a column size of the input matrix XM. However, example embodiments are not limited thereto.

Each of the plurality of scaled input vectors SCX may be implemented as a row vector having a dimension that is R times of dimension of corresponding input vector. For example, the first scaled input vector (e.g., $\overrightarrow{SCX_1}$) corresponding to the first input vector (e.g., $\overrightarrow{X_1}$) may include R x n scaled input elements as shown in Equation 20 below.

(Equation 20)

$$\overrightarrow{SCX_1} \ni (\alpha_{1\_r1} \times x_{11}), (\alpha_{2\_r1} \times x_{11}),..., (\alpha_{R\_r1} \times x_{11}),$$

$$(\alpha_{1\_r2} \times x_{12}), (\alpha_{2\_r2} \times x_{12}),...,(\alpha_{R\_r2} \times x_{12}),$$

$$...,$$

$$(\alpha_{1\_rn} \times x_{1n}), (\alpha_{2\_rn} \times x_{1n}),...,(\alpha_{R\_rn} \times x_{1n})$$

Referring to Equation 20, the plurality of scaled input elements included in the first scaled input vector may be generated by multiplying each of the plurality of input elements included in the first input vector by 'R' quantization scale coefficients QSC.

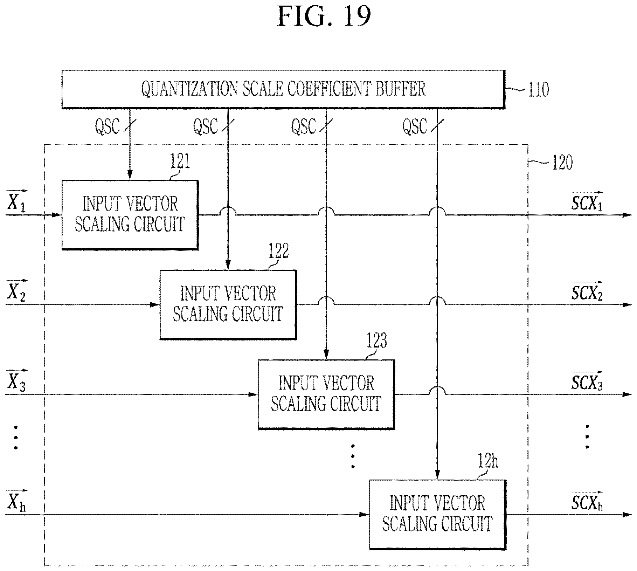

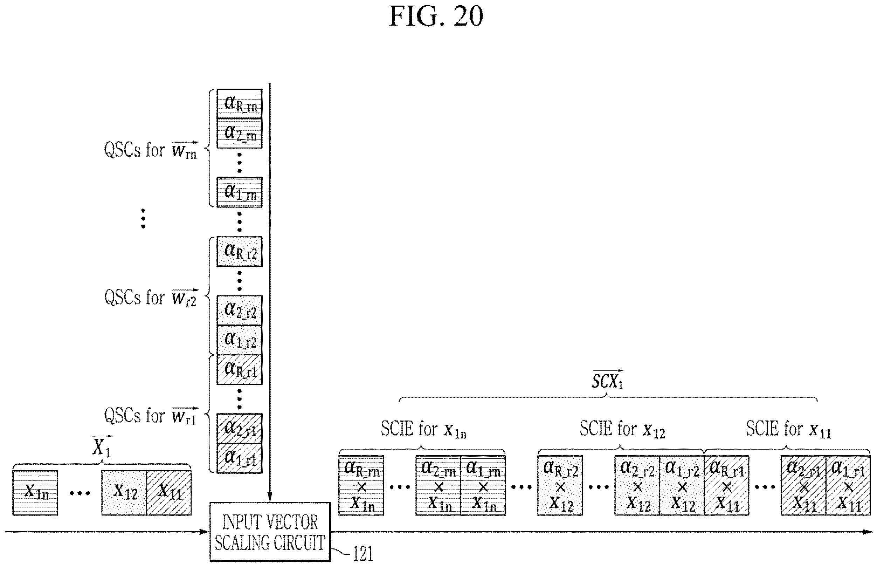

In this way, second to h-th scaled input vectors (e.g., $\overrightarrow{SCX_2}$ to $\overrightarrow{SCX_h}$) may include R × n scaled input elements. For a concise description, a detailed description of the input element included in each of the second to h-th scaled input vectors (e.g., $\overrightarrow{SCX_2}$ to $\overrightarrow{SCX_h}$) is omitted. Additionally, a configuration and an operation of the input vector scaler 120 will be described in more detail with reference to FIG. 19 and FIG. 20.

In some example embodiments, a data type of each of the plurality of input elements and a data type of each of plurality of quantization scale coefficients QSC may be floating-points. In this case, a data type of each scaled input element may be a floating-point. However, example embodiments are not limited thereto.

In some example embodiments, a code length of each of the plurality of input elements may be 16 bits or 32 bits. However, example embodiments are not limited thereto.

In some example embodiments, a code length of each of the plurality of quantization scale coefficients QSC may be 16 bits or 32 bits. However, example embodiments are not limited thereto.

The first data type converter 130 may receive the plurality of scaled input vectors SCX. For example, the first data type converter 130 may receive first to h-th scaled input vectors (e.g., $\overrightarrow{SCX_1}$ to $\overrightarrow{SCX_h}$). Each of the first to h-th scaled input vectors may include the plurality of scaled input elements.

The first data type converter 130 may extract an exponent EXP from each of the plurality of scaled input vectors SCX. For example, the first data type converter 130 may extract a first exponent from the first scaled input vector ($\overrightarrow{SCX_1}$), and may extract a second exponent from the second scaled input vector ($\overrightarrow{SCX_2}$). The first data type converter 130 may provide extracted exponents EXP to the second data type converter 160.

The first data type converter 130 may convert data types of the plurality of scaled input vectors SCX to a fixed-point. For example, the first data type converter 130 may receive the plurality of scaled input vectors SCX, and may output a plurality of fixed-point scaled input vectors SCX_fxp. For example, the first data type converter 130 may generate first to h-th fixed-point scaled input vectors (e.g., $\overrightarrow{SCX'_1}$ to $\overrightarrow{SCX'_h}$) based on the first to h-th scaled input vectors.

More specifically, the first data type converter 130 may convert a data type of each scaled input element included in the plurality of scaled input vectors SCX to a fixed-point based on the extracted exponent. In this case, the first fixed-point scaled input vector (e.g., $\overrightarrow{SCX'_1}$) may include elements of Equation 20 with fixed-point format. A configuration and an operation of the first data type converter 130 will be described in more detail with reference to FIGS. 19 to 21.

The quantization sign value buffer 140 may store the plurality of quantization sign values QSV provided from the BCQ circuit 200. The quantization sign value buffer 140 may provide the plurality of quantization sign values QSV to the processing element array 150.

The processing element array 150 may receive the plurality of quantization sign values QSV and the plurality of fixed-point scaled input vectors SCX_fxp. The processing element array 150 may generate a fixed-point output matrix YM_fxp based on a plurality of fixed-point scaled input elements (e.g., the fixed-point scaled input vectors SCX_fxp) and the plurality of quantization sign values QSV. The fixed-point output matrix YM_fxp may be expressed as Equation 21 below.

(Equation 21)

$$YM\_fxp = \begin{bmatrix} \overrightarrow{Y'_1} \\ \overrightarrow{Y'_2} \\ \vdots \\ \overrightarrow{Y'_h} \end{bmatrix} = \begin{bmatrix} y'_{11} & y'_{12} & \cdots & y'_{1m} \\ y'_{21} & y'_{22} & \cdots & y'_{2m} \\ \vdots & \vdots & \ddots & \vdots \\ y'_{h1} & y'_{h2} & \cdots & y'_{hm} \end{bmatrix}$$

Referring to Equation 21, YM_fxp may represent the fixed-point output matrix YM_fxp, and $\overrightarrow{Y'_1}$ to $\overrightarrow{Y'_h}$ may represent different output vectors having fixed-point data types. Each of $y'_{11}$ to $y'_{hm}$ may represent different output elements having fixed-point data types.

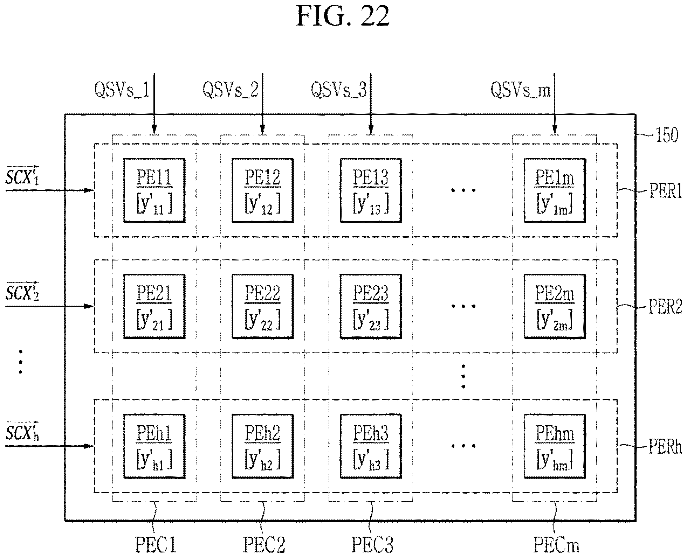

The processing element array 150 may include a plurality of processing elements disposed in a row direction and a column direction. Each of the plurality of processing elements may calculate and output different fixed-point output elements of Equation 21 described above. A more detailed configuration and operation of each processing element will be described in more detail with reference to FIGS. 22 to 25.

The second data type converter 160 may receive a plurality of exponents EXP from the first data type converter 130. The second data type converter 160 may receive the fixed-point output matrix YM_fxp from the processing element array 150. For example, the second data type converter 160 may receive a plurality of fixed-point output elements from the processing element array 150.

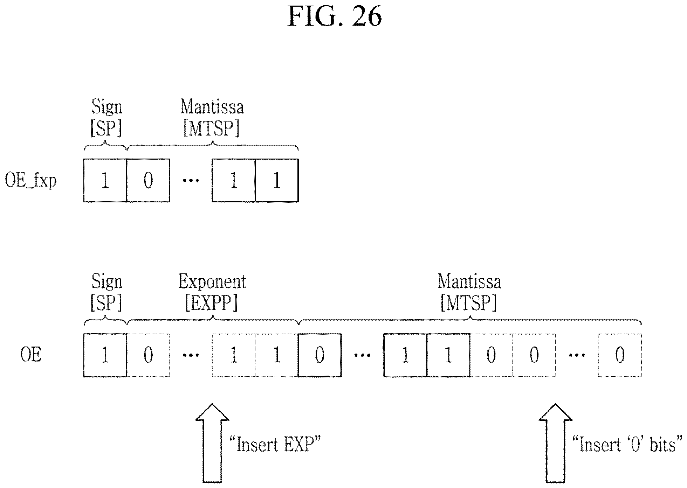

The second data type converter 160 may convert a data type of the fixed-point output matrix YM_fxp to a floating-point based on the plurality of exponents EXP. For example, the second data type converter 160 may output the output matrix YM with a floating-point data type. For example, the second data type converter 160 may generate a plurality of output elements by converting a data type of each of the received plurality of fixed-point output elements to a floating-point. A more detailed configuration and operation of the second data type converter 160 will be described in more detail with reference to FIG. 26.

FIG. 19 is a block diagram showing a configuration of the input vector scaler of FIG. 18. Referring to FIGS. 1, 3, and 15 to 19, the input vector scaler 120 may include first to h-th input vector scaling circuits 121 to 12h.

The first to h-th input vector scaling circuits 121 to 12h may receive different input vectors, respectively. For example, the first to h-th input vector scaling circuits 121 to 12h may receive first to h input vectors (e.g., $\overrightarrow{X_1}$ to $\overrightarrow{X_h}$), respectively.

Each of the first to h-th input vector scaling circuits 121 to 12h may sequentially receive the plurality of input elements. For example, the first input vector scaling circuit 121 may sequentially receive $X_{11}$ to $x_{1n}$, and the h-th input vector scaling circuit 12h may sequentially receive $x_{h1}$ to $x_{hn}$.

Each of the first to h-th input vector scaling circuits 121-12h may sequentially receive the plurality of quantization scale coefficients QSC from the quantization scale coefficient buffer 110.

The quantization scale coefficients QSC received by the first to h-th input vector scaling circuits 121-12h and provided from the quantization scale coefficient buffer 110 may be the same. For example, the quantization scale coefficients QSC sequentially received by the first input vector scaling circuit 121 may be the same as the quantization scale coefficients QSC sequentially received by the second input vector scaling circuit 122.

The orders in which each of the first to h-th input vector scaling circuits 121 to 12h receives the plurality of quantization scale coefficients QSC may be the same. For example, the quantization scale coefficient QSC firstly received by the first input vector scaling circuit 121 may be the same as the quantization scale coefficient QSC firstly received by the second input vector scaling circuit 122. Additionally or alternatively, the quantization scale coefficient QSC secondly received by the first input vector scaling circuit 121 may be the same as the quantization scale coefficient QSC secondly received by the second input vector scaling circuit 122.

The first to h-th input vector scaling circuits 121-12h may respectively generate the first to h-th scaled input vectors (e.g., $\overrightarrow{SCX_1}$ to $\overrightarrow{SCX_h}$) based on an order in which the input elements and the plurality of quantization scale coefficients QSC are received. For example, the first input vector scaling circuit 121 may generate $\overrightarrow{SCX_1}$.

FIG. 20 is a drawing showing an operation of the input vector scaling circuit of FIG. 19 in more detail. Below, for a more concise description, the operation of the first input vector scaling circuit 121 will be representatively described with reference to FIGS. 1, 3, and 15 to 20. However, the range of example embodiments is not limited thereto, and the second to h-th input vector scaling circuits 122-12h may operate in a manner similar to the operation of the first input vector scaling circuit 121.

The first input vector scaling circuit 121 may receive the first input vector (e.g., $\overrightarrow{X_1}$). For example, the first input vector scaling circuit 121 may sequentially receive $x_{11}$ to $x_{1n}$.

The first input vector scaling circuit 121 may sequentially receive the plurality of quantization scale coefficients QSC. For example, the first input vector scaling circuit 121 may receive the quantization scale coefficients (e.g., $\alpha_{1\_r1}$ to $\alpha_{R\_r1}$) corresponding to a first row vector (e.g., $\overrightarrow{w_{r1}}$) of the weight matrix WM, and then may receive the quantization scale coefficients (e.g., $\alpha_{1\_r2}$ to $\alpha_{R\_r2}$) corresponding to a second row vector (e.g., $\overrightarrow{w_{r2}}$) of the weight matrix WM. In this way, the first input vector scaling circuit 121 may sequentially receive all of the quantization scale coefficients QSC (e.g., $\alpha_{1\_r1}$ to $\alpha_{R\_rn}$) for calculating the scaled input element described above.

In some example embodiments, the second to h-th input vector scaling circuits 122-12h may sequentially receive the above-described $\alpha_{1\_r1}$ to $\alpha_{R\_rn}$.

In some example embodiments, the order in which each of the first to h-th input vector scaling circuits 122-12h receives the above-described $\alpha_{1\_r1}$ to $\alpha_{R\_rn}$ may be the same. However, example embodiments are not limited thereto.

The first input vector scaling circuit 121 may generate the first scaled input vector ($\overrightarrow{SCX_1}$) based on the order in which the input elements and the plurality of quantization scale coefficients QSC are received. For example, the first input vector scaling circuit 121 may sequentially multiply the received input element and the received plurality of quantization scale coefficients QSC to calculate a plurality of scaled input elements SCIE.

More specifically, the first input vector scaling circuit 121 may multiply $x_{11}$ by the quantization scale coefficients (e.g., $\alpha_{1\_r1}$ to $\alpha_{R\_r1}$) corresponding to the first row vector (e.g., $\overrightarrow{w_{r1}}$) respectively, to sequentially calculate the plurality of scaled input elements SCIE corresponding to $x_{11}$. (wherein the calculation is shown as a diagonal stripe.)

Thereafter, the first input vector scaling circuit 121 may multiply $x_{12}$ by the quantization scale coefficients (e.g., $\alpha_{1\_r2}$ to $\alpha_{R\_r2}$) corresponding to the second row vector (e.g., $\overrightarrow{w_{r2}}$) respectively, to sequentially calculate the plurality of scaled input elements SCIE corresponding to $x_{12}$ (wherein the calculation is shown as a dot pattern.)

In this way, the first input vector scaling circuit 121 may sequentially calculate the plurality of scaled input elements SCIE corresponding to $x_{13}$ to $x_{1n}$.

The first input vector scaling circuit 121 may sequentially output the calculated plurality of scaled input elements SCIE.

For example, according to various example embodiments, the first input vector scaling circuit 121 may generate the plurality of scaled input elements (e.g., SCIE for $x_{11}$ shown in the diagonal stripe) based on single input element (e.g., $x_{11}$). For example, the first input vector scaling circuit 121 may generate the plurality of scaled input elements by repeatedly using the single input element. Therefore, according to various example embodiments, an input reuse of the matrix multiplier 100 may be improved upon or maximized. so that the number of times the matrix multiplier 100 receives the input element from the outside is reduced or minimized. In this case, the number of times the matrix multiplier 100 accesses an external memory device that stores the input element may be reduced or minimized, so that an operating efficiency and an operating speed of the matrix multiplication device MMD are improved.

In some example embodiments, the BCQ circuit 200 may generate the plurality of quantization scale coefficients QSC and the plurality of quantization sign values QSV from the plurality of weights based on the uniform BCQ algorithm. In this case, a product of the quantization scale coefficient QSC and the input element shown in FIG. 20 may be performed with a smaller computation amount. For example, if a size ratio between the plurality of quantization scale coefficients is power of 2, mantissas of the plurality of quantization scale coefficients QSC may be the same, and exponents of the plurality of quantization scale coefficients QSC may be different by "1". In this case, the product of a single input element (e.g., $x_{11}$) and the different plurality of quantization scale coefficients (e.g., $\alpha_{1\_r1}$ to $\alpha_{R\_r1}$) may be performed more easily. However, example embodiments are not limited thereto.

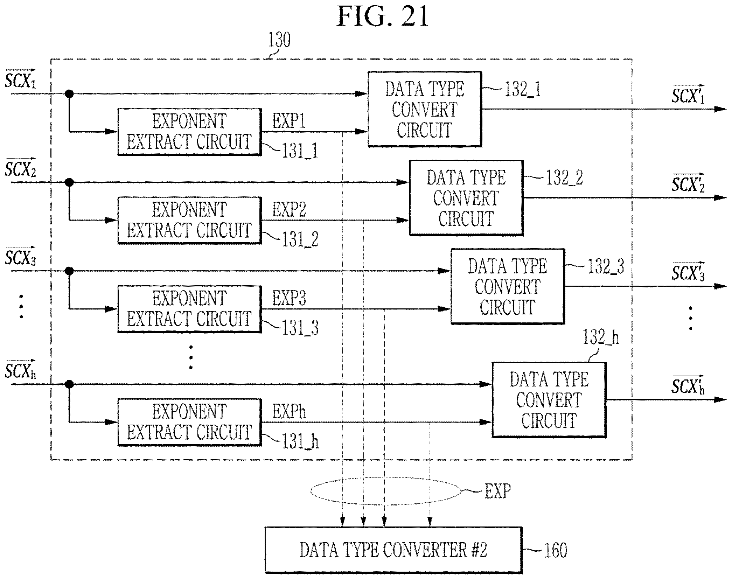

FIG. 21 is a block diagram showing a configuration of the first data type converter of FIG. 18. Referring to FIGS. 1, 3, 15 to 18, and 21, the first data type converter 130 may include first to h-th exponent extract circuits 131_1 to 131_h and first to h-th data type convert circuits 132_1 to 132_h.

The first to h-th exponent extract circuits 131_1 to 131_h may receive different scaled input vectors SCX, respectively. For example, the first to h-th exponent extract circuits 131_1 to 131_h may receive the first to h-th scaled input vectors (e.g., $\overrightarrow{SCX_1}$ to $\overrightarrow{SCX_h}$), respectively.

Each of the first to h-th exponent extract circuits 131_1 to 131_h may extract the exponent from the plurality of scaled input elements SCIE included in the received scaled input vector SCX. For example, the first exponent extract circuit 131_1 may sequentially receive the plurality of scaled input elements SCIE included in the first scaled input vector ($\overrightarrow{SCX_1}$). The first exponent extract circuit 131_1 may extract a first exponent EXP1 from the plurality of scaled input elements SCIE included in the received first scaled input vector ($\overrightarrow{SCX_1}$). The second exponent extract circuit 131_2 may sequentially receive the received plurality of scaled input elements SCIE. The second exponent extract circuit 131_2 may extract a second exponent EXP2 from the received plurality of scaled input elements SCIE. In this way, the first to h-th exponent extract circuits 131_1-131_h may extract the first to h-th exponents EXP1-EXPh, respectively.

The first to h-th exponent extract circuits 131_1 to 131_h may provide the extracted exponent to the first to h-th data type convert circuits 132_1 to 132_h, respectively. Additionally, each of the first to h-th exponent extract circuits 131_1 to 131_h may provide each of the extracted exponents to the second data type converter 160.

A detailed method of extracting the exponent from the received element by each of the first to h-th exponent extract circuits 131_1-131_h is similar to the operation of the exponent extract circuit described above with reference to FIG. 7 to FIG. 8, so that a detailed description thereof is omitted.

The first to h-th data type convert circuits 132_1 to 132_h may receive the first to h-th exponents EXP1-EXPh, respectively. The first to h-th data type convert circuits 132_1 to 132_h may receive the first to h-th scaled input vectors (e.g., $\overrightarrow{SCX_1}$ to $\overrightarrow{SCX_h}$), respectively.

Each of the first to h-th data type convert circuits 132_1 to 132_h may convert a data type of the received scaled input vector to a fixed-point based on the received exponent. For example, the first to h-th data type convert circuits 132_1 to 132_h may output the first to h-th fixed-point scaled input vectors (e.g., $\overrightarrow{SCX'_1}$ to $\overrightarrow{SCX'_h}$), respectively. For example, the first data type convert circuit 132_1 may convert each of the scaled input elements SCIE included in the first scaled input vector (e.g., $\overrightarrow{SCX_1}$) to a fixed-point format based on the first exponent EXP1.

A specific method of converting a data type of the received element to a fixed-point based on the received exponent by each of the first to h-th data type convert circuits 132_1 to 132_h is similar to the operation of the data type convert circuit described above with reference to FIG. 7 and FIG. 9, so that a detailed description thereof is omitted.

FIG. 22 is a block diagram showing a configuration of the processing element array of FIG. 18 in more detail. Referring to FIGS. 1, 3, and 15 to 22, the processing element array 150 may include the plurality of processing elements PE disposed in the row direction and the column direction. Hereinafter, for a more concise description, it is assumed that the plurality of processing elements PE are disposed in h-rows and m-columns. Additionally, the processing element disposed in an i-th row and a j-th column of the processing element array 150 will be referred to as "PEij". For example, the processing element disposed in a first row and a second column of the processing element array 150 will be referred to as "PE12".

The processing element array 150 may include first to h-th processing element rows PER1-PERh. Each of the first to h-th processing element rows PER1-PERh may include the plurality of processing elements PE. For example, the first processing element row PER1 may include processing elements PE11-PE1m.

The processing element array 150 may include first to m-th processing element columns PEC1-PECm. Each of the first to m-th processing element columns PEC1-PECm may include the plurality of processing elements PE. For example, the first processing element column PEC1 may include processing elements PE11-PEh1.

Different processing element rows may receive different fixed-point input vectors SCX_fxp. For example, the first to h-th processing element rows PER1-PERh may receive the first to h-th fixed-point scaled input vectors (e.g., $\overline{SCX'_1}$ to $\overline{SCX'_h}$), respectively.

Processing elements included in the same processing element row may receive the same fixed-point scaled input vector SCX_fxp. For example, each of processing elements PE11-PE1m may receive the first fixed-point scaled input vector (e.g., $\overline{SCX'_1}$).

Different processing element columns may receive different plurality of quantization sign values QSVs. For example, the first to m-th processing element columns PEC1-PECm may receive first to m-th plurality of quantization sign values QSVs_1-QSVs_m, respectively.

Processing elements disposed in the same processing element column may receive the same plurality of quantization sign values QSVs. For example, each of the processing elements PE11-PEh1 may receive the first plurality of quantization sign values QSVs_1, and each of the processing elements PE12-PEh2 may receive the second plurality of quantization sign values QSVs_2.

Each of the plurality of processing elements PE may calculate different fixed-point output elements based on the received fixed-point scaled input element SCIE and the received plurality of quantization sign values QSVs. For example, according to various example embodiments, one processing element PE may calculate one fixed-point output element. For example, the processing element (PEij) may calculate $y'_{ij}$. Hereinafter, the fixed-point output element calculated in each processing element PE will be described in more detail.

Each of the first to h-th processing element rows PER1-PERh may calculate different fixed-point output vectors. For example, the first to h-th processing element rows PER1-PERh may output first to h-th fixed-point output vectors (e.g., $\overline{Y'_1}$ to $\overline{Y'_h}$), respectively.

Processing elements disposed in the same processing element row and different processing element columns may calculate different fixed-point output elements. For example, the processing elements PE11-PE1m may calculate $y'_{11}$ to $y'_{1m}$, respectively. Similarly, the processing element PE21-PE2m may calculate $y'_{21}$ to $y'_{2m}$, respectively, and the processing element PEh1-PEhm may calculate $y'_{h1}$ to $y'_{hm}$, respectively.

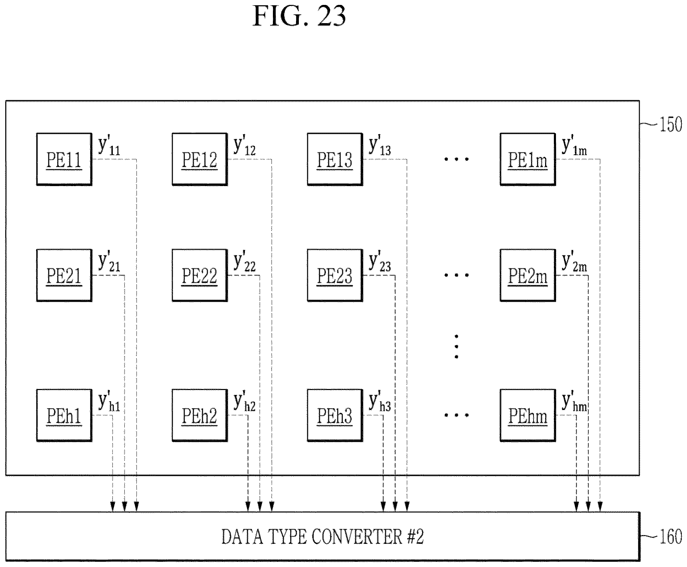

FIG. 23 is a block diagram showing outputs of the processing elements of FIG. 22 in more detail. Referring to FIGS. 1, 3, and 15 to 23, each of the plurality of processing elements PE may provide the calculated fixed-point output element to the second data type converter 160.

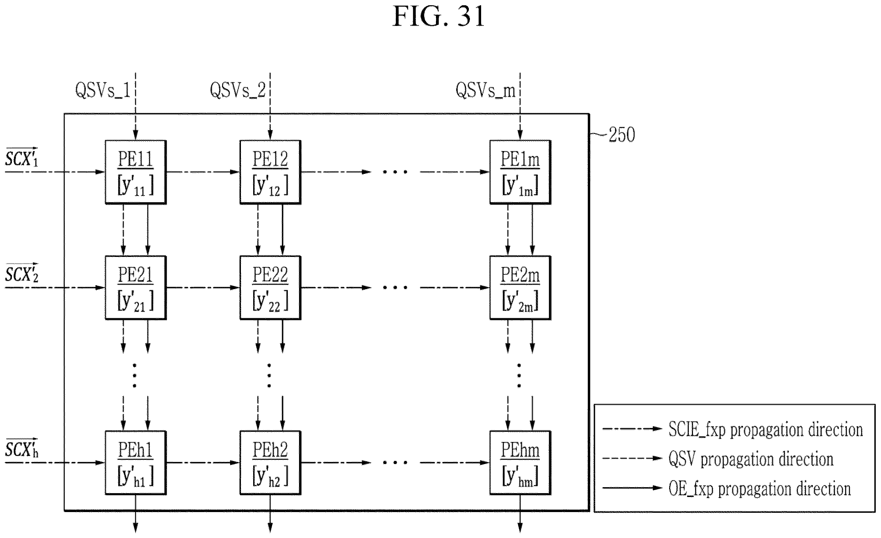

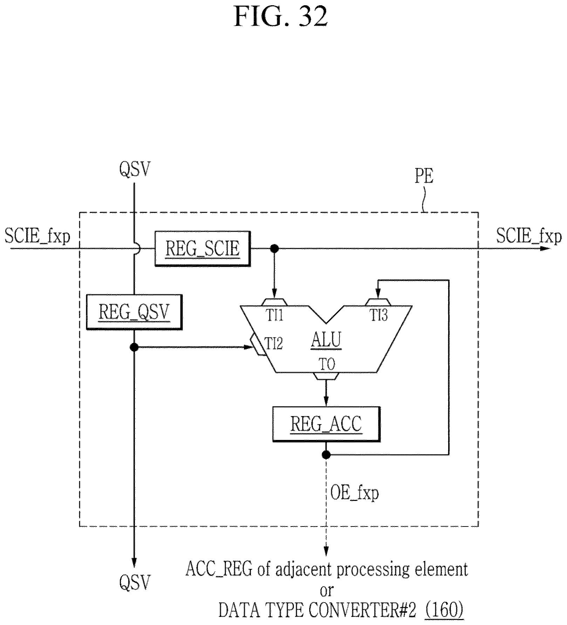

Below, for a more concise description, some example embodiments in which each of the plurality of processing elements PE directly provides the calculated fixed-point output element to the second data type converter 160 as shown in FIG. 23, will be representatively described. However, the range of example embodiments is not limited thereto, and each of the plurality of processing elements PE may transfer the calculated fixed-point output element to the second data type converter 160 in a systolic array method. Embodiments in which the plurality of processing elements PE are implemented in the systolic array method will be described in more detail with reference to FIG. 31 and FIG. 32.

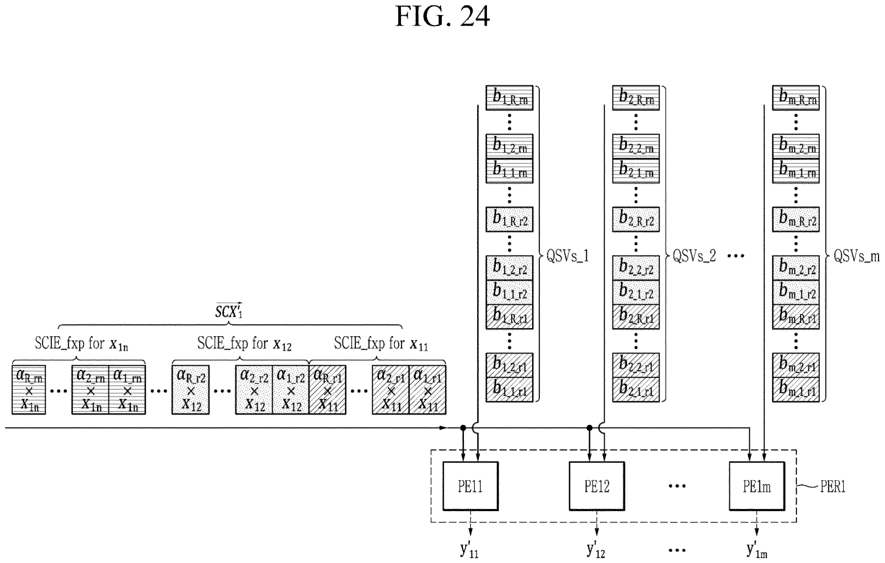

FIG. 24 is a block diagram showing an operation of the first processing element row of FIG. 22 in more detail. For example, hereinafter, the operation of the first processing element row PER1 will be representatively described with reference to FIGS. 1, 3, and 15 to 24. However, the range of example embodiments is not limited thereto, and the second to h-th processing element rows PER2-PERh may operate in a manner similar to the operation of the first processing element row PER1.

The first processing element row PER1 may receive the first fixed-point scaled input vector (e.g., $\overline{SCX'_1}$). For example, the first processing element row PER1 may sequentially receive a plurality of fixed-point scaled input elements (SCIE_fxp). For example, the first processing element row PER1 may sequentially receive the scaled input elements SCIE described above with reference to FIG. 20 in the form of a fixed-point.

The processing elements PE11-PE1m may receive the first plurality of quantization sign values QSVs_1 to the m-th plurality of quantization sign values QSVs_m, respectively. For example, the processing element PE11 may receive the first plurality of quantization sign values QSVs_1, and the processing element PE12 may receive the second plurality of quantization sign values QSVs_2.

The first plurality of quantization sign values QSVs_1 may include the quantization sign values QSV disposed in a first column of the first to R-th quantization sign matrices QSM_1-QSM_R described above with reference to FIG. 17. For example, the first plurality of quantization sign values QSVs_1 may include the quantization sign values disposed in the first column of each of the first to R-th quantization sign matrices QSM_1-QSM_R (e.g., $b_{1\_1\_r1}$ to $b_{1\_R\_rn}$).

More specifically, the processing element PE11 may sequentially receive the quantization sign values disposed in a first row and a first column of each of the first to R-th quantization sign matrices QSM_1-QSM_R (e.g., $b_{1\_1\_r1}$ to $b_{1\_R\_r1}$), and then may sequentially receive the quantization sign values disposed in a second row and a first column of each of the first to R-th quantization sign matrices QSM_1-QSM_R (e.g., $b_{1\_1\_r2}$ to $b_{1\_R\_r2}$). In this way, the processing element PE11 may sequentially receive the quantization sign values disposed in an n-th row and a first column of each of the first to R-th quantization sign matrices QSM_1-QSM_R (e.g., $b_{1\_1\_rn}$ to $b_{1\_R\_rn}$).

The processing element PE11 may calculate a fixed-point output element (e.g., $y'_{11}$) based on an order in which the quantization sign values QSV and the plurality of fixed-point scaled input elements SCIE_fxp are received. For example, the processing element PE11 may sequentially accumulate values obtained by respectively multiplying the plurality of fixed-point scaled input elements SCIE_fxp generated based on the input element "$x_{11}$" (e.g., the fixed-point scaled input elements shown as "SCIE_fxp for $x_{11}$" in FIG. 24), by the quantization sign values disposed in the first row and the first column of each of the first to R-th quantization sign matrices QSM_1-QSM_R (e.g., $b_{1\_1\_r1}$ to $b_{1\_R\_r1}$). In this way, the processing element PE11 may sequentially accumulate values obtained by multiplying fixed-point format $\alpha_{1\_r1} \times x_{11}$ by $b_{1\_1\_r1}$, to obtained by multiplying fixed-point format $\alpha_{R\_rn} \times x_{1n}$ by $b_{1\_R\_rn}$, to calculate and output the fixed-point output element ($y'_{11}$).

Similarly, the processing element PE1j may receive the j-th plurality of quantization sign values QSVs_j including the quantization sign values disposed in a j-th column of each of the each of the first to R-th quantization sign matrices QSM_1-QSM_R (e.g., $b_{j\_1\_r1}$ to $b_{j\_R\_rn}$). In this case, the processing element PE1j may multiply the plurality of fixed-point scaled input elements SCIE_fxp included in the first fixed-point scaled input vector (e.g., $\overrightarrow{SCX'_1}$) by the j-th plurality of quantization sign values QSVs_j, respectively, and may accumulate the multiplied values to calculate and output the fixed-point output element ($y'_{1j}$).

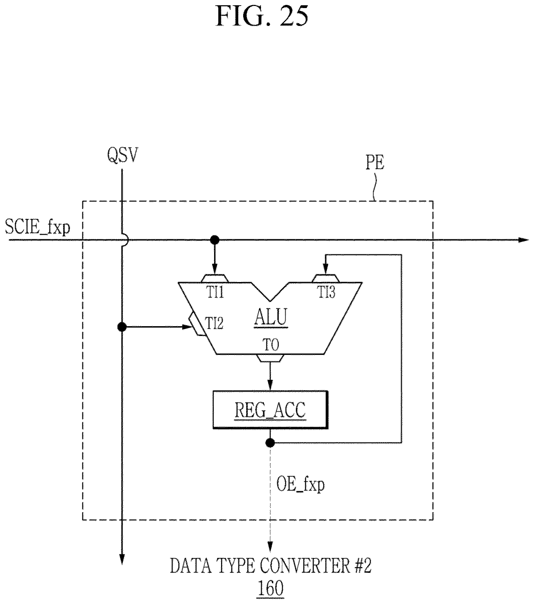

FIG. 25 is a drawing showing a configuration of the processing element of FIG. 24 according to some example embodiments. Referring to FIGS. 1, 3, and 15 to 25, the processing element PE may include an arithmetic logic unit ALU and an accumulation register REG_ACC.

The arithmetic logic unit ALU may include first to third input terminals TI1 - TI3 and an output terminal TO.

The arithmetic logic unit ALU may receive the fixed-point scaled input element SCIE_fxp through the first input terminal TI1. For example, the arithmetic logic unit ALU may sequentially receive the plurality of fixed-point scaled input elements SCIE_fxp through the first input terminal TI1.

In some example embodiments, each fixed-point scaled input element SCIE_fxp may have a code length of 8 bits, and the arithmetic logic unit ALU may be configured to receive data by the 8 bits through the first input terminal TI1.

The arithmetic logic unit ALU may receive the quantization sign value QSV through the second input terminal TI2. For example, the arithmetic logic unit ALU may sequentially receive the plurality of quantization sign values QSV through the second input terminal TI2.

In some example embodiments, the arithmetic logic unit ALU may receive each quantization sign value QSV in the form of a control signal indicating either logic low or logic high through the second input terminal TI2. For example, if the control signal provided to the second input terminal TI2 is logic high, the arithmetic logic unit ALU may determine that the quantization sign value QSV indicating "+1" is received. Conversely, if the control signal received through the second input terminal TI2 is logic low, the arithmetic logic unit ALU may determine that the quantization sign value QSV indicating "-1" is received. However, example embodiments are not limited thereto.

The third input terminal TI3 may be connected to the accumulation register REG_ACC. The arithmetic logic unit ALU may receive data stored in the accumulation register REG_ACC through the third input terminal TI3.

The arithmetic logic unit ALU may calculate a value obtained by adding a product of the quantization code value QSV received through the second input terminal TI2 and the fixed-point scaled input element SCIE_fxp received through the first input terminal TI1, to data received through the third input terminal TI3. The arithmetic logic unit ALU may update a value stored in the accumulation register REG_ACC by providing the calculated value to the accumulation register REG_ACC through the output terminal TO. For example, the arithmetic logic unit ALU may update a value calculated through Equation 22 below in the accumulation register REG_ACC.

(Equation 22)

$$ACC\_post = QSVin \times SCIE\_fxp\_in + ACC\_pre$$

The QSVin may refer to the quantization sign value QSV received by the arithmetic logic unit ALU through the second input terminal TI2, SCIE_fxp_in may refer to the fixed-point scaled input element SCIE_fxp received by the arithmetic logic unit ALU through the first input terminal TI1, ACC_pre may refer to an accumulated value received by the arithmetic logic unit ALU from the accumulation register REG_ACC through the third input terminal TI3, and ACC_post may refer to a value calculated by the arithmetic logic unit ALU and provided to the accumulation register REG_ACC.

For example, the arithmetic logic unit ALU may accumulate the plurality of fixed-point scaled input elements SCIE_fxp sequentially received through the first input terminal TI1 based on the plurality of quantization code values QSV sequentially received through the second input terminal TI2. In this way, the arithmetic logic unit ALU may calculate the fixed-point output element OE_fxp (e.g., $y'_{11}$) by accumulating the plurality of fixed-point scaled input elements SCIE_fxp in the accumulation register REG_ACC based on the plurality of quantization sign values QSV.

For example, the arithmetic logic unit ALU may store the fixed-point output element OE_fxp in the accumulation register REG_ACC. The accumulation register REG_ACC may provide the fixed-point output element OE_fxp to the second data type converter 160.

In some example embodiments, the fixed-point output element OE_fxp may have a code length of 8 bits or more. For example, the fixed-point output element OE_fxp may have a code length long enough to represent an accumulated size of the plurality of fixed-point scaled input elements SCIE_fxp.

In some example embodiments, the accumulation register REG_ACC may have a size of 8 bits or more. For example, the accumulation register REG_ACC may have a size large enough to store the fixed-point output element OE_fxp.

In some example embodiments, the fixed-point output element OE_fxp may have a code length of 10 bits to 12 bits. However, example embodiments are not limited thereto.

In some example embodiments, the accumulation register REG_ACC may have a size of 10 bits to 12 bits. However, example embodiments are not limited thereto.

In some example embodiments, the plurality of fixed-point scaled input elements SCIE_fxp received by the arithmetic logic unit ALU may correspond to the same exponent value. In this case, the arithmetic logic unit ALU may perform the calculation of Equation 22 described above even without considering a place value of each of the plurality of fixed-point scaled input elements SCIE_fxp. Therefore, the arithmetic logic unit ALU may calculate the fixed-point output element OE_fxp with a reduced or minimum amount of calculation.

FIG. 26 is a drawing showing an operation of the second data type converter of FIG. 18. Below, for a more concise description, the operation of the second data type converter 160 for one fixed-point output element OE_fxp will be representatively described. However, example embodiments are not limited thereto. For example, the operation of the second data type converter 160 for any fixed-point output element OE_fxp may be similar to the operation of the second data type converter 160 for the one fixed-point output element OE_fxp.

Referring to FIGS. 1, 3, and 15 to 26, the second data type converter 160 may receive the fixed-point output element OE_fxp. For example, the second data type converter 160 may receive one of $y'_{11}$ to $y'_{hn}$.

The second data type converter 160 may receive the first to h-th exponents EXP1-EXPh from the first data type converter 130. In this case, the first to h-th exponents EXP1-EXPh may correspond to first fixed-point output vector (e.g., $\overrightarrow{Y'_1}$) to h-th fixed-point output vector (e.g., $\overrightarrow{Y'_h}$), respectively.

The fixed-point output element OE_fxp may include a sign part SP and a mantissa part MTSP. The second data type converter 14 may generate an output element OE by converting a data type of the fixed-point output element OE_fxp to a floating-point. Hereinafter, a specific method by which the second data type converter 160 converts the data type of the fixed-point output element OE_fxp is described.

The second data type converter 160 may add an exponent part EXPP to the fixed-point output element OE_fxp. For example, the second data type converter 160 may determine the exponent corresponding to the fixed-point output element OE_fxp among the exponents received from the first data type converter 130 as the exponent part EXPP of the output element OE. For a more detailed example, if the fixed-point output element OE_fxp is included in the first fixed-point output vector (e.g., $\overrightarrow{Y'_1}$) (for example, if the fixed-point output element OE_fxp is one of $y'_{11}$ to $y'_{1n}$), the exponent part EXPP of the output element OE may be determined as the first exponent EXP1. Similarly, if the fixed-point output element OE_fxp is included in a second fixed-point output vector ($\overrightarrow{Y'_2}$), the exponent part EXPP of the output element OE may be determined as the second exponent EXP2.

The second data type converter 160 may add a plurality of '0' bits to an LSB place of a mantissa part of the output element OE, according to a difference in code lengths of the mantissa part of the fixed-point output element OE_fxp and the mantissa part of the output element OE. However, example embodiments are not limited thereto.

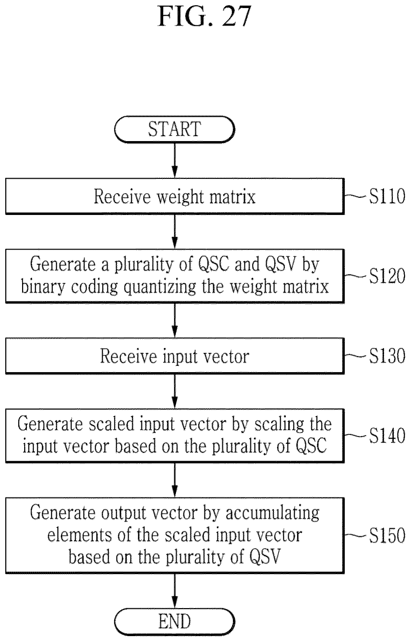

FIG. 27 is a flowchart showing an operation of the matrix multiplication device of FIG. 1. Below, the operation of the matrix multiplication device MMD that receives one input vector (e.g., $\overrightarrow{X_1}$) and outputs one output vector (e.g., $\overrightarrow{Y_1}$) will be described with reference to FIGS. 1, 3, and 15 to 27.

In a step S110, the matrix multiplication device MMD may receive the weight matrix WM. For example, the BCQ circuit 200 may receive the plurality of weights (e.g., $w_{11}$ to $w_{nm}$) included in the weight matrix WM.

In a step S120, the matrix multiplication device MMD may generate the plurality of quantization scale coefficients QSC and the plurality of quantization code values QSV by performing binary coding quantization on the weight matrix WM. For example, the BCQ circuit 200 may convert each of the plurality of weights to two or more 'quantization scale coefficient (QSC)-quantization sign value (QSV)' pairs. The BCQ circuit 200 may provide the generated plurality of quantization scale coefficients QSC and plurality of quantization sign values QSV to the matrix multiplier 100. In this case, the plurality of quantization scale coefficients QSC may be stored in the quantization scale coefficient buffer 110, and the plurality of quantization sign values QSV may be stored in the quantization sign value buffer 140. However, example embodiments are not limited thereto.

In a step S130, the matrix multiplication device MMD may receive the input vector (e.g., $\overrightarrow{X_1}$). For example, the matrix multiplier 100 may receive the plurality of input elements (e.g., $x_{11}$ to $x_{1n}$) included in the input vector.

In some example embodiments, the matrix multiplication device MMD may perform the step S130 regardless of an order of the steps S110 and S120. For example, the matrix multiplication vice MMD may perform the step S130 before the steps S110 and S120, or may perform the step S130 between the steps S110 and S120.

In a step S140, the matrix multiplication device MMD may generate scaled input vector SCX by scaling the input vector based on the plurality of quantization scale coefficients QSC. For example, the input vector scaler 120 may scale each of the plurality of input elements based on the plurality of quantization scale coefficients QSC provided from the quantization scale coefficient buffer 110.

In a step S150, the matrix multiplication device MMD may generate the output vector (e.g., $\overrightarrow{Y_1}$) by accumulating elements of the scaled input vector SCX based on the plurality of quantization sign values QSV. For example, the matrix multiplier 100 may generate one output element (e.g., $y_{11}$) by accumulating the elements of the scaled input vector SCX based on the first plurality of quantization sign values QSVs_1. The matrix multiplier 100 may generate another output element (e.g., $y_{12}$) by accumulating the elements of the scaled input vector SCX based on the second plurality of quantization sign values QSVs_2. In this way, the matrix multiplier 100 may generate the plurality of output elements included in the output vector.

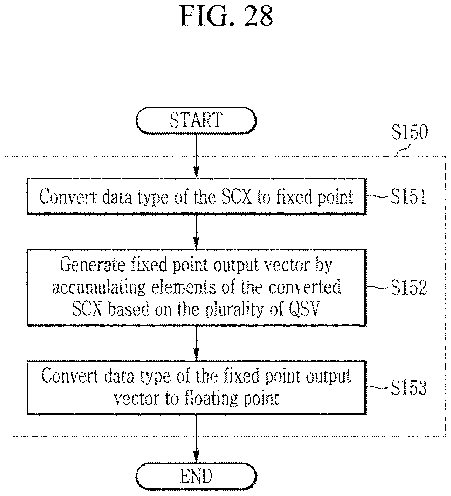

FIG. 28 is a flowchart showing the step S150 of FIG. 27 in more detail. Referring to FIGS. 1, 3, and 15 to 28, the step S150 may include steps S151 to S153.

In the step S151, the matrix multiplier 100 may convert a data type of the scaled input vector SCX to a fixed-point. For example, the matrix multiplier 100 may generate the fixed-point scaled input vector SCX_fxp based on the scaled input vector SCX. For example, the first data type converter 130 may convert the data type of each of the plurality of scaled input elements SCIE to the fixed-point to generate the plurality of fixed-point scaled input elements SCIE_fxp.

In the step S152, the matrix multiplier 100 may generate the fixed-point output vector (e.g., $\overrightarrow{Y'_1}$) by accumulating the elements of the scaled input vector SCX (e.g., the fixed-point scaled input vector SCX_fxp), which is converted into a fixed-point data type, based on the plurality of quantization sign values QSV. For example, the processing element array 150 may generate the fixed-point output vector by accumulating the plurality of fixed-point scaled input elements SCIE_fxp based on the plurality of quantization sign values QSV. More specifically, the processing element array 150 may generate one fixed-point output element (e.g., $y'_{11}$) by accumulating the plurality of fixed-point scaled input elements SCIE_fxp based on the first plurality of quantization sign values QSVs_1. Similarly, the processing element array 150 may generate one fixed-point output element (e.g., $y'_{12}$) by accumulating the plurality of fixed-point scaled input elements SCIE_fxp based on the second plurality of quantization sign values QSVs_2. In this way, the processing element array 150 may calculate the plurality of fixed-point output elements OE_fxp included in the fixed-point output vector (e.g., $\overrightarrow{Y'_1}$).

In the step S153, the matrix multiplier 100 may convert a data type of the fixed-point output vector (e.g., $\overrightarrow{Y'_1}$) to a floating-point. For example, the second data type converter 160 may receive the plurality of fixed-point output elements OE_fxp included in the fixed-point output vector. The second data type converter 160 may convert the plurality of fixed-point output elements OE_fxp to the plurality of output elements OE, respectively.

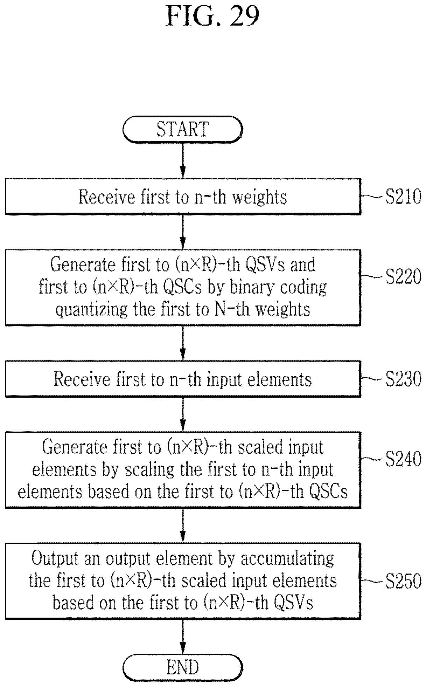

FIG. 29 is a flowchart showing an operation of the matrix multiplication device of FIG. 1. Below, the operation of the matrix multiplication device MMD that receives one input vector (e.g., $\overrightarrow{X_1}$) to generates one output element (e.g., $y_{11}$) will be described with reference to FIGS. 1, 3, 15 to 26, and 29.

In a step S210, the matrix multiplication device MMD may receive first to n-th weights. For example, the BCQ circuit 200 may receive weights (e.g., $w_{11}$ to $w_{n1}$) corresponding to one column of the weight matrix WM.

In a step S220, the matrix multiplication device MMD may generate first to (n×R)-th quantization scale coefficients QSC and first to (nxR)-th quantization sign values QSV by binary coding quantizing the first to n-th weights. For example, the BCQ circuit 200 may generate R quantization scale coefficients QSC and R quantization sign values QSV per weight.

In a step S230, the matrix multiplication device MMD may receive first to n-th input elements. For example, the matrix multiplier 100 may receive the plurality of input elements (e.g., $x_{11}$ to $x_{1n}$) included in one input vector.

In some example embodiments, the matrix multiplication device MMD may perform the step S230 regardless of an order of the steps S210 and S220. For example, the matrix multiplication device MMD may perform the step S230 before the steps S210 and S220, or may perform the step S230 between the steps S210 and S220.

In a step S240, the matrix multiplication device MMD may generate first to $(n\times R)$-th scaled input elements SCIE by scaling the first to n-th input elements based on first to $(n\times R)$-th quantization scale coefficients QSC. For example, the input vector scaler 120 may generate R scaled input elements SCIE per single input element based on the R quantization scale coefficients QSC.

In a step S250, the matrix multiplication device MMD may generate one output element (e.g., $y_{11}$) by accumulating the first to $(n\times R)$-th scaled input elements SCIE based on the first to $(n\times R)$-th quantization sign values QSV. For example, the matrix multiplier 100 may generate the one output element (e.g., $y_{11}$) by accumulating products of the first to (nxR)-th scaled input elements SCIE and the first to (nxR)-th quantization sign values QSV (e.g., $b_{1\_1\_r1}$ to $b_{1\_R\_rn}$).

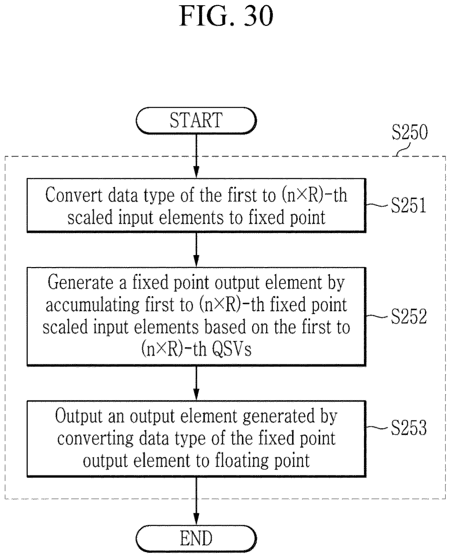

FIG. 30 is a flowchart showing the step S250 of FIG. 29 in more detail. Referring to FIGS. 1, 3, 15 to 26, and 29 to 30, the step S250 may include steps S251 to S253.

In the step S251, the matrix multiplier 100 may convert a data type of each of the first to $(n\times R)$-th scaled input elements SCIE to a fixed-point. For example, the first data type converter 130 may convert the first to $(n\times R)$-th scaled input elements SCIE to first to $(n\times R)$-th fixed-point scaled input elements SCIE_fxp, respectively.

In the step S252, the matrix multiplier 100 may generate the fixed-point output element OE_fxp by accumulating the first to $(n\times R)$-th fixed-point scaled input elements SCIE_fxp based on the first to $(n\times R)$-th quantization sign values QSV. For example, one processing element PE may sequentially receive the first to $(n\times R)$-th quantization sign values QSV, and may sequentially receive the first to $(n\times R)$-th fixed-point scaled input elements SCIE_fxp. The processing element PE may generate one fixed-point output element OE_fxp (e.g., $y'_{11}$) by accumulating products of the first to $(n\times R)$-th quantization sign values QSV and the first to $(n\times R)$-th fixed-point scaled input elements SCIE_fxp.

In the step S253, the matrix multiplier 100 may convert a data type of the fixed-point output element OE_fxp to a floating-point. For example, the second data type converter 160 may receive the fixed-point output element OE_fxp (e.g., $y'_{11}$), and may output the output element OE (e.g., $y_{11}$).

FIG. 31 is a block diagram showing the processing element array of FIG. 22 implemented in the systolic array method. Referring to FIGS. 1, 3, 15 to 22, and 31, the processing element array 150 may be implemented as a processing element array 250 of FIG. 31.

The processing element array 250 may include a plurality of processing elements PE disposed in a row direction and a column direction. The plurality of processing elements PE may operate in the systolic array scheme.

The processing element array 250 may be implemented to sequentially propagate the plurality of fixed-point scaled input elements SCIE_fxp in the row direction. For example, the first processing element row PER1 may sequentially propagate the plurality of fixed-point scaled input elements SCIE_fxp included in the first fixed-point scaled input vector (e.g., $\overrightarrow{SCX'_1}$) in the row direction.

For a more detailed example, the processing element PE11 may receive one fixed-point scaled input element SCIE_fxp at a first time point. The processing element PE11 may transfer the fixed-point scaled input element SCIE_fxp to the processing element PE12 disposed adjacent to the processing element PE11 in the row direction at a second time point after the first time point. In this way, the processing elements PE included in the first processing element row PER1 may sequentially transfer the plurality of fixed-point scaled input elements SCIE_fxp provided from the first data type converter 130 to adjacent processing element.

The processing element array 250 may be implemented to sequentially propagate the plurality of quantization sign values QSV in the column direction. For example, the first processing element column PEC1 may sequentially propagate the first plurality of quantization sign values QSVs_1 in the column direction.

For a more detailed example, the processing element PE11 may receive one quantization sign value QSV at a first time point. The processing element PE11 may transfer the quantization sign value QSV to the processing element PE21 disposed adjacent to the processing element PE11 in the column direction at a second time point after the first time point. In this way, the processing elements PE included in the first processing element column PEC1 may sequentially transfer the first plurality of quantization sign values QSVs_1 provided from the quantization sign value buffer 140 to adjacent processing element.

Each of the plurality of processing elements PE may generate different fixed-point output elements OE_fxp in a method similar to the method described above with reference to FIGS. 18 to 24. For a more concise description, a detailed description of a method in which each of the plurality of processing elements PE generates the fixed-point output element OE_fxp is omitted.

The processing element array 250 may be implemented to sequentially propagate the fixed-point output element OE_fxp in the column direction. For example, the fixed-point output element OE_fxp (e.g., $y'_{11}$) calculated from the processing element PE11 may be sequentially propagated in the column direction. In this way, the fixed-point output element OE_fxp may be transferred to the second data type converter 160. Because a method in which the fixed-point output element OE_fxp is propagated is similar to the method in which the quantization sign value QSV is propagated, a detailed description thereof will be omitted

For example, each of the processing elements included in the processing element array 250 may be implemented to receive one or more of the fixed-point output element OE_fxp, the quantization sign value QSV, and the fixed-point scaled input element SCIE_fxp from adjacent processing elements. Conversely, each of the processing elements included in the processing element array 250 may be implemented to transfer one or more of the fixed-point output element OE_fxp, the quantization sign value QSV, and the fixed-point scaled input element SCIE_fxp to adjacent processing elements. A more detailed configuration of the processing element PE operating in the systolic array method will be described in more detail with reference to FIG. 32.

For a more concise description, the embodiment in which each of the fixed-point output element OE_fxp, the quantization sign value QSV, and the fixed-point scaled input element SCIE_fxp propagates in the systolic array method is representatively illustrated in FIG. 31, but the range of example embodiments is not limited thereto. For example, the processing element array 250 may be implemented to propagate only one or two of the fixed-point output element OE_fxp, the quantization sign value QSV, and the fixed-point scaled input element SCIE_fxp propagates in the systolic array method.

In some example embodiments, each of the processing elements included in the processing element array 250 may operate in response to the same control clock signal. In this case, each of the plurality of processing elements may transfer the fixed-point output element OE_fxp, the quantization sign value QSV, and/or the fixed-point scaled input element SCIE_fxp to another processing element at the same time point. However, example embodiments are not limited thereto.

FIG. 32 is a drawing showing a configuration of the processing element of FIG. 31 in more detail. Referring to FIGS. 1, 3, 15 to 22, and 31 to 32, the processing element PE may include the arithmetic logic unit ALU, the accumulation register REG_ACC, a scaled input element register REG_SCIE, and a quantization sign value register REG_QSV. For a more concise description, a detailed description of a configuration and an operation of the arithmetic logic unit ALU and the accumulation register REG_ACC described above with reference to FIG. 25 is omitted.

Below, some example embodiments in which the arithmetic logic unit ALU, the accumulation register REG_ACC, the scaled input element register REG_SCIE, and the quantization sign value register REG_QSV operate in response to the same control clock signal is representatively described. However, example embodiments are not limited thereto.

The scaled input element register REG_SCIE may sequentially receive the plurality of fixed-point scaled input elements SCIE_fxp. The scaled input element register REG_SCIE may receive one fixed-point scaled input element SCIE_fxp, and may transfer the received fixed-point scaled input element SCIE_fxp to the processing element PE adjacent to the scaled input element register REG_SCIE and the first input terminal TI1 after one cycle of the control clock signal elapses.

The quantization sign value register REG_QSV may sequentially receive the plurality of quantization sign values QSV. The quantization sign value register REG_QSV may receive one quantization sign value QSV, and may transfer the received quantization sign value QSV to adjacent processing element and the second input terminal TI2 after one cycle of the control clock signal elapses.

The accumulation register REG_ACC may store the fixed-point output element OE_fxp provided from the arithmetic logic unit ALU. For example, the accumulation register REG_ACC may store the fixed-point output element OE_fxp calculated by the arithmetic logic unit ALU in a manner similar to that described above with reference to FIG. 25.

The accumulation register REG_ACC may transfer the fixed-point output element OE_fxp to adjacent processing element and/or the second data type converter 160. For example, the accumulation register REG_ACC may transfer the fixed-point output element OE_fxp to an accumulation register of the adjacent processing element. More specifically, the fixed-point output element OE_fxp (e.g., $y'_{h1}$) calculated by the processing element PE11 may be transferred to the second data type converter 160 through the processing elements PE21-PEh1 sequentially. However, example embodiments are not limited thereto.

For a more concise description, the embodiment in which each of the registers included in the processing element PE receives and outputs data each period of the control clock signal is described FIG. 32, but example embodiments are limited to a specific operation method of the register in response to the control clock signal.

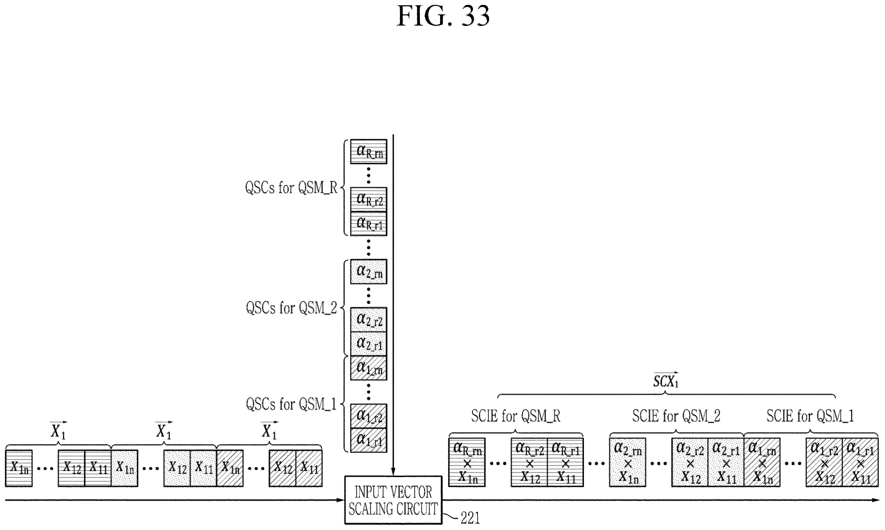

FIG. 33 is a drawing showing an operation of the input vector scaling circuit of FIG. 19 according to some example embodiments. Referring to FIGS. 1, 3, 15 to 19, and 33, the first input vector scaling circuit 121 may be implemented as a first input vector scaling circuit 221. However, the range of example embodiments is not limited thereto, and the second to h-th input vector scaling circuits 122-12h may operate in a manner similar to an operation of the first input vector scaling circuit 221. Below, a difference between the first input vector scaling circuit 121 and the first input vector scaling circuit 221 will be mainly described.

The first input vector scaling circuit 221 may repeatedly receive the first input vector (e.g., $\overrightarrow{X_1}$). For example, the first input vector scaling circuit 221 may repeatedly receive $x_{11}$ to $x_{1n}$.

The first input vector scaling circuit 221 may sequentially receive the plurality of quantization scale coefficients QSC. For example, the first input vector scaling circuit 221 may receive the quantization scale coefficients corresponding to the first quantization sign matrix QSM_1 (e.g., $\alpha_{1\_r1}$ to $\alpha_{1\_rn}$), and then may receive the quantization scale coefficients corresponding to a second quantization sign matrix QSM_2 (e.g., $\alpha_{2\_r1}$ to $\alpha_{2\_rn}$). In this way, the first input vector scaling circuit 221 may sequentially receive all of the quantization scale coefficients QSC for calculating the scaled input element SCIE described above.

The first input vector scaling circuit 221 may generate the first scaled input vector ($\overrightarrow{SCX1}$) based on the order in which the input elements and the plurality of quantization scale coefficients QSC are received. For example, the first input vector scaling circuit 221 may sequentially calculate the plurality of scaled input elements SCIE by sequentially multiplying the received input elements and the received plurality of quantization scale coefficients QSC. Because the sequential operation of the first input vector scaling circuit 221 is similar to the operation of the first input vector scaling circuit 221 described with reference to FIG. 20, a detailed description thereof will be omitted.

In some example embodiments, if the input vector scaler 120 is implemented based on the first input vector scaling circuit 221 described above, the processing element array 150 may receive the quantization sign values QSV in a different order than that described above with reference to FIG. 24. For example, the first processing element column PEC1 may receive the first plurality of quantization sign values QSVs_1 in an order different from that previously described with reference to FIG. 24. For a more detailed example, the processing element PE11 may sequentially receive the quantization sign values disposed in a first column of the first quantization sign matrix QSM_1 (e.g., $b_{1\_1\_r1}$ to $b_{1\_1\_rn}$), and then may sequentially receive the quantization sign values disposed in a first column of the second quantization sign matrix QSM_2 (e.g., $b_{1\_2\_r1}$ to $b_{1\_2\_rn}$). For example, the order in which the processing element array 150 receives the quantization sign values QSV may be determined according to the order in which the input vector scaler 120 receives the quantization scale coefficients QSC.

FIG. 34 is a drawing showing an operation of the matrix multiplication device of FIG. 1 according to some example embodiments. Referring to FIGS. 1 to 3 and 15 to 34, the matrix multiplication device MMD may receive a full input matrix FXM. The full input matrix FXM may include the input matrix XM described with reference to FIGS. 1 to 34. For example, the full input matrix FXM may include a plurality of input matrices XM.

The matrix multiplication device MMD may receive a full weight matrix FWM. The full weight matrix FWM may include the weight matrix WM described with reference to FIGS. 1 to 34. For example, the full weight matrix FWM may include a plurality of weight matrices WM.

The BCQ circuit 200 may perform a binary coding quantization operation on each of the plurality of weight matrices WM included in the full weight matrix FWM. For example, the BCQ circuit 200 may generate the plurality of quantization sign values QSV and the plurality of quantization scale coefficients QSC from each of the plurality of weight matrices WM.

The matrix multiplier 100 may receive the plurality of quantization sign values QSV and the plurality of quantization scale coefficients QSC. The matrix multiplier 100 may perform matrix multiplication for the full input matrix FXM and the full weight matrix FWM based on the plurality of quantization sign values QSV and the plurality of quantization scale coefficients QSC.

The matrix multiplier 100 may perform matrix multiplication for the full input matrix FXM and the full weight matrix FWM through one of various tiling techniques. For example, the matrix multiplier 100 may calculate a full output matrix FYM by sequentially calculating a product of the plurality of input matrices XM and the plurality of weight matrices WM and then combining the calculated results.

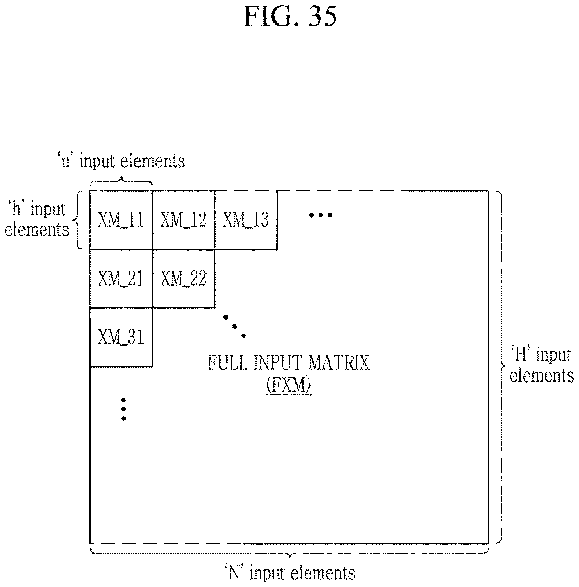

FIG. 35 is a drawing showing the full input matrix of FIG. 34. Referring to FIGS. 1 to 3 and 15 to 35, the full input matrix FXM may include the plurality of input matrices XM. For example, the full input matrix FXM may be tiled with the plurality of input matrices XM disposed in a row direction and a column direction. Hereinafter, for a more concise description, the input matrix disposed in an i-th row and a j-th column of the full input matrix FXM will be referred to as "XM_ij".

In some example embodiments, the input matrix XM described above with reference to FIGS. 1 to 3 and 15 to 33 may be one of the plurality of input matrices XM included in the full input matrix FXM.

In some example embodiments, the plurality of input matrices XM included in the full input matrix FXM may have the same row size and column size. For example, each of the plurality of input matrices XM may include n input elements for each row. Each of the plurality of input matrices XM may include h input elements for each column.

A row size of the full input matrix FXM may be an integer multiple of a row size of each of the plurality of input matrices XM. For example, one row of the full input matrix FXM may include N input elements. In this case, "N" may be an integer multiple of "n".

A column size of the full input matrix FXM may be an integer multiple of a column size of each of the plurality of input matrices XM. For example, one column of the full input matrix FXM may include H input elements. In this case, "H" may be an integer multiple of "h".

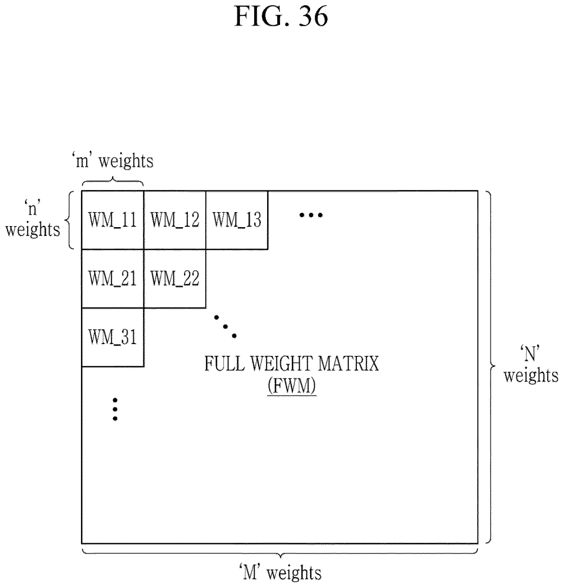

FIG. 36 is a drawing showing the full weight matrix of FIG. 34. Referring to FIGS. 1 to 3 and 15 to 36, the full weight matrix FWM may include the plurality of weight matrices WM. For example, the full weight matrix FWM may be tiled with the plurality of weight matrices WM disposed in a row direction and a column direction. Hereinafter, for a more concise description, the weight matrix disposed in an i-th row and a j-th column of the full weight matrix FWM will be referred to as "WM_ij".

In some example embodiments, the weight matrix WM described above with reference to FIGS. 1 to 3 and 15 to 33 may be one of the plurality of weight matrices WM included in the full input matrix FXM.

In some example embodiments, each of the plurality of weight matrices WM included in the full weight matrix FWM may have the same row size and column size. For example, each of the plurality of weight matrices WM may include m weights each row. Each of the plurality of weight matrices WM may include n weights each column.

A row size of the full weight matrix FWM may be an integer multiple of a row size of each of the plurality of weight matrices WM. For example, one row of the full weight matrix FWM may include M weights. In this case, "M" may be an integer multiple of "m".

A column size of the full weight matrix FWM may be an integer multiple of a column size of each of the plurality of weight matrices WM. For example, one column of the full weight matrix FWM may include N weights. In this case, "N" may be an integer multiple of "n".

The BCQ circuit 200 may perform a binary coding quantization operation on each of the plurality of weight matrices WM included in the full weight matrix FWM. In this case, the quantization scale coefficient generated based on the weight matrix WM_11 may be different from the quantization scale coefficient generated based on the weight matrix WM_12. Likewise, the quantization sign value generated based on the weight matrix WM_11 may be different from the quantization sign value generated based on the weight matrix WM_12. The specific method in which the BCQ circuit 200 performs the binary coding quantization operation for each weight matrix WM is similar to that described above with reference to FIGS. 15 to 17, so that a detailed description thereof is omitted.

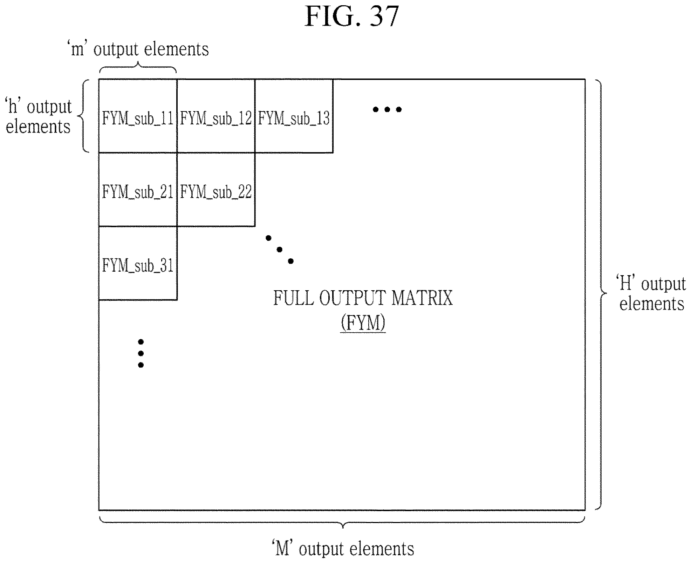

FIG. 37 is a drawing showing the full output matrix of FIG. 34. Referring to FIGS. 1 to 3 and 15 to 37, the full output matrix FYM may correspond to a product of the full input matrix FXM and the full weight matrix FWM.

The full output matrix FYM may include a plurality of sub-matrices FYM_sub disposed in a row direction and a column direction. Hereinafter, for a more concise description, the sub-matrix disposed in an i-th row and a j-th column of the full output matrix FYM will be referred to as "FYM_sub_ij".

Each of the plurality of sub-matrices FYM_sub may have the same row size and column size. A row size of each of the plurality of sub-matrices FYM_sub may be the same as a row size of the input matrix XM. A column size of each of the plurality of sub-matrices FYM_sub may be the same as a column size of the weight matrix WM. For example, each of each of the plurality of sub-matrices FYM_sub may include m output elements each row. Each of each of the plurality of sub-matrices FYM_sub may include h output elements each column.

A row size of the full output matrix FYM may be the same as a row size of the full weight matrix FWM. For example, the row size of the full output matrix FYM may be "M".

A column size of the full output matrix FYM may be the same as a column size of the full input matrix FXM. For example, the column size of the full output matrix FYM may be "H".

The matrix multiplication device MMD may operate the full output matrix FYM by the sub-matrices FYM_sub. For example, the matrix multiplication device MMD may calculate one sub-matrices FYM_sub by adding products of the tiled plurality of input matrices XM and the tiled plurality of weight matrices WM.

For a more detailed example, if N is 3 times n, the matrix multiplier 100 may calculate the sub-matrix FYM_sub_11 by sequentially calculating a product of the input matrix XM_11 and the weight matrix WM_11, a product of the input matrix XM_12 and the weight matrix WM_21, and a product of the input matrix XM_13 and the weight matrix WM_31 and then adding the calculated products. In this case, a product of the tiled input matrix and the tiled weight matrix may correspond to the output matrix YM described above with reference to FIGS. 1 to 3 and 15 to 33. For example, the matrix multiplication device MMD may calculate a first output matrix based on the product of the input matrix XM_11 and the weight matrix WM_11; may calculate a second output matrix based on the product of the input matrix XM_12 and the weight matrix WM_21; and may calculate a third output matrix based on the product of the input matrix XM_13 and the weight matrix WM_31. Thereafter, the matrix multiplication device MMD may calculate the sub-matrix FYM_sub_11 by adding the above-described the first to third output matrices. However, example embodiments are not limited thereto.

For example, the matrix multiplication device MMD may be implemented to accumulate the plurality of output matrices to calculate one sub-matrix (e.g., a part of the full output matrix FYM). For example, the matrix multiplication device MMD may be implemented to temporarily store the plurality of output matrices in an external volatile memory device (e.g., an SRAM device) and then accumulate the stored plurality of output matrices to calculate one sub-matrix. In this way, the matrix multiplication device MMD may calculate the full output matrix FYM by sequentially calculating the plurality of sub-matrices FYM_sub.

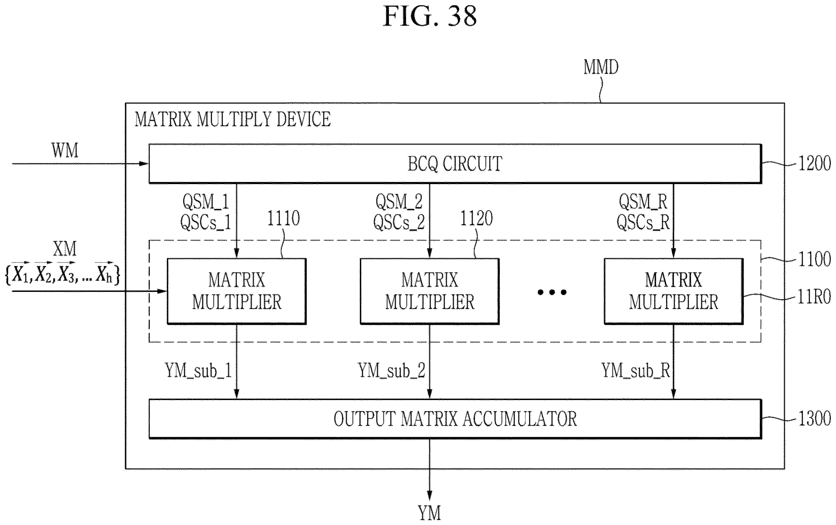

FIG. 38 is a block diagram showing a matrix multiplication device according to some example embodiments. Referring to FIG. 38, the matrix multiplication device MMD may include a matrix multiplier array 1000, a BCQ circuit 1200, and an output matrix accumulator 3000.

The BCQ circuit 1200 may receive the weight matrix WM. The BCQ circuit 1200 may generate a plurality of quantization sign matrices QSM and the plurality of quantization scale coefficients QSC by binary coding quantizing the weight matrix WM with the BCQ resolution of "R". Because an operation of the BCQ circuit 1200 is similar to the operation of the BCQ circuit 200 described above with reference to FIGS. 1 to 3 and 15 to 33, a detailed description thereof will be omitted.

Hereinafter, for a more concise description, the quantization scale coefficients corresponding to the first to R-th quantization sign matrices QSM_1-QSM_R will be referred to as first to R-th plurality of quantization scale coefficients QSCs_1-QSCs_R, respectively. For example, the first plurality of quantization scale coefficients QSCs_1 may refer to the quantization scale coefficients shown in the diagonal stripe in FIG. 24. Similarly, the second plurality of quantization scale coefficients QSCs_2 may refer to the quantization scale coefficients shown in the dot pattern in FIG. 24.

The matrix multiplier array 1000 may include first to R-th matrix multipliers 1110-11R0.

Each of the first to R-th matrix multipliers 1110-11R0 may receive the input matrix XM. For example, each of the first to R-th matrix multipliers 1110-11R0 may receive the same input matrix XM.

The first to R-th matrix multipliers 1110-11R0 may receive the first to R-th plurality of quantization scale coefficients QSCs_1-QSCs_R, respectively. The first to R-th matrix multipliers 1110-11R0 may respectively receive the first to R-th quantization sign matrices QSM_1-QSM_R.

Each of the first to R-th matrix multipliers 1110-11R0 may be implemented in a manner similar to that described above with reference to FIGS. 1 to 3 and 15 to 33. For example, the first matrix multiplier 1110 may generate a first sub-output matrix YM_sub_1 by scaling the input matrix XM based on the plurality of quantization scale coefficients QSCs_1 and then accumulating the scaled input matrix based on the first quantization sign matrix QSM_1. In this way, the first to R-th matrix multipliers 1110-11R0 may generate first to R-th sub-output matrices YM_sub_1-YM_sub_R, respectively.

An output matrix accumulator 1300 may receive the first to R-th sub-output matrices YM_sub_1-YM_sub_R. The output matrix accumulator 1300 may generate the output matrix YM by adding the first to the first to R-th sub-output matrices YM_sub_1-YM_sub_R.

For example, according to the embodiment of FIG. 35, the output matrix may be calculated in such a way that the plurality of matrix multipliers respectively generate the sub-output matrices based on different quantization sign matrices, and then accumulate the generated sub-output matrices. In this case, even if the weight matrix WM is binary coding quantized with a high BCQ resolution, the plurality of matrix multipliers operate the sub-output matrices corresponding to the different quantization sign matrices in parallel. Thus, an operating speed of the matrix multiplication device MMD may be improved.

For a more concise description, the embodiment in which the matrix multiplier array 1000 includes the number of matrix multipliers corresponding to the BCQ resolution (e.g., R) is representatively described in FIG. 38, but the range of example embodiments is not limited thereto. For example, an operation of each matrix multiplier based on the plurality of quantization sign matrices may be similar to that described above with reference to FIGS. 1 to 3, and 15 to 33.

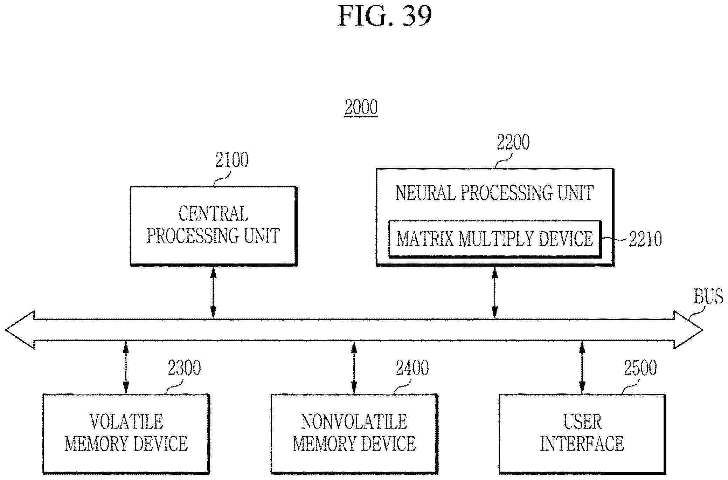

FIG. 39 is a block diagram showing a neural processing system implemented according to some example embodiments. Referring to FIG. 39, the neural processing system 2000 may include a central processing unit 2100, a neural processing unit 2200, a volatile memory device 2300, a nonvolatile memory device 2400, and a user interface 2500. The central processing unit 2100, the neural processing unit 2200, the volatile memory device 2300, the volatile memory device 2400, and the user interface 2500 may be connected to each other through a bus BUS.

The central processing unit 2100 may control an overall operation of the neural processing system 2000. For example, the central processing unit 2100 may control each component of the neural processing system 2000 to operate the artificial intelligence model.

In some example embodiments, the artificial intelligence model that the neural processing system 2000 executes may be one of any type of the artificial intelligence model such as a language model, an image identification model, an image generation model, a weather analysis model, or the like. For example, the artificial intelligence model that neural processing system 2000 executes may be one of any type of the artificial intelligence model such as GPT-3, GPT-4, Pangu, GShard, Megatron-LM, or the like. However, example embodiments are not limited thereto.

In some example embodiments, the artificial intelligence model executed by the neural processing system 2000 may perform an inference operation and/or a training operation. However, example embodiments are not limited thereto.

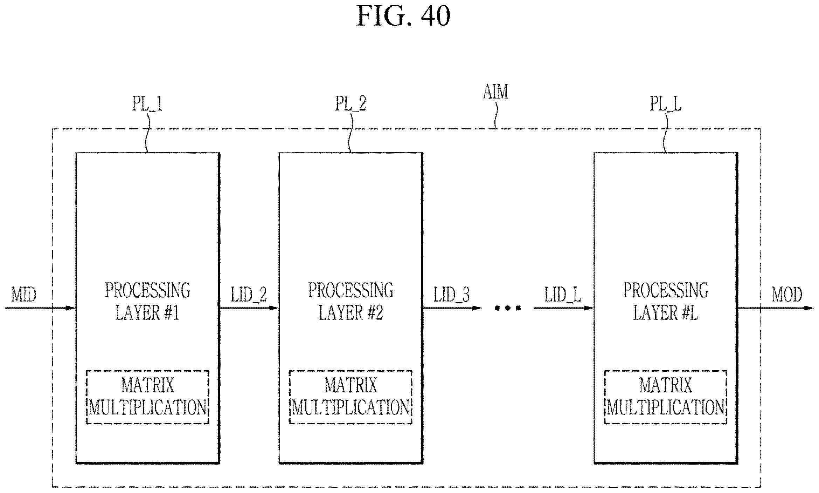

Each artificial intelligence model may include a plurality of processing layers. Each of the plurality of processing layers may be implemented to receive layer input data to generate layer output data. In this case, the generated layer output data may be used as layer input data for another processing layer. For example, layer output data generated from a first processing layer may be used as layer input data for a second processing layer. More detailed descriptions of the artificial intelligence model and the processing layer will be described with reference to FIG. 40.

Each of the plurality of processing layers may transform layer input data into layer output data based on matrix multiplication calculation. For example, each of the plurality of processing layers may generate the output matrix corresponding to the layer output data by multiplying the input matrix corresponding to the layer input data, by the weight matrix. However, the range of example embodiments is not limited thereto, and each of the plurality of processing layers may generate the output data by converting the input matrix corresponding to the layer input data in an any manner. For example, each of the plurality of processing layers may be implemented to generate the layer output data by sequentially multiplying the input matrix corresponding to the layer input data by the plurality of weight matrices, or to convert the input matrix to the layer output data based on any conversion parameter. For example, example embodiments are not limited to the specific manner in which each of the plurality of processing layers transforms the layer input data.

The neural processing unit 2200 may include a matrix multiplication device 2210. The matrix multiplication device 2210 may execute at least some of calculations included in the plurality of processing layers. For example, the matrix multiplication device 2210 may perform a matrix multiplication calculation included in the plurality of processing layers.

In some example embodiments, the matrix multiplication calculation may occupy most of a processing load required by the neural processing system 2000 to execute each of the plurality of processing layers.

In some example embodiments, the matrix multiplication device 2210 may be implemented as the matrix multiplication device MMD described above with reference to FIGS. 1 to 38. In this case, the neural processing unit 2200 may execute the calculations included in the plurality of processing layers with a smaller computation amount. Therefore, the neural processing system 2000 including the matrix multiplication device MMD according to various example embodiments may drive the artificial intelligence model at a faster speed.

The volatile memory device 2300 may be used as an operating memory of the neural processing unit 2200. For example, the volatile memory device 2300 may temporarily store data generated during an operation of the neural processing unit 2200.

In some example embodiments, the neural processing unit 2200 may access the volatile memory device 2300 to execute the calculations included in the plurality of processing layers. For example, the neural processing unit 2200 may be implemented to read a parameter stored in the volatile memory device 2300 to perform a calculation for layer input data, or may be implemented to temporarily store intermediate data generated during the calculation in the volatile memory device 2300.

In some example embodiments, a calculation speed of the neural processing unit 2200 may be higher than an access speed of the neural processing unit 2200 to the volatile memory device 2300. Accordingly, a bottleneck phenomenon may occur in an operating speed of the artificial intelligence model due to a communication speed between the neural processing unit 2200 and the volatile memory device 2300.

In some example embodiments, if the matrix multiplication device 2210 is implemented as the matrix multiplication device MMD described above with reference to FIGS. 1 to 38, each of the processing elements PE included in the matrix multiplier MMD may calculate one output element. In this case, since the neural processing unit 2200 may not store and read the partial sum PSM in the volatile memory device 2300, the number of accesses of the neural processing unit 2200 to the volatile memory device 2300 may be reduced or minimized. Therefore, according to various example embodiments, the bottleneck phenomenon in an operation speed of the artificial intelligence model caused by the access of the neural processing unit 2200 to the volatile memory device 2300 may be reduced or minimized.

In some example embodiments, if the matrix multiplication device 2210 is implemented as the matrix multiplication device MMD described above with reference to FIGS. 1 to 39, each of the processing elements PE may calculate one output element. In this case, the artificial intelligence model may be driven with a smaller size of the processing element array 150 (e.g., fewer processing elements PE). Therefore, according to various example embodiments, a production cost of the neural processing system 2000 for driving the artificial intelligence model may be reduced or minimized.

In some example embodiments, the volatile memory device 2300 may be implemented with any type of volatile memory such as a dynamic random access memory (DRAM), a static random access memory (SRAM), or the like.

In some example embodiments, the volatile memory device 2300 may be used as a buffer memory, an operating memory, or a cache memory of the central processing unit 2100. However, example embodiments are not limited thereto.

The volatile memory device 2400 may store data for the operation of the neural processing system 2000. For example, the volatile memory device 2400 may store various types of data such as a parameter for an operating system (OS) of the neural processing system 2000, a parameter for driving the artificial intelligence model, and the like. However, example embodiments are not limited thereto.

The central processing unit 2100 may communicate with a user through the user interface 2500. The central processing unit 2100 may provide model input data provided by the user, to the volatile memory device 2300 or the neural processing unit 2200, through the user interface 2500. The central processing unit 2100 may return model output data generated by the artificial intelligence model based on the model input data to the user through the user interface 2500.

FIG. 40 is a block diagram showing the artificial intelligence model driven by the neural processing system of FIG. 39. Referring to FIG. 39 and FIG. 40, the neural processing system 2000 may drive an artificial intelligence model AIM.

The artificial intelligence model AIM may receive the model input data MID. The artificial intelligence model AIM may include first to L-th processing layers PL_1-PL_L.

The artificial intelligence model AIM may generate the model output data MOD by sequentially converting the model input data MID through the first to L-th processing layers PL_1-PL_L. For example, the first processing layer PL_1 may receive the model input data MID, and may generate second layer input data LID_2. The second processing layer PL_2 may receive the second layer input data LID_2, and may generate third layer input data LID_3. In this way, the L-th processing layer PL_L may receive L-th layer input data LID_L, and may generate the model output data MOD.

Each of the first to L-th processing layers PL_1-PL_L may transform (or convert) the received data into data to be output through various types of calculations. For example, a matrix multiplication calculation may be included in calculations performed by the first processing layer PL_1 to transform the model input data MID to the second layer input data LID_2. Similarly, each of the first to L-th processing layers PL_1-PL_L may have to perform the matrix multiplication calculation to transform the received layer input data. However, the range of example embodiments is not limited thereto, and some of the first to L-th processing layers PL_1-PL_L may not perform the matrix multiplication calculation.

In some example embodiments, the matrix multiplication calculation performed by each of the first to L-th processing layers PL_1-PL_L may be performed through the matrix multiplication device 2210.

In some example embodiments, if the matrix multiplication device 2210 is implemented as the matrix multiplication device MMD described above with reference to FIGS. 1 to 39, the matrix multiplication device 2210 may output a result of the matrix multiplication calculation at a faster speed. Therefore, according to various example embodiments, an operation speed of the artificial intelligence model AIM may be improved.

For a more concise description, embodiments including the plurality of processing layers in which the artificial intelligence model AIM operates in series is representatively described in FIG. 40, but example embodiments are not limited thereto. For example, the artificial intelligence model AIM may further include a processing layer that operates in parallel for at least some of the first to L-th processing layers PL_1-PL_L described above. For example, example embodiments are not limited to the specific implementation method of the artificial intelligence model AIM.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

Example embodiments may provide a matrix multiplier and a method of matrix multiplication, which may be used in various algorithms such as various machine-learning and/or artificial intelligence algorithms. The machine-learning and/or artificial intelligence algorithms may be used to implement various industrial processes, and/or various telecommunication processes, and/or various transportation processes. For example, the matrix multiplier and/or the method of matrix multiplication may be used in and may speed up applications applicable to one or more of healthcare, customer service, finance, manufacturing, transportation, agriculture, retail, education, energy, human resources, environment, security, entertainment, legal services, space exploration, mining operations, defense operations, and/or governmental services.

The contents described above are specific embodiments for implementing present disclosure. Inventive concepts may include not only the above-described example embodiments but also embodiments that may be simply changed in design or may be easily modified. Additionally, inventive concepts may also include technologies that may be easily modified and implemented using the embodiments. Therefore, the scope of the present disclosure should not be limited to the above-described example embodiments, but should be defined by the claims described below as well as the claims and equivalents thereof. Additionally, example embodiments are not necessarily mutually exclusive. For example, some example embodiments may include one or more features described with reference to one or more figures, and may also include one or more other features described with reference to one or more other figures.

Embodiments of the invention are set out in the following numbered clauses:

1. A matrix multiplier comprising:

an input vector scaler configured to generate a first scaled input vector based on a first input vector and on a plurality of quantization scale coefficients;
a first data type converter configured to generate a first fixed-point scaled input vector based on the first scaled input vector;
a processing element array including a first processing element configured to generate a first fixed-point output element based on the first fixed-point scaled input vector and on a first plurality of quantization sign values, and a second processing element configured to generate a second fixed-point output element based on the first fixed-point scaled input vector and on second plurality of quantization sign values; and
a second data type converter configured to generate a first output element and a second output element by converting a data type of the first fixed-point output element and a data type of the second fixed-point output element respectively, and configured to output a first output vector including the first and second output elements.

2. The matrix multiplier of clause 1, wherein

the input vector scaler is further configured to generate a second scaled input vector based on a second input vector and on the plurality of quantization scale coefficients,

the first data type converter is further configured to generate a second fixed-point scaled input vector based on the second scaled input vector,

the processing element array further includes a third processing element and a fourth processing element, the third processing element configured to generate a third fixed-point output element based on the second fixed-point scaled input vector and on the first plurality of quantization sign values, and the fourth processing element configured to generate a fourth fixed-point output element based on the second fixed-point scaled input vector and on the second plurality of quantization sign values, and

the second data type converter is further configured to generate a third output element and a fourth output element by converting a data type of the third fixed-point output element and a data type of the fourth fixed-point output element respectively, and to output a second output vector including the third and fourth output elements.

3. The matrix multiplier of clause 2, wherein the first and second processing elements are in a first processing element row of the processing element array, and the third and fourth processing elements are in a second processing element row of the processing element array.

4. The matrix multiplier of clause 2 or clause 3, wherein the first and third processing elements are in a first processing element column of the processing element array, and the second and fourth processing elements are in a second processing element column of the processing element array.

5. The matrix multiplier of any of clauses 2 to 4, wherein

a dimension of the first fixed-point scaled input vector is R times of a dimension of the first input vector, (wherein R is an integer greater than or equal to 2), and

a dimension of the second fixed-point scaled input vector is R times of a dimension of the second input vector.

6. The matrix multiplier of clause 5, wherein the dimension of the first input vector, the dimension of the second input vector, the dimension of the first output vector, and the dimension of the second output vector are the same.

7. The matrix multiplier of any of clauses 2 to 6, wherein the first data type converter comprises:

a first exponent extract circuit configured to extract a first exponent corresponding to a largest one among exponents of each of first plurality of scaled input elements included in the first scaled input vector;

a second exponent extract circuit configured to extract a second exponent based on a largest one among exponents of each of second plurality of scaled input elements included in the second scaled input vector;

a first data type convert circuit configured to generate the first fixed-point scaled input vector by converting a data type of each of the first plurality of scaled input elements to fixed-point based on the first exponent; and

a second data type convert circuit configured to generate the second fixed-point scaled input vector by converting a data type of each of the second plurality of scaled input elements to fixed-point based on the second exponent.

8. The matrix multiplier of clause 7, wherein the second data type converter is further configured to:

convert the data types of the first and second fixed-point output elements to floating-point based on the first exponent, and

convert the data types of the third and fourth fixed-point output elements to floating-point based on the second exponent.

9. The matrix multiplier of clause 8, wherein

exponent parts of the first and second output elements correspond to the first exponent, and

exponent parts of the third and fourth output elements correspond to the second exponent.

10. The matrix multiplier of any preceding clause, wherein

the first processing element is configured to generate the first fixed-point output element by accumulating products of first plurality of fixed-point scaled input elements included in the first fixed-point scaled input vector and the first plurality of quantization sign values, and

the second processing element is configured to generate the second fixed-point output element by accumulating products of the first plurality of fixed-point scaled input elements included in the second fixed-point scaled input vector and the second plurality of quantization sign values.

11. The matrix multiplier of clause 10, wherein the first processing element includes:

an accumulation register; and
an arithmetic logic unit (ALU) including a first input terminal configured to sequentially receive the first plurality of fixed-point scaled input elements, a second input terminal configured to sequentially receive the first plurality of quantization sign values, and a third input terminal connected to the accumulation register, and
wherein the arithmetic logic unit is configured to update a value obtained by adding a product of one scaled input element received through the first input terminal and one quantization sign value received through the second input terminal to a stored value of the accumulation register, in the accumulation register and through the third input terminal.

12. A matrix multiplier comprising:

an input vector scaler configured to generate a first plurality of scaled input elements based on a first input element and a first plurality of quantization scale coefficients, and generates second plurality of scaled input elements based on a second input element and a second plurality of quantization scale coefficients;
a first data type converter configured to generate a first plurality of fixed-point scaled input elements based on the first plurality of scaled input elements, and to generate a second plurality of fixed-point scaled input elements based on the second plurality of scaled input elements;
a first processing element configured to generate a first fixed-point output element by accumulating the first plurality of fixed-point scaled input elements and the second plurality of fixed-point scaled input elements based on a plurality of quantization sign values; and
a second data type converter configured to generate a first output element by converting a data type of the first fixed-point output element.

13. The matrix multiplier of clause 12, wherein a number of the first plurality of quantization scale coefficients, a number of the second plurality of quantization scale coefficients, a number of the first plurality of scaled input elements, and a number of the second plurality of scaled input elements are the same.

14. The matrix multiplier of clause 13, wherein the first plurality of scaled input elements correspond to values obtained by multiplying each of the first plurality of quantization scale coefficients by the first input element, and the second plurality of scaled input elements correspond to values obtained by multiplying each of the second plurality of quantization scale coefficients by the second input element.

15. The matrix multiplier of any of clauses 12 to 14, wherein:

a data type of each of the first and second input elements and each of first and second plurality of quantization scale coefficients are floating-point, and
data types of the first plurality of fixed-point scaled input elements and the second plurality of scaled input elements are fixed-point corresponding to a same place value.

16. The matrix multiplier of clause 15, wherein the first data type converter comprises:

a first exponent extract circuit configured to extract a first exponent corresponding to a largest among exponents of the first plurality of scaled input elements and the second plurality of scaled input elements;
a data type convert circuit configured to convert a data type of each of the first plurality of scaled input elements and the second plurality of scaled input elements to fixed-point based on the first exponent.

17. The matrix multiplier of clause 16, wherein the data type convert circuit is configured to determine an exponent part of the first output element based on the first exponent.

18. An operation method of a matrix multiplication device, comprising:

receiving first to N-th weights from an external device (wherein N is an integer greater than or equal to 2);

generating first to (N×R)-th quantization sign values and first to (N×R)-th quantization scale coefficients by binary coding quantizing the first to N-th weights (wherein R is an integer greater than or equal to 2); receiving first to N-th input elements from the external device; generating first to (N×R)-th scaled input elements by scaling the first to N-th input elements based on the first to (N×R)-th quantization scale coefficients; and outputting a first output element generated by accumulating the first to (N×R)-th scaled input elements based on the first to (N×R)-th quantization sign values.

19. The operation method of clause 18, wherein the outputting the first output element comprises:

converting data type of the first to (N×R)-th scaled input elements to fixed-point; generating a first fixed-point output element by accumulating the first to (N×R)-th scaled input elements converted to fixed-point format, based on the first to (N×R)-th quantization sign values; and outputting the first output element generated by converting a data type of the first fixed-point output element to floating-point.

20. The operation method of clause 18 or clause 19, wherein the first output element corresponds to a sum of values obtained by respectively multiplying the first to (N×R)-th quantization sign values by the first to (N×R)-th scaled input elements.

21. A matrix multiplication device configured to receive a weight matrix and a first input vector from outside, comprising:

a binary coding quantization (BCQ) circuit configured to generate a plurality of quantization sign values and a plurality of quantization scale coefficients by binary coding quantizing the weight matrix; and a matrix multiplier configured to calculate a first output vector corresponding to a product of the first input vector and the weight matrix based on the plurality of quantization sign values and on the plurality of quantization scale coefficients,

wherein the matrix multiplier comprises, an input vector scaler configured to generate a first scaled input vector by scaling the first input vector based on the plurality of quantization scaling coefficients, a first data type converter configured to generate a first fixed-point scaled input vector based on the first scaled input vector, a processing element array configured to calculate a first fixed-point output vector based on the plurality of quantization sign values and the first fixed-point scaled input vector, and a second data type converter configured to generate the first output vector by converting a data type of the first fixed-point output vector.

22. A matrix multiplication device configured to receive an n-dimensional input vector and a weight matrix with n by m dimensions, and to output an m-dimensional output vector, (wherein n and m are an integer greater than or equal to 2) comprising:

a binary coding quantization (BCQ) circuit configured to generate first to R-th quantization sign matrices with n by m dimensions, and first to (N×R)-th quantization scale coefficients respectively corresponding to different rows of the first to R-th quantization sign matrices (wherein R is an integer greater than or equal to 2); an input vector scaler configured to scale elements of the n-dimensional input vector based on the first to (N×R)-th quantization scale coefficients; and a processing element array that includes a plurality of processing elements, wherein each of the plurality of processing elements is configured to output different output elements each other included in the m-dimensional output vector, by accumulating elements of the input vector scaled based on the first to R-th quantization sign matrices.

**Claims**

1. A matrix multiplier comprising:

an input vector scaler configured to generate a first scaled input vector based on a first input vector and on a plurality of quantization scale coefficients;

a first data type converter configured to generate a first fixed-point scaled input vector based on the first scaled input vector;

a processing element array including a first processing element configured to generate a first fixed-point output element based on the first fixed-point scaled input vector and on a first plurality of quantization sign values, and a second processing element configured to generate a second fixed-point output element based on the first fixed-point scaled input vector and on second plurality of quantization sign values; and

a second data type converter configured to generate a first output element and a second output element by converting a data type of the first fixed-point output element and a data type of the second fixed-point output element respectively, and configured to output a first output vector including the first and second output elements.

2. The matrix multiplier of claim 1, wherein

the input vector scaler is further configured to generate a second scaled input vector based on a second input vector and on the plurality of quantization scale coefficients,

the first data type converter is further configured to generate a second fixed-point scaled input vector based on the second scaled input vector,

the processing element array further includes a third processing element and a fourth processing element, the third processing element configured to generate a third fixed-point output element based on the second fixed-point scaled input vector and on the first plurality of quantization sign values, and the fourth processing element configured to generate a fourth fixed-point output element based on the second fixed-point scaled input vector and on the second plurality of quantization sign values, and

the second data type converter is further configured to generate a third output element and a fourth output element by converting a data type of the third fixed-point output element and a data type of the fourth fixed-point output element respectively, and to output a second output vector including the third and fourth output elements.

3. The matrix multiplier of claim 2, wherein the first and second processing elements are in a first processing element row of the processing element array, and the third and fourth processing elements are in a second processing element row of the processing element array.

4. The matrix multiplier of claim 2 or claim 3, wherein the first and third processing elements are in a first processing element column of the processing element array, and the second and fourth processing elements are in a second processing element column of the processing element array.

5. The matrix multiplier of any of claims 2 to 4, wherein

a dimension of the first fixed-point scaled input vector is R times of a dimension of the first input vector, (wherein R is an integer greater than or equal to 2), and

a dimension of the second fixed-point scaled input vector is R times of a dimension of the second input vector.

6. The matrix multiplier of claim 5, wherein the dimension of the first input vector, the dimension of the second input vector, the dimension of the first output vector, and the dimension of the second output vector are the same.

7. The matrix multiplier of any of claims 2 to 6, wherein the first data type converter comprises:

a first exponent extract circuit configured to extract a first exponent corresponding to a largest one among exponents of each of first plurality of scaled input elements included in the first scaled input vector;

a second exponent extract circuit configured to extract a second exponent based on a largest one among exponents of each of second plurality of scaled input elements included in the second scaled input vector;

a first data type convert circuit configured to generate the first fixed-point scaled input vector by converting a data type of each of the first plurality of scaled input elements to fixed-point based on the first exponent; and

a second data type convert circuit configured to generate the second fixed-point scaled input vector by converting a data type of each of the second plurality of scaled input elements to fixed-point based on the second exponent.

8. The matrix multiplier of claim 7, wherein the second data type converter is further configured to:

convert the data types of the first and second fixed-point output elements to floating-point based on the first exponent, and
convert the data types of the third and fourth fixed-point output elements to floating-point based on the second exponent.

9. The matrix multiplier of claim 8, wherein

exponent parts of the first and second output elements correspond to the first exponent, and
exponent parts of the third and fourth output elements correspond to the second exponent.

10. The matrix multiplier of any of claims 2 to 9, wherein:

the first input vector includes first and second input elements,
the plurality of quantization scale coefficients includes a first plurality of quantization scale coefficients and a second plurality of quantization scale coefficients, and
the input vector scaler includes a first input vector scaling circuit, the first input vector scaling circuit is configured to sequentially calculate elements included in the first scaled input vector by multiplying the first input element to each of the first plurality of quantization scale coefficients, and multiplying the second input element to each of the second plurality of quantization scale coefficients.

11. The matrix multiplier of claim 10, wherein:

the second input vector includes third and fourth input elements, and
the input vector scaler further includes a second input vector scaling circuit, the second input vector scaling circuit is configured to sequentially calculate elements included in the second scaled input vector by multiplying the third input element to each of the first plurality of quantization scale coefficients, and multiplying the fourth input element to each of the second plurality of quantization scale coefficients.

12. The matrix multiplier of any preceding claim, wherein

the first processing element is configured to generate the first fixed-point output element by accumulating products of first plurality of fixed-point scaled input elements included in the first fixed-point scaled input vector and the first plurality of quantization sign values, and
the second processing element is configured to generate the second fixed-point output element by accumulating products of the first plurality of fixed-point scaled input elements included in the second fixed-point scaled input vector and the second plurality of quantization sign values.

13. The matrix multiplier of claim 12, wherein the first processing element includes:

an accumulation register; and
an arithmetic logic unit (ALU) including a first input terminal configured to sequentially receive the first plurality of fixed-point scaled input elements, a second input terminal configured to sequentially receive the first plurality of quantization sign values, and a third input terminal connected to the accumulation register, and
wherein the arithmetic logic unit is configured to update a value stored in in the accumulation register with a value obtained by adding a product of one scaled input element received through the first input terminal and one quantization sign value received through the second input terminal to a value received by the third input terminal.

14. The matrix multiplier of any preceding claim, wherein a first code length of the first plurality of fixed-point scaled input elements is shorter than a second code length of the elements included in the first and second scaled input vectors.

15. The matrix multiplier of any preceding claim, wherein

the matrix multiplier is configured to generate the first and second plurality of quantization sign value, and the plurality of quantization scale coefficient, by performing binary coding quantization (BCQ) for a weight matrix, and
the matrix multiplier is configured to generate the first plurality of quantization sign value based on a first column of the weight matrix, and to generate the second plurality of quantization sign value based on a second column of the weight matrix.

# FIG. 1

# FIG. 2

n-times of "Floating point multiplication"
(n-1) times of "Floating point summation"

$$\begin{bmatrix} x_{11} & x_{12} & \cdots & x_{1n} \\ x_{21} & x_{22} & \cdots & x_{2n} \\ \vdots & \vdots & \ddots & \vdots \\ x_{h1} & x_{h2} & \cdots & x_{hn} \end{bmatrix} \times \begin{bmatrix} w_{11} & w_{12} & \cdots & w_{1m} \\ w_{21} & w_{22} & \cdots & w_{2m} \\ \vdots & \vdots & \ddots & \vdots \\ w_{n1} & w_{n2} & \cdots & w_{nm} \end{bmatrix} = \begin{bmatrix} y_{11} & y_{12} & \cdots & y_{1m} \\ y_{21} & y_{22} & \cdots & y_{2m} \\ \vdots & \vdots & \ddots & \vdots \\ y_{h1} & y_{h2} & \cdots & y_{hm} \end{bmatrix}$$

INPUT MATRIX
(XM)

WEIGHT MATRIX
(WM)

OUTPUT MATRIX
(YM)

FIG. 3

# FIG. 4

$$WM = \begin{bmatrix} W_{11} & W_{12} & \cdots & W_{1m} \\ W_{21} & W_{22} & \cdots & W_{2m} \\ \vdots & \vdots & \ddots & \vdots \\ W_{n1} & W_{n2} & \cdots & W_{nm} \end{bmatrix}$$

$$\overrightarrow{W_{c1}} \qquad \overrightarrow{W_{c2}} \qquad \overrightarrow{W_{cm}}$$

$$\overrightarrow{W_{cj}} \approx \sum_{k=1}^{R} \left( \alpha_{k\_cj} \times \overrightarrow{B_{k\_cj}} \right)$$

# FIG. 5

$$y_{11} = \overrightarrow{X_1} \times \overrightarrow{W_{c1}}$$

$$\approx \overrightarrow{X_1} \times \left( \alpha_{1\_c1} \times \overrightarrow{B_{1\_c1}} + \alpha_{2\_c1} \times \overrightarrow{B_{2\_c1}} + \ldots + \alpha_{R\_c1} \times \overrightarrow{B_{R\_c1}} \right)$$

$$\approx \underbrace{\alpha_{1\_c1} \times \overrightarrow{X_1} \times \overrightarrow{B_{1\_c1}}}_{PSM_{1\_c1\_X1}} + \underbrace{\alpha_{2\_c1} \times \overrightarrow{X_1} \times \overrightarrow{B_{2\_c1}}}_{PSM_{2\_c1\_X1}} + \ldots + \underbrace{\alpha_{R\_c1} \times \overrightarrow{X_1} \times \overrightarrow{B_{R\_c1}}}_{PSM_{R\_c1\_X1}}$$

$R \times (n-1)$-times of "Floating point summation"
$R$-times of "Floating point multiplication"
$(R-1)$-times of "Floating point summation"

EP 4 546 114 A1

# FIG. 6

QUNATIZATION SIGN VALUE BUFFER — 12

QSV

— 10

$$XM$$
$$\{\vec{X_1}, \vec{X_2}, \vec{X_3}, \dots \vec{X_h}\}$$

DATA TYPE CONVERTER #1 — 11

$$XM\_fxp$$
$$\{\vec{X'_1}, \vec{X'_2}, \vec{X'_3}, \dots \vec{X'_h}\}$$

PROCESSING ELEMENT ARRAY — 13

PSM_fxp

EXP

DATA TYPE CONVERTER #2 — 14

PSM

QUNATIZATION SCALE COEFFICIENT BUFFER — 15

QSC

PARTIAL SUM SCALER — 16

SCPSM

ACCUMULATOR — 17

$$YM$$
$$\{\vec{Y_1}, \vec{Y_2}, \vec{Y_3}, \dots \vec{Y_h}\}$$

EP 4 546 114 A1

# FIG. 7

# FIG. 8

"Extract maximum exponent"

EXP1

# FIG. 9

# FIG. 10

QUNATIZATION SIGN VALUE BUFFER ~12

QSV

~13

$\overrightarrow{X'_1}$  →  PE11  PE12  PE13  · · ·  PE1q  ~PER1

$\overrightarrow{X'_2}$  →  PE21  PE22  PE23  · · ·  PE2q  ~PER2

$\overrightarrow{X'_p}$  →  PEp1  PEp2  PEp3  · · ·  PEpq  ~PERp

DATA TYPE CONVERTER #2  ~14

EP 4 546 114 A1

# FIG. 11

# FIG. 12

# FIG. 13

# FIG. 14

PSM_fxp

Sign [SP]   Mantissa [MTSP]

| 1 | 0 | ... | 1 | 1 |

PSM

Sign [SP]   Exponent [EXPP]   Mantissa [MTSP]

| 1 | 0 | ... | 1 | 1 | 0 | ... | 1 | 1 | 0 | 0 | ... | 0 |

"Insert EXP1"

"Insert '0' bits"

EP 4 546 114 A1

FIG. 15

EP 4 546 114 A1

$$WM = \begin{bmatrix} W_{11} & W_{12} & \cdots & W_{1m} \\ W_{21} & W_{22} & \cdots & W_{2m} \\ \vdots & \vdots & \ddots & \vdots \\ W_{n1} & W_{n2} & \cdots & W_{nm} \end{bmatrix} \begin{matrix} \overrightarrow{W_{r1}} \\ \overrightarrow{W_{r2}} \\ \\ \overrightarrow{W_{rn}} \end{matrix} \Bigg\} \quad \overrightarrow{W_{ri}} \approx \sum_{k=1}^{R} \left( \alpha_{k\_ri} \times \overrightarrow{B_{k\_ri}} \right)$$

# FIG. 16

$$WM \approx \begin{bmatrix} \alpha_{1\_r1} \times \overrightarrow{B_{1\_r1}} + \alpha_{2\_r1} \times \overrightarrow{B_{2\_r1}} + \ldots + \alpha_{R\_r1} \times \overrightarrow{B_{R\_r1}} \\ \alpha_{1\_r2} \times \overrightarrow{B_{1\_r2}} + \alpha_{2\_r2} \times \overrightarrow{B_{2\_r2}} + \ldots + \alpha_{R\_r2} \times \overrightarrow{B_{R\_r2}} \\ \vdots \\ \alpha_{1\_rn} \times \overrightarrow{B_{1\_rn}} + \alpha_{2\_rn} \times \overrightarrow{B_{2\_rn}} + \ldots + \alpha_{R\_rn} \times \overrightarrow{B_{R\_rn}} \end{bmatrix}$$

QSM_1 QSM_2 ⋯ QSM_R

# FIG. 17

m-weights

n-weights

WEIGHT MATRIX
(WM)

"BCQ"

QSM_R
QSM_3
QSM_2
QSM_1

n-QSVs

QUANTIZATION SIGN MATRIX
(QSM)

m-QSVs

EP 4 546 114 A1

# FIG. 18

# FIG. 19

QUANTIZATION SCALE COEFFICIENT BUFFER — 110

QSC QSC QSC QSC

— 120

$\overrightarrow{X_1}$

121

INPUT VECTOR SCALING CIRCUIT

$\overrightarrow{SCX_1}$

$\overrightarrow{X_2}$

122

INPUT VECTOR SCALING CIRCUIT

$\overrightarrow{SCX_2}$

$\overrightarrow{X_3}$

123

INPUT VECTOR SCALING CIRCUIT

$\overrightarrow{SCX_3}$

$\overrightarrow{X_h}$

12h

INPUT VECTOR SCALING CIRCUIT

$\overrightarrow{SCX_h}$

EP 4 546 114 A1

# FIG. 20

EP 4 546 114 A1

# FIG. 21

EP 4 546 114 A1

FIG. 22

# FIG. 23

FIG. 24

# FIG. 25

QSV

PE

SCIE_fxp

TI1    TI3

TI2    ALU

TO

REG_ACC

OE_fxp

DATA TYPE CONVERTER #2
160

# FIG. 26

EP 4 546 114 A1

# FIG. 27

```
                    ( START )
                        │
                        ▼
        ┌───────────────────────────────┐
        │     Receive weight matrix      │──S110
        └───────────────────────────────┘
                        │
                        ▼
        ┌───────────────────────────────┐
        │ Generate a plurality of QSC and QSV by │──S120
        │ binary coding quantizing the weight matrix │
        └───────────────────────────────┘
                        │
                        ▼
        ┌───────────────────────────────┐
        │      Receive input vector      │──S130
        └───────────────────────────────┘
                        │
                        ▼
        ┌───────────────────────────────┐
        │ Generate scaled input vector by scaling the │──S140
        │ input vector based on the plurality of QSC │
        └───────────────────────────────┘
                        │
                        ▼
        ┌───────────────────────────────┐
        │    Generate output vector by accumulating    │──S150
        │    elements of the scaled input vector       │
        │       based on the plurality of QSV          │
        └───────────────────────────────┘
                        │
                        ▼
                     ( END )
```

# FIG. 28

```
                    ┌──────────────────┐
                    │      START       │
                    └──────────────────┘
                             │                    S150
   ┌─────────────────────────┼───────────────────────────┐
   │                         ▼                            │
   │  ┌──────────────────────────────────────┐           │
   │  │ Convert data type of the SCX to       │──S151    │
   │  │ fixed point                           │           │
   │  └──────────────────────────────────────┘           │
   │                         │                            │
   │                         ▼                            │
   │  ┌──────────────────────────────────────┐           │
   │  │   Generate fixed point output vector  │           │
   │  │   by accumulating elements of the     │──S152    │
   │  │   converted SCX based on the          │           │
   │  │   plurality of QSV                    │           │
   │  └──────────────────────────────────────┘           │
   │                         │                            │
   │                         ▼                            │
   │  ┌──────────────────────────────────────┐           │
   │  │ Convert data type of the fixed point  │──S153    │
   │  │ output vector to floating point       │           │
   │  └──────────────────────────────────────┘           │
   └─────────────────────────┼───────────────────────────┘
                             ▼
                    ┌──────────────────┐
                    │       END        │
                    └──────────────────┘
```

# FIG. 29

```
                    ┌─────────────┐
                    │    START    │
                    └──────┬──────┘
                           │
                           ▼
        ┌──────────────────────────────────────┐
        │      Receive first to n-th weights     │──S210
        └──────────────────┬───────────────────┘
                           │
                           ▼
        ┌──────────────────────────────────────┐
        │      Generate first to (n×R)-th QSVs and │
        │    first to (n×R)-th QSCs by binary coding │──S220
        │       quantizing the first to N-th weights │
        └──────────────────┬───────────────────┘
                           │
                           ▼
        ┌──────────────────────────────────────┐
        │    Receive first to n-th input elements  │──S230
        └──────────────────┬───────────────────┘
                           │
                           ▼
        ┌──────────────────────────────────────┐
        │     Generate first to (n×R)-th scaled input │
        │    elements by scaling the first to n-th input │──S240
        │  elements based on the first to (n×R)-th QSCs │
        └──────────────────┬───────────────────┘
                           │
                           ▼
        ┌──────────────────────────────────────┐
        │   Output an output element by accumulating │
        │    the first to (n×R)-th scaled input elements │──S250
        │      based on the first to (n×R)-th QSVs  │
        └──────────────────┬───────────────────┘
                           │
                           ▼
                    ┌─────────────┐
                    │     END     │
                    └─────────────┘
```

# FIG. 30

START

S250

Convert data type of the first to (n×R)-th scaled input elements to fixed point — S251

Generate a fixed point output element by accumulating first to (n×R)-th fixed point scaled input elements based on the first to (n×R)-th QSVs — S252

Output an output element generated by converting data type of the fixed point output element to floating point — S253

END

FIG. 31

EP 4 546 114 A1

# FIG. 32

ACC_REG of adjacent processing element
or
DATA TYPE CONVERTER#2 (160)

FIG. 33

# FIG. 34

# FIG. 35

'n' input elements

'h' input elements

| XM_11 | XM_12 | XM_13 | ... |
| XM_21 | XM_22 | |
| XM_31 | |

FULL INPUT MATRIX
(FXM)

'H' input elements

'N' input elements

# FIG. 36

# FIG. 37

'm' output elements

'h' output elements

| FYM_sub_11 | FYM_sub_12 | FYM_sub_13 |

FYM_sub_21 | FYM_sub_22

FYM_sub_31

FULL OUTPUT MATRIX
(FYM)

'H' output elements

'M' output elements

EP 4 546 114 A1

# FIG. 38

MMD

MATRIX MULTIPLY DEVICE

WM → | BCQ CIRCUIT | — 1200

QSM_1
QSCs_1    1110    QSM_2
QSCs_2    1120    QSM_R
QSCs_R

XM
$\{\overrightarrow{X_1}, \overrightarrow{X_2}, \overrightarrow{X_3}, \dots \overrightarrow{X_h}\}$ →

1100

| MATRIX MULTIPLIER | | MATRIX MULTIPLIER | • • • | MATRIX MULTIPLIER |

11R0

YM_sub_1    YM_sub_2    YM_sub_R

| OUTPUT MATRIX ACCUMULATOR | — 1300

YM

# FIG. 39

2000

2100 — CENTRAL PROCESSING UNIT

2200 — NEURAL PROCESSING UNIT
2210 — MATRIX MULTIPLY DEVICE

BUS

2300 — VOLATILE MEMORY DEVICE

2400 — NONVOLATILE MEMORY DEVICE

2500 — USER INTERFACE

EP 4 546 114 A1

EP 4 546 114 A1

# FIG. 40

Europäisches
Patentamt

European
Patent Office

Office européen
des brevets

# EUROPEAN SEARCH REPORT

Application Number

EP 24 19 8215

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Kim Yulhwa ET AL: "WINNING BOTH THE ACCURACY OF FLOATING POINT ACTIVATION AND THE SIMPLICITY OF INTEGER ARITHMETIC", , 28 February 2023 (2023-02-28), XP093242728, Retrieved from the Internet: URL:https://openreview.net/pdf?id=z92lBy1ehjI * figures 1, 3, 5 * * Sections 3.1, 4.1 * * Equation (1) * | 1-15 | INV. G06F7/544 G06F7/483 |
| A | GUNHO PARK ET AL: "LUT-GEMM: Quantized Matrix Multiplication based on LUTs for Efficient Inference in Large-Scale Generative Language Models", ARXIV.ORG, CORNELL UNIVERSITY LIBRARY, 201 OLIN LIBRARY CORNELL UNIVERSITY ITHACA, NY 14853, 15 April 2023 (2023-04-15), XP091485175, * figure 5 * * Sections 2, 3 * | 1-15 | |

TECHNICAL FIELDS
SEARCHED          (IPC)

G06F

The present search report has been drawn up for all claims

| Place of search | Date of completion of the search | Examiner |
|---|---|---|
| Munich | 28 January 2025 | Winkelbauer, Andreas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)